(19) Europäisches Patentamt

European Patent Office

Office européen des brevets

(11) **EP 2 617 120 B1**

(12) **EUROPEAN PATENT SPECIFICATION**

(45) Date of publication and mention
of the grant of the patent:
**18.01.2017 Bulletin 2017/03**

(21) Application number: **11825893.8**

(22) Date of filing: **14.09.2011**

(51) Int Cl.:
*H04B 5/00* (2006.01)     *H02J 5/00* (2016.01)
*H01F 3/00* (2006.01)     *H01F 38/14* (2006.01)
*H04W 52/02* (2009.01)

(86) International application number:
**PCT/US2011/051634**

(87) International publication number:
**WO 2012/037279 (22.03.2012 Gazette 2012/12)**

(54) **WIRELESS ENERGY DISTRIBUTION SYSTEM**

DRAHTLOSES ENERGIEVERTEILUNGSSYSTEM

SYSTÈME DE DISTRIBUTION D'ÉNERGIE SANS FIL

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **06.01.2011 US 986018
31.08.2011 US 201113222915
06.06.2011 US 201113154131
20.04.2011 US 201113090369
07.02.2011 US 201113021965
14.09.2010 US 382806 P**

(43) Date of publication of application:
**24.07.2013 Bulletin 2013/30**

(73) Proprietor: **WiTricity Corporation
Watertown, MA 02472 (US)**

(72) Inventors:
• **GANEM, Steven, J.
Westwood, MA 02090 (US)**
• **SCHATZ, David, A.
Needham, MA 02492 (US)**
• **KESLER, Morris, P.
Bedford, MA 01730 (US)**
• **GILER, Eric, R.
Boston, MA 02116 (US)**
• **HALL, Katherine, L.
Westford, MA 01886 (US)**

(74) Representative: **Peterreins Schley
Patent- und Rechtsanwälte
Hermann-Sack-Strasse 3
80331 München (DE)**

(56) References cited:
**US-A1- 2008 211 320     US-A1- 2009 134 712
US-A1- 2010 109 445     US-A1- 2010 164 296
US-A1- 2010 181 843**

**Description**

BACKGROUND

Field:

This disclosure relates to wireless energy transfer, methods, systems and apparati to accomplish such transfer, and applications.

Description of the Related Art:

Energy distribution over an area to moving devices or devices that may be often repositioned is unpractical with wired connections. Moving and changing devices create the possibility of wire tangles, tripping hazards, and the like. Wireless energy transfer over a larger area may be difficult when the area or region in which devices may be present may be large compared to the size of the device. Large mismatches in a source and device wireless energy capture modules may pose challenges in delivering enough energy to the devices at a high enough efficiency to make the implementations practical or may be difficult to deploy.

US 2010/0164296 discloses configurations for a wireless power transfer system with at least one adjustable magnetic resonator that may include a first magnetic resonator with a plurality of differently sized inductive elements, at least one power and control circuit configured to selectively connect to at least one plurality of differently sized inductive elements, one or more additional magnetic resonators separated from the first magnetic resonator, and measurement circuitry to measure at least one parameter of a wireless power transfer between the first magnetic resonator and the one or more additional magnetic resonators. One or more connections between the plurality of differently sized inductive elements and the at least one power and control circuit may be configured to change an effective size of the first magnetic resonator according to the at least one parameter measured by the measurement circuitry.

SUMMARY

The invention is defined by the claims.

Resonators and resonator assemblies may be positioned to distribute wireless energy over a larger area. The wireless energy transfer resonators and components that may be used have been described in, for example, in commonly owned U.S. Patent Application No. 12/789,611 published on September 23, 2010 as U.S. Pat. Pub. No. 2010/0237709 and entitled "RESONATOR ARRAYS FOR WIRELESS ENERGY TRANSFER," and U.S. Patent Application No. 12/722,050 published on July 22, 2010 as U.S. Pat. Pub. No. 2010/0181843 and entitled "WIRELESS ENERGY TRANSFER FOR REFRIGERATOR APPLICATION".

Repeater resonators are positioned around one or more source resonators in a defined area. The one or more source resonators is coupled to an energy source and generate an oscillating magnetic field which is transferred to the repeater resonators around the source resonators, and the repeater resonators may transfer the field to other repeaters around them thereby extending the energy over the defined area. In embodiments energy may be extended over an area of 10 cm2 or 2 m2 or more.

In the distribution system with multiple sources the frequency and phase of the sources may be synchronized.

The distribution system may use tunable repeaters that have a tunable resonant frequency. The resonant frequencies of the repeaters may dynamically or periodically adjusted to change the magnetic field distribution within the defined area. In embodiments the resonators and components of the system may have a communication capability to coordinate tuning of the resonators and components of the system to route or distribute the energy to specific areas of the defined area or route the energy along a specific route of resonators that may be calculated using network routing algorithms and other methods.

The components of the system may be integrated into flooring material such as tiles and distributed in a room floor or a wall or ceiling.

Multiple resonators and power and control circuitry may be incorporated onto one sheet and may be trimmed or cut to fit desired dimensions.

Unless otherwise indicated, this disclosure uses the terms wireless energy transfer, wireless power transfer, wireless power transmission, and the like, interchangeably. Those skilled in the art will understand that a variety of system architectures may be supported by the wide range of wireless system designs and functionalities described in this application.

This disclosure references certain individual circuit components and elements such as capacitors, inductors, resistors, diodes, transformers, switches and the like; combinations of these elements as networks, topologies, circuits, and the like; and objects that have inherent characteristics such as "self-resonant" objects with capacitance or inductance distributed (or partially distributed, as opposed to solely lumped) throughout the entire object. It would be understood by one of ordinary skill in the art that adjusting and controlling variable components within a circuit or network may adjust the performance of that circuit or network and that those adjustments may be described generally as tuning, adjusting, matching, correcting, and the like. Other methods to tune or adjust the operating point of the wireless power transfer system may be used alone, or in addition to adjusting tunable components such as inductors and capacitors, or banks of inductors and capacitors. Those skilled in the art will recognize that a particular topology discussed in this disclosure can be implemented in a variety of other ways.

Unless otherwise defined, all technical and scientific terms used herein have the same meaning as commonly understood by one of ordinary skill in the art to which this disclosure belongs. In case of conflict with publications, patent applications, patents, and other references mentioned or incorporated herein by reference, the present specification, including definitions, will control.

Any of the features described above may be used, alone or in combination, without departing from the scope of this disclosure. Other features, objects, and advantages of the systems and methods disclosed herein will be apparent from the following detailed description and figures.

## BRIEF DESCRIPTION OF FIGURES

Fig. 1 is a system block diagram of wireless energy transfer configurations.

Figs. 2A-2E are exemplary structures and schematics of simple resonator structures.

Fig. 3 is a block diagram of a wireless source with a single-ended amplifier.

Fig. 4 is a block diagram of a wireless source with a differential amplifier.

Figs. 5A and 5B are block diagrams of sensing circuits.

Figs. 6A, 6B, and 6C are block diagrams of a wireless source.

Fig. 7 is a plot showing the effects of a duty cycle on the parameters of an amplifier.

Fig. 8 is a simplified circuit diagram of a wireless power source with a switching amplifier.

Fig. 9 shows plots of the effects of changes of parameters of a wireless power source.

Fig. 10 shows plots of the effects of changes of parameters of a wireless power source.

Figs. 11A, 11B, and 11C are plots showing the effects of changes of parameters of a wireless power source.

Fig. 12 shows plots of the effects of changes of parameters of a wireless power source.

Fig. 13 is a simplified circuit diagram of a wireless energy transfer system comprising a wireless power source with a switching amplifier and a wireless power device.

Fig. 14 shows plots of the effects of changes of parameters of a wireless power source.

Fig. 15 is a diagram of a resonator showing possible nonuniform magnetic field distributions due to irregular spacing between tiles of magnetic material.

Fig. 16 is a resonator with an arrangement of tiles in a block of magnetic material that may reduce hotspots in the magnetic material block.

Fig. 17A is a resonator with a block of magnetic material comprising smaller individual tiles and 17B and 17C is the resonator with additional strips of thermally conductive material used for thermal management.

Fig. 18 is block diagram of a wireless energy transfer system with in-band and out-of-band communication channels.

Fig. 19A and Fig. 19B are steps that may be used to verify the energy transfer channel using an out-of-band communication channel.

Fig. 20 is an isometric view of a conductor wire comprising multiple conductor shells.

Fig. 21 is an isometric view of a conductor wire comprising multiple conductor shells.

Fig 22 is a plot showing the current distributions for a solid conductor wire.

Fig 23 is a plot showing the current distributions for a conductor wire comprising 25 conductor shells.

Fig 24 is a plot showing the current distributions for a conductor wire comprising 25 conductor shells.

Fig 25 is plot showing the ratio of the resistance of an optimized conducting-shell structure with overall diameter 1mm to the AC resistance of a solid conductor of the same diameter.

Fig 26 is plot showing the ratio of the resistance of an optimized conducting-shell structure with overall diameter 1mm to the DC resistance of the same conductor (21.6 m$\Omega$/m).

Fig 27 is plot showing the ratio of the resistance of an optimized conducting-shell structure with overall diameter 1mm to the resistance with the same number of elements, but with shells of (optimized) uniform thickness around a copper core.

Fig. 28A and Fig. 28B are diagrams of embodiments of a wireless power enabled floor tile.

Fig. 29 is a block diagram of an embodiment of a wireless power enabled floor tile.

Fig. 30 is diagram of a wireless power enables floor system.

Fig. 31 is diagram of a cuttable sheet of resonators.

## DETAILED DESCRIPTION

As described above, this disclosure relates to wireless energy transfer using coupled electromagnetic resonators. However, such energy transfer is not restricted to electromagnetic resonators, and the wireless energy transfer systems described herein are more general and may be implemented using a wide variety of resonators and resonant objects.

As those skilled in the art will recognize, important considerations for resonator-based power transfer include resonator efficiency and resonator coupling. Extensive discussion of such issues, e.g., coupled mode theory (CMT), coupling coefficients and factors, quality factors (also referred to as $Q$ -factors), and impedance matching is provided, for example, in U.S. patent application 12/789,611 published on September 23, 2010 as US 20100237709 and entitled "RESONATOR ARRAYS FOR WIRELESS ENERGY TRANSFER," and U.S. patent application 12/722,050 published on July 22, 2010 as US 20100181843 and entitled "WIRELESS ENERGY TRANSFER FOR REFRIGERATOR APPLICATION".

A **resonator** may be defined as a resonant structure that can store energy in at least two different forms, and where the stored energy oscillates between the two forms. The resonant structure will have a specific oscillation mode with a resonant (modal) frequency, $f$, and a resonant (modal) field. The angular resonant frequency, $\omega$, may be defined as $\omega = 2\pi f$, the resonant period, $T$, may be defined as $T = 1/f = 2\pi/f$, and the resonant wavelength, $\lambda$, may be defined as $\lambda = c/f$, where $c$ is the speed of the associated field waves (light, for electromagnetic resonators). In the absence of loss mechanisms, coupling mechanisms or external energy supplying or draining mechanisms, the total amount of energy stored by the resonator, $W$, would stay fixed, but the form of the energy would oscillate between the two forms supported by the resonator, wherein one form would be maximum when the other is minimum and vice versa.

For example, a resonator may be constructed such that the two forms of stored energy are magnetic energy and electric energy. Further, the resonator may be constructed such that the electric energy stored by the electric field is primarily confined within the structure while the magnetic energy stored by the magnetic field is primarily in the region surrounding the resonator. In other words, the total electric and magnetic energies would be equal, but their localization would be different. Using such structures, energy exchange between at least two structures may be mediated by the resonant magnetic near-field of the at least two resonators. These types of resonators may be referred to as **magnetic resonators.**

An important parameter of resonators used in wireless power transmission systems is the **Quality Factor,** or $Q$ **-factor,** or $Q$, of the resonator, which characterizes the energy decay and is inversely proportional to energy losses of the resonator. It may be defined as $Q = \omega * W/P$, where $P$ is the time-averaged power lost at steady state. That is, a resonator with a high-$Q$ has relatively low intrinsic losses and can store energy for a relatively long time. Since the resonator loses energy at its intrinsic decay rate, $2\Gamma$, its $Q$, also referred to as its intrinsic $Q$ , is given by $Q = \omega/2\Gamma$. The quality factor also represents the number of oscillation periods, $T$, it takes for the energy in the resonator to decay by a factor of $e^{-2\pi}$. Note that the quality factor or intrinsic quality factor or $Q$ of the resonator is that due only to intrinsic loss mechanisms. The $Q$ of a resonator connected to, or coupled to a power generator, $g$, or load, $l$, may be called the **"loaded quality factor"** or the "loaded $Q$". The $Q$ of a resonator in the presence of an extraneous object that is not intended to be part of the energy transfer system may be called the **"perturbed quality factor"** or the "perturbed $Q$".

Resonators, coupled through any portion of their near-fields may interact and exchange energy. The efficiency of this energy transfer can be significantly enhanced if the resonators operate at substantially the same resonant frequency. By way of example, but not limitation, imagine a source resonator with $Q_s$ and a device resonator with $Q_d$. High-Q wireless energy transfer systems may utilize resonators that are high-Q . The $Q$ of each resonator may be high. The geometric mean of the resonator $Q$ 's, $\sqrt{Q_s Q_d}$ may also or instead be high.

The **coupling factor,** $k$, is a number between $0 \leq |k| \leq 1$, and it may be independent (or nearly independent) of the resonant frequencies of the source and device resonators , when those are placed at sub-wavelength distances. Rather the coupling factor $k$ may be determined mostly by the relative geometry and the distance between the source and device resonators where the physical decay-law of the field mediating their coupling is taken into account. The coupling coefficient used in CMT, $\kappa = k\sqrt{\omega_s \omega_d}\big/2$ , may be a strong function of the resonant frequencies, as well as other properties of the resonator structures. In applications for wireless energy transfer utilizing the near-fields of the resonators, it is desirable to have the size of the resonator be much smaller than the resonant wavelength, so that power lost by radiation is reduced. In some embodiments, high-Q resonators are sub-wavelength structures. In some electromagnetic embodiments, high-Q resonator structures are designed to have resonant frequencies higher than 100 kHz.

In other embodiments, the resonant frequencies may be less than 1 GHz.

In exemplary embodiments, the power radiated into the far-field by these sub wavelength resonators may be further reduced by lowering the resonant frequency of the resonators and the operating frequency of the system. In other embodiments, the far field radiation may be reduced by arranging for the far fields of two or more resonators to interfere destructively in the far field.

In a wireless energy transfer system a resonator may be used as a wireless energy source, a wireless energy capture device, a repeater or a combination thereof. In embodiments a resonator may alternate between transferring energy, receiving energy or relaying energy. In a wireless energy transfer system one or more magnetic resonators may be coupled to an energy source and be energized to produce an oscillating magnetic near-field. Other resonators that are within the oscillating magnetic near-fields may capture these fields and convert the energy into electrical energy that may be used to power or charge a load thereby enabling wireless transfer of useful energy.

The so-called "useful" energy in a useful energy exchange is the energy or power that must be delivered to a device in order to power or charge it at an acceptable rate. The transfer efficiency that corresponds to a useful energy exchange may be system or application-dependent. For example, high power vehicle charging applications that transfer kilowatts of power may need to be at least 80% efficient in order to supply useful amounts of power resulting in a useful energy exchange sufficient to recharge a vehicle battery without significantly heating up various components of the transfer system. In some consumer electronics applications, a useful energy exchange may include any energy transfer efficiencies greater than 10%, or any other amount acceptable to keep rechargeable batteries "topped off' and running for long periods of time. In implanted medical device applications, a useful energy exchange may be any exchange that does not harm the patient but that extends the life of a battery or wakes up a sensor or monitor or stimulator. In such applications, 100 mW of power or less may be useful. In distributed sensing applications, power transfer of microwatts may be useful, and transfer efficiencies may be well below 1%.

A useful energy exchange for wireless energy transfer in a powering or recharging application may be efficient, highly efficient, or efficient enough, as long as the wasted energy levels, heat dissipation, and associated field strengths are within tolerable limits and are balanced appropriately with related factors such as cost, weight, size, and the like.

The resonators may be referred to as source resonators, device resonators, first resonators, second resonators, repeater resonators, and the like. Implementations may include three (3) or more resonators. For example, a single source resonator may transfer energy to multiple device resonators or multiple devices. Energy may be transferred from a first device to a second, and then from the second device to the third, and so forth. Multiple sources may transfer energy to a single device or to multiple devices connected to a single device resonator or to multiple devices connected to multiple device resonators. Resonators may serve alternately or simultaneously as sources, devices, and/or they may be used to relay power from a source in one location to a device in another location. Intermediate electromagnetic resonators may be used to extend the distance range of wireless energy transfer systems and/or to generate areas of concentrated magnetic near-fields. Multiple resonators may be daisy-chained together, exchanging energy over extended distances and with a wide range of sources and devices. For example, a source resonator may transfer power to a device resonator via several repeater resonators. Energy from a source may be transferred to a first repeater resonator, the first repeater resonator may transfer the power to a second repeater resonator and the second to a third and so on until the final repeater resonator transfers its energy to a device resonator. In this respect the range or distance of wireless energy transfer may be extended and/or tailored by adding repeater resonators. High power levels may be split between multiple sources, transferred to multiple devices and recombined at a distant location.

The resonators may be designed using coupled mode theory models, circuit models, electromagnetic field models, and the like. The resonators may be designed to have tunable characteristic sizes. The resonators may be designed to handle different power levels. In exemplary embodiments, high power resonators may require larger conductors and higher current or voltage rated components than lower power resonators.

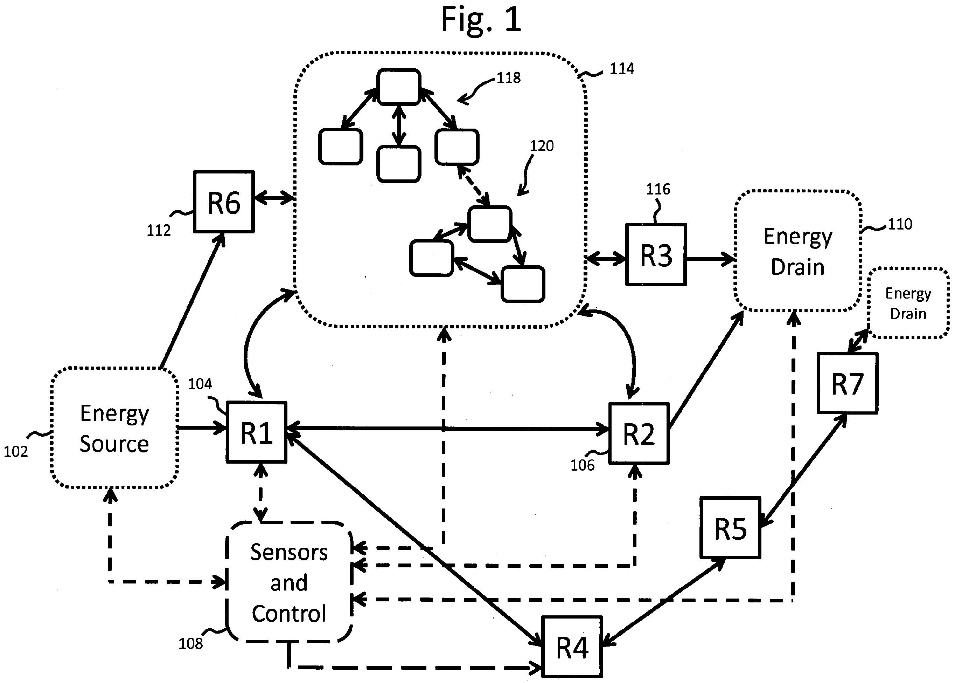

Fig. 1 shows a diagram of exemplary configurations and arrangements of a wireless energy transfer system. A wireless energy transfer system may include at least one source resonator (R1)**104** (optionally R6, **112**) coupled to an energy source **102** and optionally a sensor and control unit **108**. The energy source may be a source of any type of energy capable of being converted into electrical energy that may be used to drive the source resonator **104**. The energy source may be a battery, a solar panel, the electrical mains, a wind or water turbine, an electromagnetic resonator, a generator, and the like. The electrical energy used to drive the magnetic resonator is converted into oscillating magnetic fields by the resonator. The oscillating magnetic fields may be captured by other resonators which may be device resonators (R2) **106,** (R3) 116 that are optionally coupled to an energy drain **110**. The oscillating fields may be optionally coupled to repeater resonators (R4, R5) that are configured to extend or tailor the wireless energy transfer region. Device resonators may capture the magnetic fields in the vicinity of source resonator(s), repeater resonators and other device resonators and convert them into electrical energy that may be used by an energy drain. The energy drain **110** may be an electrical, electronic, mechanical or chemical device and the like configured to receive electrical energy. Repeater resonators may capture magnetic fields in the vicinity of source, device and repeater resonator(s) and may pass the energy on to other resonators.

A wireless energy transfer system may comprise a single source resonator **104** coupled to an energy source **102** and a single device resonator **106** coupled to an energy drain **110**. In embodiments a wireless energy transfer system may comprise multiple source resonators coupled to one or more energy sources and may comprise multiple device resonators coupled to one or more energy drains.

In embodiments the energy may be transferred directly between a source resonator 104 and a device resonator **106**. In other embodiments the energy may be transferred from one or more source resonators **104,112** to one or more device resonators **106,116** via any number of intermediate resonators which may be device resonators, source resonators, repeater resonators, and the like. Energy may be transferred via a network or arrangement of resonators **114** that may include subnetworks **118, 120** arranged in any combination of topologies such as token ring, mesh, ad hoc, and the like.

In embodiments the wireless energy transfer system may comprise a centralized sensing and control system **108**. In embodiments parameters of the resonators, energy sources, energy drains, network topologies, operating parameters, etc. may be monitored and adjusted from a control processor to meet specific operating parameters of the system. A central control processor may adjust parameters of individual components of the system to optimize global energy transfer efficiency, to optimize the amount of power transferred, and the like. Other embodiments may be designed to have a substantially distributed sensing and control system. Sensing and control may be incorporated into each resonator or group of resonators, energy sources, energy drains, and the like and may be configured to adjust the parameters of the individual components in the group to maximize or minimize the power delivered, to maximize energy transfer efficiency in that group and the like.

In embodiments, components of the wireless energy transfer system may have wireless or wired data communication links to other components such as devices, sources, repeaters, power sources, resonators, and the like and may transmit or receive data that can be used to enable the distributed or centralized sensing and control. A wireless communication channel may be separate from the wireless energy transfer channel, or it may be the same. In one embodiment the resonators used for power exchange may also be used to exchange information. In some cases, information may be exchanged by modulating a component in a source or device circuit and sensing that change with port parameter or other monitoring equipment. Resonators may signal each other by tuning, changing, varying, dithering, and the like, the resonator parameters such as the impedance of the resonators which may affect the reflected impedance of other resonators in the system. The systems and methods described herein may enable the simultaneous transmission of power and communication signals between resonators in wireless power transmission systems, or it may enable the transmission of power and communication signals during different time periods or at different frequencies using the same magnetic fields that are used during the wireless energy transfer. In other embodiments wireless communication may be enabled with a separate wireless communication channel such as WiFi, Bluetooth, Infrared, NFC, and the like.

In embodiments, a wireless energy transfer system may include multiple resonators and overall system performance may be improved by control of various elements in the system. For example, devices with lower power requirements may tune their resonant frequency away from the resonant frequency of a high-power source that supplies power to devices with higher power requirements. For another example, devices needing less power may adjust their rectifier circuits so that they draw less power from the source. In these ways, low and high power devices may safely operate or charge from a single high power source. In addition, multiple devices in a charging zone may find the power available to them regulated according to any of a variety of consumption control algorithms such as First-Come-First-Serve, Best Effort, Guaranteed Power, etc. The power consumption algorithms may be hierarchical in nature, giving priority to certain users or types of devices, or it may support any number of users by equally sharing the power that is available in the source. Power may be shared by any of the multiplexing techniques described in this disclosure.

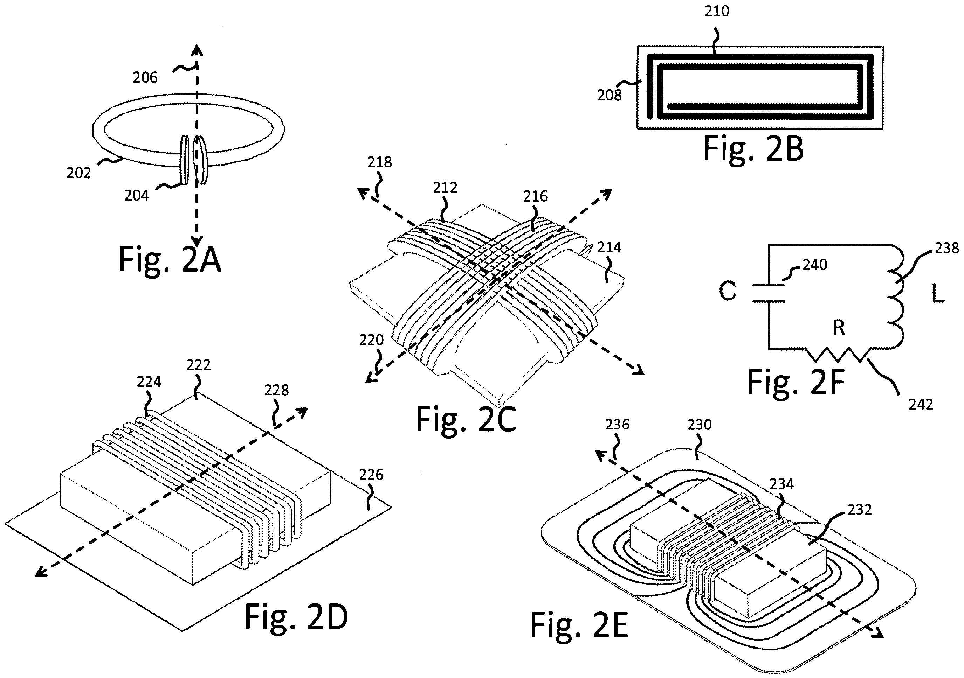

In embodiments electromagnetic resonators may be realized or implemented using a combination of shapes, structures, and configurations. Electromagnetic resonators may include an inductive element, a distributed inductance, or a combination of inductances with a total inductance, *L*, and a capacitive element, a distributed capacitance, or a combination of capacitances, with a total capacitance, *C*. A minimal circuit model of an electromagnetic resonator comprising capacitance, inductance and resistance, is shown in Fig. 2F. The resonator may include an inductive element **238** and a capacitive element **240**. Provided with initial energy, such as electric field energy stored in the capacitor **240,** the system will oscillate as the capacitor discharges transferring energy into magnetic field energy stored in the inductor **238** which in turn transfers energy back into electric field energy stored in the capacitor **240**. Intrinsic losses in these electromagnetic resonators include losses due to resistance in the inductive and capacitive elements and to radiation losses, and are represented by the resistor, R, **242** in Fig. 2F.

Fig. 2A shows a simplified drawing of an exemplary magnetic resonator structure. The magnetic resonator may include a loop of conductor acting as an inductive element **202** and a capacitive element **204** at the ends of the conductor loop. The inductor **202** and capacitor **204** of an electromagnetic resonator may be bulk circuit elements, or the inductance and capacitance may be distributed and may result from the way the conductors are formed, shaped, or positioned, in the structure.

For example, the inductor **202** may be realized by shaping a conductor to enclose a surface area, as shown in Figs. 2A. This type of resonator may be referred to as a capacitively-loaded loop inductor. Note that we may use the terms "loop" or "coil" to indicate generally a conducting structure (wire, tube, strip, etc.), enclosing a surface of any shape and dimension, with any number of turns. In Fig. 2A, the enclosed surface area is circular, but the surface may be any of a wide variety of other shapes and sizes and may be designed to achieve certain system performance specifications. In embodiments the inductance may be realized using inductor elements, distributed inductance, networks, arrays, series and parallel combinations of inductors and inductances, and the like. The inductance may be fixed or variable and may be used to vary impedance matching as well as resonant frequency operating conditions.

There are a variety of ways to realize the capacitance required to achieve the desired resonant frequency for a resonator structure. Capacitor plates **204** may be formed and utilized as shown in Fig. 2A, or the capacitance may be distributed and be realized between adjacent windings of a multi-loop conductor. The capacitance may be realized using capacitor elements, distributed capacitance, networks, arrays, series and parallel combinations of capacitances, and the like. The capacitance may be fixed or variable and may be used to vary impedance matching as well as resonant frequency operating conditions.

The inductive elements used in magnetic resonators may contain more than one loop and may spiral inward or outward or up or down or in some combination of directions. In general, the magnetic resonators may have a variety of shapes, sizes and number of turns and they may be composed of a variety of conducing materials. The conductor **210,** for example, may be a wire, a Litz wire, a ribbon, a pipe, a trace formed from conducting ink, paint, gels, and the like or from single or multiple traces printed on a circuit board. An exemplary embodiment of a trace pattern on a substrate **208** forming inductive loops is depicted in Fig. 2B.

In embodiments the inductive elements may be formed using magnetic materials of any size, shape thickness, and the like, and of materials with a wide range of permeability and loss values. These magnetic materials may be solid blocks, they may enclose hollow volumes, they may be formed from many smaller pieces of magnetic material tiled and or stacked together, and they may be integrated with conducting sheets or enclosures made from highly conducting materials. Conductors may be wrapped around the magnetic materials to generate the magnetic field. These conductors may be wrapped around one or more than one axis of the structure. Multiple conductors may be wrapped around the magnetic materials and combined in parallel, or in series, or via a switch to form customized near-field patterns and/or to orient the dipole moment of the structure. Examples of resonators comprising magnetic material are depicted in Figures 2C, 2D, 2E. In Fig. 2D the resonator comprises loops of conductor **224** wrapped around a core of magnetic material **222** creating a structure that has a magnetic dipole moment **228** that is parallel to the axis of the loops of the conductor **224.** The resonator may comprise multiple loops of conductor **216,212** wrapped in orthogonal directions around the magnetic material **214** forming a resonator with a magnetic dipole moment **218, 220** that may be oriented in more than one direction as depicted in Fig. 2C, depending on how the conductors are driven.

An electromagnetic resonator may have a characteristic, natural, or resonant frequency determined by its physical properties. This resonant frequency is the frequency at which the energy stored by the resonator oscillates between that stored by the electric field, $W_E$, ($W_E = q^2/2C$, where $q$ is the charge on the capacitor, $C$) and that stored by the magnetic field, $W_B$, ($W_B = Li^2/2$, where $i$ is the current through the inductor, $L$) of the resonator. The frequency at which this energy is exchanged may be called the characteristic frequency, the natural frequency, or the resonant frequency of the resonator, and is given by $\omega$,

$$\omega = 2\pi f = \sqrt{\frac{1}{LC}}.$$

The resonant frequency of the resonator may be changed by tuning the inductance, $L$, and/or the capacitance, $C$, of the resonator. In one embodiment system parameters are dynamically adjustable or tunable to achieve as close as possible to optimal operating conditions. However, based on the discussion above, efficient enough energy exchange may be realized even if some system parameters are not variable or components are not capable of dynamic adjustment.

In embodiments a resonator may comprise an inductive element coupled to more than one capacitor arranged in a network of capacitors and circuit elements. In embodiments the coupled network of capacitors and circuit elements may be used to define more than one resonant frequency of the resonator. In embodiments a resonator may be resonant, or partially resonant, at more than one frequency.

In embodiments, a wireless power source may comprise of at least one resonator coil coupled to a power supply, which may be a switching amplifier, such as a class-D amplifier or a class-E amplifier or a combination thereof. In this case, the resonator coil is effectively a power load to the power supply. In embodiments, a wireless power device may comprise of at least one resonator coil coupled to a power load, which may be a switching rectifier, such as a class-D rectifier or a class-E rectifier or a combination thereof. In this case, the resonator coil is effectively a power supply for the power load, and the impedance of the load directly relates also to the work-drainage rate of the load from the resonator coil. The efficiency of power transmission between a power supply and a power load may be impacted by how closely matched the output impedance of the power source is to the input impedance of the load. Power may be delivered to the load at a maximum possible efficiency, when the input impedance of the load is equal to the complex conjugate of the internal impedance of the power supply. Designing the power supply or power load impedance to obtain a maximum power transmission efficiency is often called "impedance matching", and may also referred to as optimizing the ratio of useful-to-lost powers in the system. Impedance matching may be performed by adding networks or sets of elements such as capacitors, inductors, transformers, switches, resistors, and the like, to form impedance matching networks between a power supply and a power load. In embodiments, mechanical adjustments and changes in element positioning may be used to achieve impedance matching. For varying loads, the impedance matching network may include variable components that are dynamically adjusted to ensure that the impedance at the power supply terminals looking towards the load and the characteristic impedance of the power supply remain substantially complex conjugates of each other, even in dynamic environments and operating scenarios.

In embodiments, impedance matching may be accomplished by tuning the duty cycle, and/or the phase, and/or the frequency of the driving signal of the power supply or by tuning a physical component within the power supply, such as a capacitor. Such a tuning mechanism may be advantageous because it may allow impedance matching between a power supply and a load without the use of a tunable impedance matching network, or with a simplified tunable impedance matching network, such as one that has fewer tunable components for example. In embodiments, tuning the duty cycle, and/or frequency, and/or phase of the driving signal to a power supply may yield a dynamic impedance matching system with an extended tuning range or precision, with higher power, voltage and/or current capabilities, with faster electronic control, with fewer external components, and the like.

In some wireless energy transfer systems the parameters of the resonator such as the inductance may be affected by environmental conditions such as surrounding objects, temperature, orientation, number and position of other resonators and the like. Changes in operating parameters of the resonators may change certain system parameters, such as the efficiency of transferred power in the wireless energy transfer. For example, high-conductivity materials located near a resonator may shift the resonant frequency of a resonator and detune it from other resonant objects. In some embodiments, a resonator feedback mechanism is employed that corrects its frequency by changing a reactive element (e.g., an inductive element or capacitive element). In order to achieve acceptable matching conditions, at least some of the system parameters may need to be dynamically adjustable or tunable. All the system parameters may be dynamically adjustable or tunable to achieve approximately the optimal operating conditions. However, efficient enough energy exchange may be realized even if all or some system parameters are not variable. In some examples, at least some of the devices may not be dynamically adjusted. In some examples, at least some of the sources may not be dynamically adjusted. In some examples, at least some of the intermediate resonators may not be dynamically adjusted. In some examples, none of the system parameters may be dynamically adjusted.

In some embodiments changes in parameters of components may be mitigated by selecting components with characteristics that change in a complimentary or opposite way or direction when subjected to differences in operating environment or operating point. In embodiments, a system may be designed with components, such as capacitors, that have an opposite dependence or parameter fluctuation due to temperature, power levels, frequency, and the like. In some embodiments, the component values as a function of temperature may be stored in a look-up table in a system microcontroller and the reading from a temperature sensor may be used in the system control feedback loop to adjust other parameters to compensate for the temperature induced component value changes.

In some embodiments the changes in parameter values of components may be compensated with active tuning circuits comprising tunable components. Circuits that monitor the operating environment and operating point of components and system may be integrated in the design. The monitoring circuits may provide the signals necessary to actively compensate for changes in parameters of components. For example, a temperature reading may be used to calculate expected changes in, or to indicate previously measured values of, capacitance of the system allowing compensation by switching in other capacitors or tuning capacitors to maintain the desired capacitance over a range of temperatures. In embodiments, the RF amplifier switching waveforms may be adjusted to compensate for component value or load changes in the system. In some embodiments the changes in parameters of components may be compensated with active cooling, heating, active environment conditioning, and the like.

The parameter measurement circuitry may measure or monitor certain power, voltage, and current, signals in the system, and processors or control circuits may adjust certain settings or operating parameters based on those measurements. In addition the magnitude and phase of voltage and current signals, and the magnitude of the power signals, throughout the system may be accessed to measure or monitor the system performance. The measured signals referred to throughout this disclosure may be any combination of port parameter signals, as well as voltage signals, current signals, power signals, temperatures signals and the like. These parameters may be measured using analog or digital techniques, they may be sampled and processed, and they may be digitized or converted using a number of known analog and digital processing techniques. In embodiments, preset values of certain measured quantities are loaded in a system controller or memory location and used in various feedback and control loops. In embodiments, any combination of measured, monitored, and/or preset signals may be used in feedback circuits or systems to control the operation of the resonators and/or the system.

Adjustment algorithms may be used to adjust the frequency, Q, and/or impedance of the magnetic resonators. The algorithms may take as inputs reference signals related to the degree of deviation from a desired operating point for the system and may output correction or control signals related to that deviation that control variable or tunable elements of the system to bring the system back towards the desired operating point or points. The reference signals for the magnetic resonators may be acquired while the resonators are exchanging power in a wireless power transmission system, or they may be switched out of the circuit during system operation. Corrections to the system may be applied or performed continuously, periodically, upon a threshold crossing, digitally, using analog methods, and the like.

In embodiments, lossy extraneous materials and objects may introduce potential reductions in efficiencies by absorbing the magnetic and/or electric energy of the resonators of the wireless power transmission system. Those impacts may be mitigated in various embodiments by positioning resonators to minimize the effects of the lossy extraneous materials and objects and by placing structural field shaping elements (e.g., conductive structures, plates and sheets, magnetic material structures, plates and sheets, and combinations thereof) to minimize their effect.

One way to reduce the impact of lossy materials on a resonator is to use high-conductivity materials, magnetic materials, or combinations thereof to shape the resonator fields such that they avoid the lossy objects. In an exemplary embodiment, a layered structure of high-conductivity material and magnetic material may tailor, shape, direct, reorient, etc. the resonator's electromagnetic fields so that they avoid lossy objects in their vicinity by deflecting the fields. Fig. 2D shows a top view of a resonator with a sheet of conductor **226** below the magnetic material that may used to tailor the fields of the resonator so that they avoid lossy objects that may be below the sheet of conductor **226.** The layer or sheet of good **226** conductor may comprise any high conductivity materials such as copper, silver, aluminum, as may be most appropriate for a given application. In certain embodiments, the layer or sheet of good conductor is thicker than the skin depth of the conductor at the resonator operating frequency. The conductor sheet may be preferably larger than the size of the resonator, extending beyond the physical extent of the resonator.

In environments and systems where the amount of power being transmitted could present a safety hazard to a person or animal that may intrude into the active field volume, safety measures may be included in the system. In embodiments where power levels require particularized safety measures, the packaging, structure, materials, and the like of the resonators may be designed to provide a spacing or "keep away" zone from the conducting loops in the magnetic resonator. To provide further protection, high- Q resonators and power and control circuitry may be located in enclosures that confine high voltages or currents to within the enclosure, that protect the resonators and electrical components from weather, moisture, sand, dust, and other external elements, as well as from impacts, vibrations, scrapes, explosions, and other types of mechanical shock. Such enclosures call for attention to various factors such as thermal dissipation to maintain an acceptable operating temperature range for the electrical components and the resonator. In embodiments, enclosure may be constructed of non-lossy materials such as composites, plastics, wood, concrete, and the like and may be used to provide a minimum distance from lossy objects to the resonator components. A minimum separation distance from lossy objects or environments which may include metal objects, salt water, oil and the like, may improve the efficiency of wireless energy transfer. In embodiments, a "keep away" zone may be used to increase the perturbed Q of a resonator or system of resonators. In embodiments a minimum separation distance may provide for a more reliable or more constant operating parameters of the resonators.

In embodiments, resonators and their respective sensor and control circuitry may have various levels of integration with other electronic and control systems and subsystems. In some embodiments the power and control circuitry and the device resonators are completely separate modules or enclosures with minimal integration to existing systems, providing a power output and a control and diagnostics interface. In some embodiments a device is configured to house a resonator and circuit assembly in a cavity inside the enclosure, or integrated into the housing or enclosure of the device.

## Example Resonator Circuitry

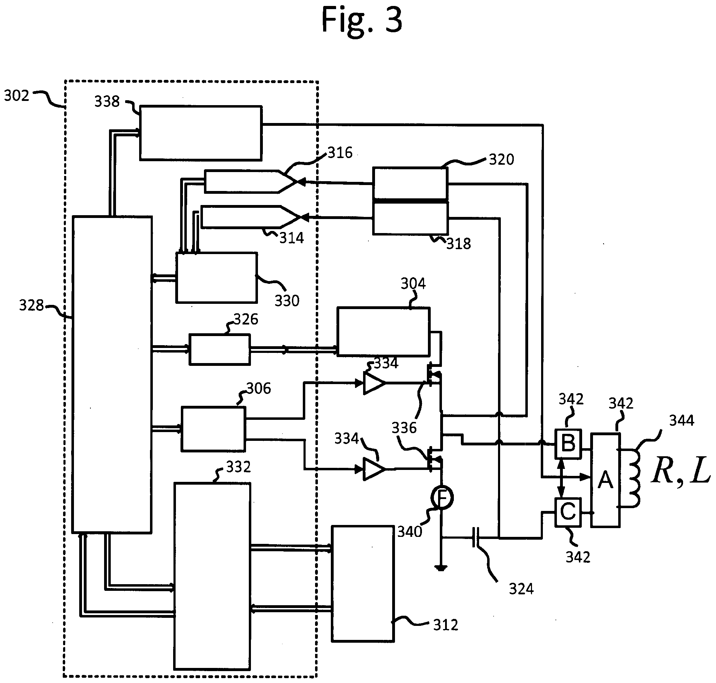

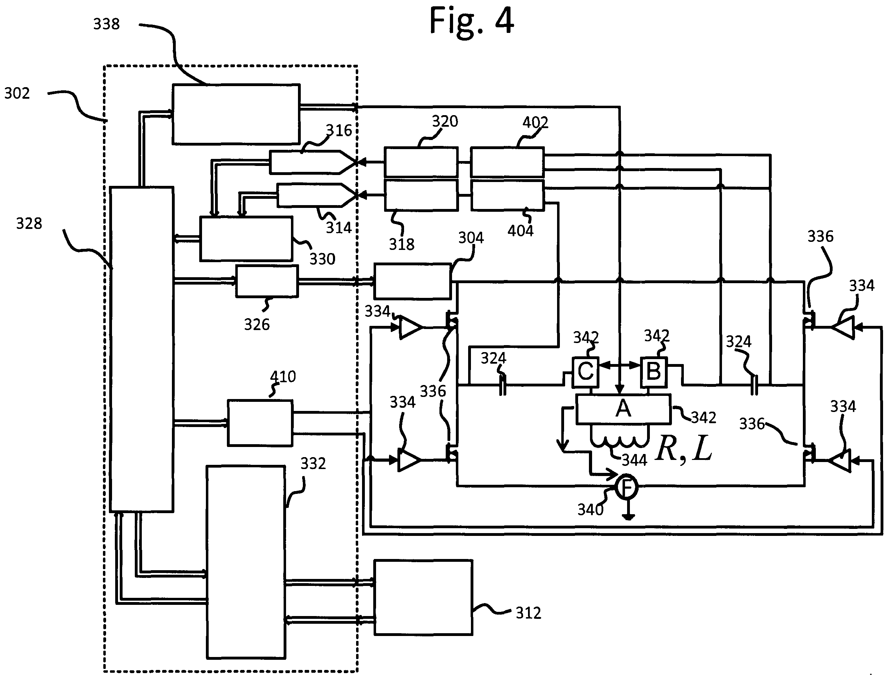

Figures 3 and 4 show high level block diagrams depicting power generation, monitoring, and control components for exemplary sources of a wireless energy transfer system. Fig. 3 is a block diagram of a source comprising a half-bridge switching power amplifier and some of the associated measurement, tuning, and control circuitry. Fig. 4 is a block diagram of a source comprising a full-bridge switching amplifier and some of the associated measurement, tuning, and control circuitry.

The half bridge system topology depicted in Fig. 3 may comprise a processing unit that executes a control algorithm **328**. The processing unit executing a control algorithm **328** may be a microcontroller, an application specific circuit, a field programmable gate array, a processor, a digital signal processor, and the like. The processing unit may be a single device or it may be a network of devices. The control algorithm may run on any portion of the processing unit. The algorithm may be customized for certain applications and may comprise a combination of analog and digital circuits and signals. The master algorithm may measure and adjust voltage signals and levels, current signals and levels, signal phases, digital count settings, and the like.

The system may comprise an optional source/device and/or source/other resonator communication controller **332** coupled to wireless communication circuitry **312**. The optional source/device and/or source/other resonator communication controller **332** may be part of the same processing unit that executes the master control algorithm, it may a part or a circuit within a microcontroller **302,** it may be external to the wireless power transmission modules, it may be substantially similar to communication controllers used in wire powered or battery powered applications but adapted to include some new or different functionality to enhance or support wireless power transmission.

The system may comprise a PWM generator **306** coupled to at least two transistor gate drivers **334** and may be controlled by the control algorithm. The two transistor gate drivers **334** may be coupled directly or via gate drive transformers to two power transistors **336** that drive the source resonator coil **344** through impedance matching network components **342**. The power transistors **336** may be coupled and powered with an adjustable DC supply **304** and the adjustable DC supply **304** may be controlled by a variable bus voltage, Vbus. The Vbus controller may be controlled by the control algorithm **328** and may be part of, or integrated into, a microcontroller **302** or other integrated circuits. The Vbus controller **326** may control the voltage output of an adjustable DC supply **304** which may be used to control power output of the amplifier and power delivered to the resonator coil **344**.

The system may comprise sensing and measurement circuitry including signal filtering and buffering circuits **318, 320** that may shape, modify, filter, process, buffer, and the like, signals prior to their input to processors and/or converters such as analog to digital converters (ADC) **314,316,** for example. The processors and converters such as ADCs **314, 316** may be integrated into a microcontroller **302** or may be separate circuits that may be coupled to a processing core **330**. Based on measured signals, the control algorithm **328** may generate, limit, initiate, extinguish, control, adjust, or modify the operation of any of the PWM generator **306,** the communication controller **332,** the Vbus control **326,** the source impedance matching controller **338,** the filter/buffering elements, **318, 320,** the converters, **314, 316,** the resonator coil **344,** and may be part of, or integrated into, a microcontroller **302** or a separate circuit. The impedance matching networks **342** and resonator coils **344** may include electrically controllable, variable, or tunable components such as capacitors, switches, inductors, and the like, as described herein, and these components may have their component values or operating points adjusted according to signals received from the source impedance matching controller **338**. Components may be tuned to adjust the operation and characteristics of the resonator including the power delivered to and by the resonator, the resonant frequency of the resonator, the impedance of the resonator, the Q of the resonator, and any other coupled systems, and the like. The resonator may be any type or structure resonator described herein including a capacitively loaded loop resonator, a planer resonator comprising a magnetic material or any combination thereof.

The full bridge system topology depicted in Fig. 4 may comprise a processing unit that executes a master control algorithm **328**. The processing unit executing the control algorithm **328** may be a microcontroller, an application specific circuit, a field programmable gate array, a processor, a digital signal processor, and the like. The system may comprise a source/device and/or source/other resonator communication controller **332** coupled to wireless communication circuitry **312**. The source/device and/or source/other resonator communication controller **332** may be part of the same processing unit that executes that master control algorithm, it may a part or a circuit within a microcontroller **302,** it may be external to the wireless power transmission modules, it may be substantially similar to communication controllers used in wire powered or battery powered applications but adapted to include some new or different functionality to enhance or support wireless power transmission.

The system may comprise a PWM generator **410** with at least two outputs coupled to at least four transistor gate drivers **334** that may be controlled by signals generated in a master control algorithm. The four transistor gate drivers **334** may be coupled to four power transistors **336** directly or via gate drive transformers that may drive the source resonator coil **344** through impedance matching networks **342**. The power transistors **336** may be coupled and powered with an adjustable DC supply **304** and the adjustable DC supply **304** may be controlled by a Vbus controller **326** which may be controlled by a master control algorithm. The Vbus controller **326** may control the voltage output of the adjustable DC supply **304** which may be used to control power output of the amplifier and power delivered to the resonator coil **344.**

The system may comprise sensing and measurement circuitry including signal filtering and buffering circuits **318, 320** and differential/single ended conversion circuitry **402, 404** that may shape, modify, filter, process, buffer, and the like, signals prior to being input to processors and/or converters such as analog to digital converters (ADC) **314, 316**. The processors and/or converters such as ADC **314,316** may be integrated into a microcontroller **302** or may be separate circuits that may be coupled to a processing core **330**. Based on measured signals, the master control algorithm may generate, limit, initiate, extinguish, control, adjust, or modify the operation of any of the PWM generator **410,** the communication controller **332,** the Vbus controller **326,** the source impedance matching controller **338,** the filter/buffering elements, **318, 320,** differential/single ended conversion circuitry **402, 404,** the converters, **314, 316,** the resonator coil **344,** and may be part of or integrated into a microcontroller **302** or a separate circuit.

Impedance matching networks **342** and resonator coils **344** may comprise electrically controllable, variable, or tunable components such as capacitors, switches, inductors, and the like, as described herein, and these components may have their component values or operating points adjusted according to signals received from the source impedance matching controller **338.** Components may be tuned to enable tuning of the operation and characteristics of the resonator including the power delivered to and by the resonator, the resonant frequency of the resonator, the impedance of the resonator, the Q of the resonator, and any other coupled systems, and the like. The resonator may be any type or structure resonator described herein including a capacitively loaded loop resonator, a planar resonator comprising a magnetic material or any combination thereof.

Impedance matching networks may comprise fixed value components such as capacitors, inductors, and networks of components as described herein. Parts of the impedance matching networks , A, B and C, may comprise inductors, capacitors, transformers, and series and parallel combinations of such components, as described herein. In some embodiments, parts of the impedance matching networks A, B, and C, may be empty (short-circuited). In some embodiments, part B comprises a series combination of an inductor and a capacitor, and part C is empty.

The full bridge topology may allow operation at higher output power levels using the same DC bus voltage as an equivalent half bridge amplifier. The half bridge exemplary topology of Fig. 3 may provide a single-ended drive signal, while the exemplary full bridge topology of Fig. 4 may provide a differential drive to the source resonator **308.** The impedance matching topologies and components and the resonator structure may be different for the two systems, as discussed herein.

The exemplary systems depicted in Figures 3 and 4 may further include fault detection circuitry **340** that may be used to trigger the shutdown of the microcontroller in the source amplifier or to change or interrupt the operation of the amplifier. This protection circuitry may comprise a high speed comparator or comparators to monitor the amplifier return current, the amplifier bus voltage (Vbus) from the DC supply **304,** the voltage across the source resonator **308** and/or the optional tuning board, or any other voltage or current signals that may cause damage to components in the system or may yield undesirable operating conditions. Preferred embodiments may depend on the potentially undesirable operating modes associated with different applications. In some embodiments, protection circuitry may not be implemented or circuits may not be populated. In some embodiments, system and component protection may be implemented as part of a master control algorithm and other system monitoring and control circuits. In embodiments, dedicated fault circuitry **340** may include an output (not shown) coupled to a master control algorithm **328** that may trigger a system shutdown, a reduction of the output power (e.g. reduction of Vbus), a change to the PWM generator, a change in the operating frequency, a change to a tuning element, or any other reasonable action that may be implemented by the control algorithm **328** to adjust the operating point mode, improve system performance, and/or provide protection.

As described herein, sources in wireless power transfer systems may use a measurement of the input impedance of the impedance matching network **342** driving source resonator coil **344** as an error or control signal for a system control loop that may be part of the master control algorithm. In exemplary embodiments, variations in any combination of three parameters may be used to tune the wireless power source to compensate for changes in environmental conditions, for changes in coupling, for changes in device power demand, for changes in module, circuit, component or subsystem performance, for an increase or decrease in the number or sources, devices, or repeaters in the system, for user initiated changes, and the like. In exemplary embodiments, changes to the amplifier duty cycle, to the component values of the variable electrical components such as variable capacitors and inductors, and to the DC bus voltage may be used to change the operating point or operating range of the wireless source and improve some system operating value. The specifics of the control algorithms employed for different applications may vary depending on the desired system performance and behavior.

Impedance measurement circuitry such as described herein, and shown in Figures 3 and 4, may be implemented using two-channel simultaneous sampling ADCs and these ADCs may be integrated into a microcontroller chip or may be part of a separate circuit. Simultaneously sampling of the voltage and current signals at the input to a source resonator's impedance matching network and/or the source resonator, may yield the phase and magnitude information of the current and voltage signals and may be processed using known signal processing techniques to yield complex impedance parameters. In some embodiments, monitoring only the voltage signals or only the current signals may be sufficient.

The impedance measurements described herein may use direct sampling methods which may be relatively simpler than some other known sampling methods. In embodiments, measured voltage and current signals may be conditioned, filtered and scaled by filtering/buffering circuitry before being input to ADCs. In embodiments, the filter/buffering circuitry may be adjustable to work at a variety of signal levels and frequencies, and circuit parameters such as filter shapes and widths may be adjusted manually, electronically, automatically, in response to a control signal, by the master control algorithm, and the like. Exemplary embodiments of filter/buffering circuits are shown in Figures 3, 4, and 5.

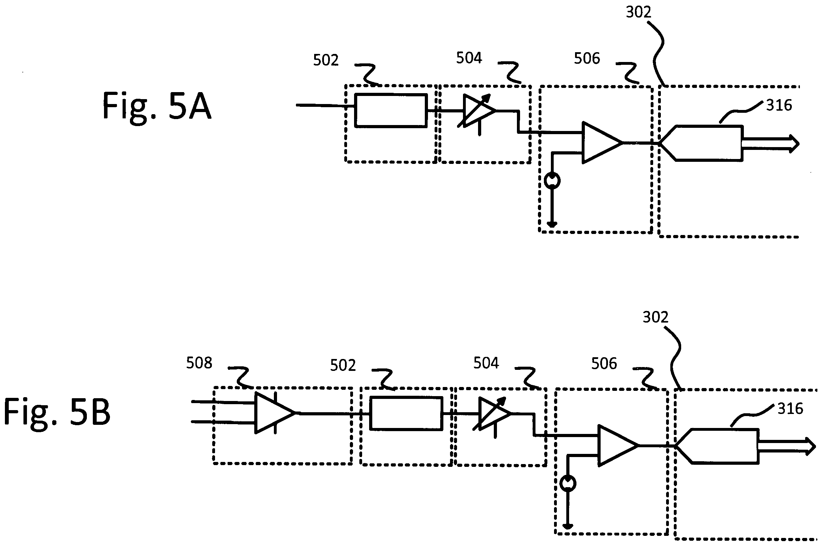

Fig. 5 shows more detailed views of exemplary circuit components that may be used in filter/buffering circuitry. In embodiments, and depending on the types of ADCs used in the system designs, single-ended amplifier topologies may reduce the complexity of the analog signal measurement paths used to characterize system, subsystem, module and/or component performance by eliminating the need for hardware to convert from differential to single-ended signal formats. In other implementations, differential signal formats may be preferable. The implementations shown in Fig. 5 are exemplary, and should not be construed to be the only possible way to implement the functionality described herein.

Rather it should be understood that the analog signal path may employ components with different input requirements and hence may have different signal path architectures.

In both the single ended and differential amplifier topologies, the input current to the impedance matching networks **342** driving the resonator coils **344** may be obtained by measuring the voltage across a capacitor **324,** or via a current sensor of some type. For the exemplary single-ended amplifier topology in Fig. 3, the current may be sensed on the ground return path from the impedance matching network **342**. For the exemplary differential power amplifier depicted in Fig. 4, the input current to the impedance matching networks **342** driving the resonator coils **344** may be measured using a differential amplifier across the terminals of a capacitor **324** or via a current sensor of some type. In the differential topology of Fig. 4, the capacitor **324** may be duplicated at the negative output terminal of the source power amplifier.

In both topologies, after single ended signals representing the input voltage and current to the source resonator and impedance matching network are obtained, the signals may be filtered **502** to obtain the desired portions of the signal waveforms. In embodiments, the signals may be filtered to obtain the fundamental component of the signals. In embodiments, the type of filtering performed, such as low pass, bandpass, notch, and the like, as well as the filter topology used, such as elliptical, Chebyshev, Butterworth, and the like, may depend on the specific requirements of the system. In some embodiments, no filtering will be required.

The voltage and current signals may be amplified by an optional amplifier **504**. The gain of the optional amplifier **504** may be fixed or variable. The gain of the amplifier may be controlled manually, electronically, automatically, in response to a control signal, and the like. The gain of the amplifier may be adjusted in a feedback loop, in response to a control algorithm, by the master control algorithm, and the like. In embodiments, required performance specifications for the amplifier may depend on signal strength and desired measurement accuracy, and may be different for different application scenarios and control algorithms.

The measured analog signals may have a DC offset added to them, **506,** which may be required to bring the signals into the input voltage range of the ADC which for some systems may be 0 to 3.3V. In some systems this stage may not be required, depending on the specifications of the particular ADC used.

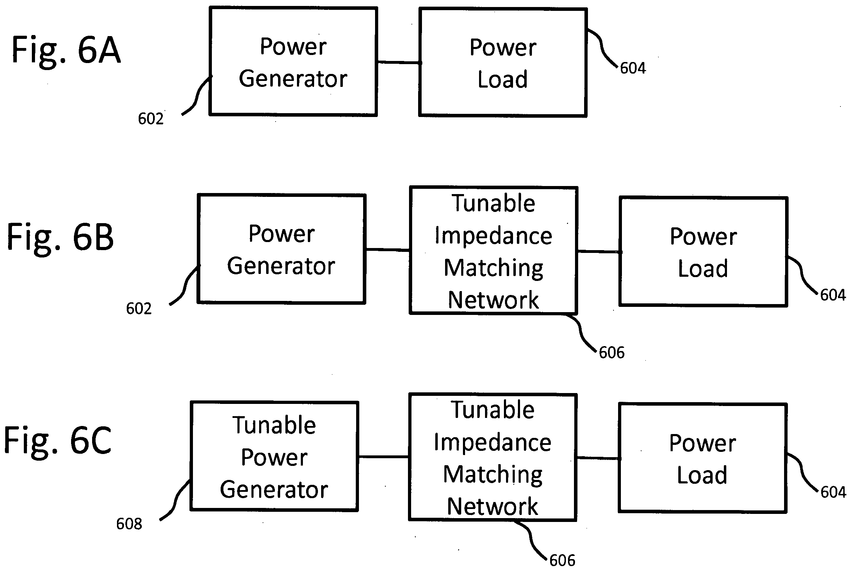

As described above, the efficiency of power transmission between a power generator and a power load may be impacted by how closely matched the output impedance of the generator is to the input impedance of the load. In an exemplary system as shown in Fig. 6A, power may be delivered to the load at a maximum possible efficiency, when the input impedance of the load **604** is equal to the complex conjugate of the internal impedance of the power generator or the power amplifier **602**. Designing the generator or load impedance to obtain a high and/or maximum power transmission efficiency may be called "impedance matching". Impedance matching may be performed by inserting appropriate networks or sets of elements such as capacitors, resistors, inductors, transformers, switches and the like, to form an impedance matching network **606,** between a power generator **602** and a power load **604** as shown in Fig. 6B. In other embodiments, mechanical adjustments and changes in element positioning may be used to achieve impedance matching. As described above for varying loads, the impedance matching network **606** may include variable components that are dynamically adjusted to ensure that the impedance at the generator terminals looking towards the load and the characteristic impedance of the generator remain substantially complex conjugates of each other, even in dynamic environments and operating scenarios. In embodiments, dynamic impedance matching may be accomplished by tuning the duty cycle, and/or the phase, and/or the frequency of the driving signal of the power generator or by tuning a physical component within the power generator, such as a capacitor, as depicted in Fig. 6C. Such a tuning mechanism may be advantageous because it may allow impedance matching between a power generator **608** and a load without the use of a tunable impedance matching network, or with a simplified tunable impedance matching network **606,** such as one that has fewer tunable components for example. In embodiments, tuning the duty cycle, and/or frequency, and/or phase of the driving signal to a power generator may yield a dynamic impedance matching system with an extended tuning range or precision, with higher power, voltage and/or current capabilities, with faster electronic control, with fewer external components, and the like. The impedance matching methods, architectures, algorithms, protocols, circuits, measurements, controls, and the like, described below, may be useful in systems where power generators drive high-Q magnetic resonators and in high-Q wireless power transmission systems as described herein. In wireless power transfer systems a power generator may be a power amplifier driving a resonator, sometimes referred to as a source resonator, which may be a load to the power amplifier. In wireless power applications, it may be preferable to control the impedance matching between a power amplifier and a resonator load to control the efficiency of the power delivery from the power amplifier to the resonator. The impedance matching may be accomplished, or accomplished in part, by tuning or adjusting the duty cycle, and/or the phase, and/or the frequency of the driving signal of the power amplifier that drives the resonator.

Efficiency of switching amplifiers

Switching amplifiers, such as class D, E, F amplifiers, and the like or any combinations thereof, deliver power to a load at a maximum efficiency when almost no power is dissipated on the switching elements of the amplifier. This operating condition may be accomplished by designing the system so that the switching operations which are most critical (namely those that are most likely to lead to switching losses) are done when either or both of the voltage across the switching element and the current through the switching element are nearly zero. These conditions may be referred to as Zero Voltage Switching (ZVS) and Zero Current Switching (ZCS) conditions respectively. When an amplifier operates at ZVS and/or ZCS either the voltage across the switching element or the current through the switching element is zero and thus no power can be dissipated in the switch. Since a switching amplifier may convert DC (or very low frequency AC) power to AC power at a specific frequency or range of frequencies, a filter may be introduced before the load to prevent unwanted harmonics that may be generated by the switching process from reaching the load and being dissipated there. In embodiments, a switching amplifier may be designed to operate at maximum efficiency of power conversion, when connected to a resonant load, with a quality factor (say Q>5), and of a specific impedance

$Z_o^* = R_o + jX_o,$ which leads to simultaneous ZVS and ZCS. We define $Z_o = R_o - jX_o$ as the characteristic impedance of the amplifier, so that achieving maximum power transmission efficiency is equivalent to impedance matching the resonant load to the characteristic impedance of the amplifier.

In a switching amplifier, the switching frequency of the switching elements, $f_{switch}$, wherein $f_{switch} = \omega/2\pi$ and the duty cycle, $dc$, of the ON switch-state duration of the switching elements may be the same for all switching elements of the amplifier. In this specification, we will use the term "class D" to denote both class D and class DE amplifiers, that is, switching amplifiers with $dc<=50\%$.

The value of the characteristic impedance of the amplifier may depend on the operating frequency, the amplifier topology, and the switching sequence of the switching elements. In some embodiments, the switching amplifier may be a half-bridge topology and, in some embodiments, a full-bridge topology. In some embodiments, the switching amplifier may be class D and, in some embodiments, class E. In any of the above embodiments, assuming the elements of the bridge are symmetric, the characteristic impedance of the switching amplifier has the form

$$R_o = F_R(dc)/\omega C_a \, , X_o = F_X(dc)/\omega C_a \, , \qquad (1)$$

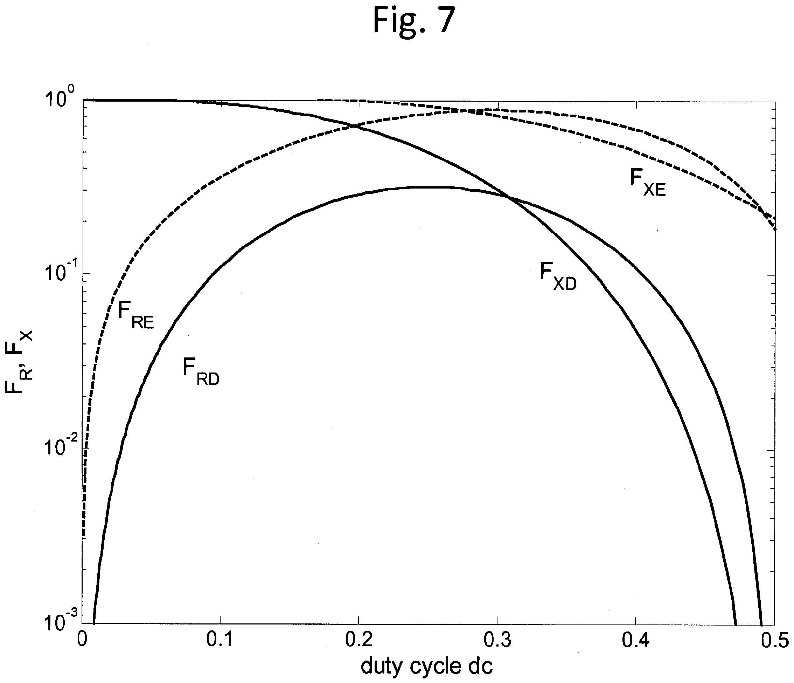

where $dc$ is the duty cycle of ON switch-state of the switching elements, the functions $F_R(dc)$ and $F_X(dc)$ are plotted in Fig. 7 (both for class D and E), $\omega$ is the frequency at which the switching elements are switched, and $C_a = n_a C_{switc}$ where $C_{switc}$ is the capacitance across each switch, including both the transistor output capacitance and also possible external capacitors placed in parallel with the switch, while $n_a = 1$ for a full bridge and $n_a = 2$ for a half bridge. For class D, one can also write the analytical expressions

$$F_R(dc) = sin^2 u/\pi, \quad F_X(dc) = (u - sinu * cosu)/\pi \, , \qquad (2)$$

where $u = \pi(1 - 2 * dc)$, indicating that the characteristic impedance level of a class D amplifier decreases as the duty cycle, $dc$, increases towards 50%. For a class D amplifier operation with dc=50%, achieving ZVS and ZCS is possible only when the switching elements have practically no output capacitance ($C_a = 0$) and the load is exactly on resonance ($X_o = 0$), while $R_o$ can be arbitrary.

Impedance Matching Networks

In applications, the driven load may have impedance that is very different from the characteristic impedance of the external driving circuit, to which it is connected. Furthermore, the driven load may not be a resonant network. An Impedance Matching Network (IMN) is a circuit network that may be connected before a load as in Fig. 6B, in order to regulate the impedance that is seen at the input of the network consisting of the IMN circuit and the load. An IMN circuit may typically achieve this regulation by creating a resonance close to the driving frequency. Since such an IMN circuit accomplishes all conditions needed to maximize the power transmission efficiency from the generator to the load (resonance and impedance matching-ZVS and ZCS for a switching amplifier), in embodiments, an IMN circuit may be used between the driving circuit and the load.

For an arrangement shown in Fig. 6B, let the input impedance of the network consisting of the Impedance Matching Network (IMN) circuit and the load (denoted together from now on as IMN+load) be $Z_l = R_l(\omega) + jX_l(\omega)$. The impedance matching conditions of this network to the external circuit with characteristic impedance $Z_o = R_o - jX_o$ are then $R_l(\omega) = R_o$, $X_l(\omega) = X_o$.

Methods for tunable Impedance Matching of a variable load

In embodiments where the load may be variable, impedance matching between the load and the external driving circuit, such as a linear or switching power amplifier, may be achieved by using adjustable/tunable components in the IMN circuit that may be adjusted to match the varying load to the fixed characteristic impedance $Z_o$ of the external circuit (Fig. 6B). To match both the real and imaginary parts of the impedance two tunable/variable elements in the IMN circuit may be needed.

In embodiments, the load may be inductive (such as a resonator coil) with impedance $R + j\omega L$, so the two tunable elements in the IMN circuit may be two tunable capacitance networks or one tunable capacitance network and one tunable inductance network or one tunable capacitance network and one tunable mutual inductance network.

In embodiments where the load may be variable, the impedance matching between the load and the driving circuit, such as a linear or switching power amplifier, may be achieved by using adjustable/tunable components or parameters in the amplifier circuit that may be adjusted to match the characteristic impedance $Z_o$ of the amplifier to the varying (due to load variations) input impedance of the network consisting of the IMN circuit and the load (IMN+load), where the IMN circuit may also be tunable (Fig. 6C). To match both the real and imaginary parts of the impedance, a total of two tunable/variable elements or parameters in the amplifier and the IMN circuit may be needed. The disclosed impedance matching method can reduce the required number of tunable/variable elements in the IMN circuit or even completely eliminate the requirement for tunable/variable elements in the IMN circuit. In some examples, one tunable element in the power amplifier and one tunable element in the IMN circuit may be used. In some examples, two tunable elements in the power amplifier and no tunable element in the IMN circuit may be used.

In embodiments, the tunable elements or parameters in the power amplifier may be the frequency, amplitude, phase, waveform, duty cycle and the like of the drive signals applied to transistors, switches, diodes and the like.

In embodiments, the power amplifier with tunable characteristic impedance may be a tunable switching amplifier of class D, E, F or any combinations thereof. Combining Equations (1) and (2), the impedance matching conditions for this network are

$$R_l(\omega) = F_R(dc)/\omega C_a \, , X_l(\omega) = F_X(dc)/\omega C_a \qquad (3).$$

In some examples of a tunable switching amplifier, one tunable element may be the capacitance $C_a$, which may be tuned by tuning the external capacitors placed in parallel with the switching elements.

In some examples of a tunable switching amplifier, one tunable element may be the duty cycle $dc$ of the ON switch-state of the switching elements of the amplifier. Adjusting the duty cycle, $dc$, via Pulse Width Modulation (PWM) has been used in switching amplifiers to achieve output power control. In this specification, we disclose that PWM may also be used to achieve impedance matching, namely to satisfy Eqs.(3), and thus maximize the amplifier efficiency.

In some examples of a tunable switching amplifier one tunable element may be the switching frequency, which is also the driving frequency of the IMN+load network and may be designed to be substantially close to the resonant frequency of the IMN+load network. Tuning the switching frequency may change the characteristic impedance of the amplifier and the impedance of the IMN+load network. The switching frequency of the amplifier may be tuned appropriately together with one more tunable parameters, so that Eqs.(3) are satisfied.

A benefit of tuning the duty cycle and/or the driving frequency of the amplifier for dynamic impedance matching is that these parameters can be tuned electronically, quickly, and over a broad range. In contrast, for example, a tunable capacitor that can sustain a large voltage and has a large enough tunable range and quality factor may be expensive, slow or unavailable for with the necessary component specifications

Examples of methods for tunable Impedance Matching of a variable load

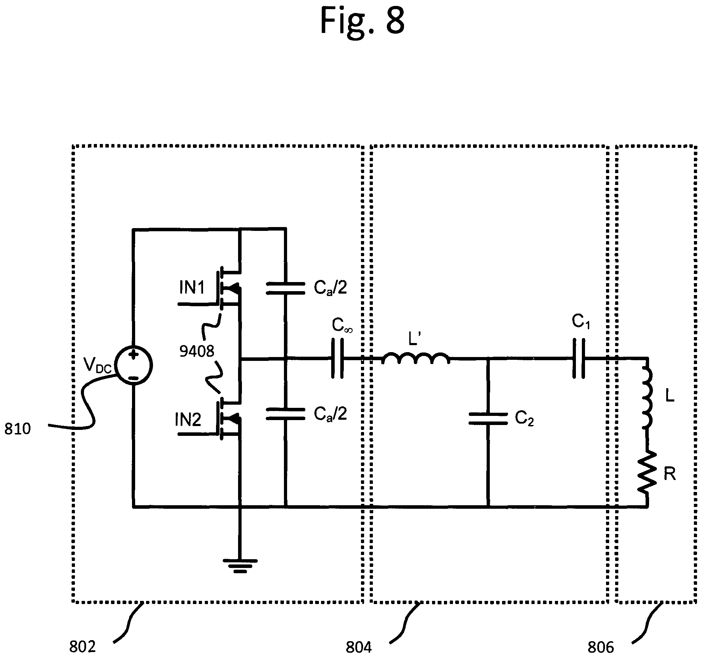

A simplified circuit diagram showing the circuit level structure of a class D power amplifier **802,** impedance matching network **804** and an inductive load **806** is shown in Fig. 8. The diagram shows the basic components of the system with the switching amplifier **804** comprising a power source **810,** switching elements **808,** and capacitors. The impedance matching network **804** comprising inductors and capacitors, and the load **806** modeled as an inductor and a resistor.

An exemplary embodiment of this inventive tuning scheme comprises a half-bridge class-D amplifier operating at switching frequency $f$ and driving a low-loss inductive element $R + j\omega L$ via an IMN, as shown in Fig. 8.

In some embodiments $L'$ may be tunable. $L'$ may be tuned by a variable tapping point on the inductor or by connecting a tunable capacitor in series or in parallel to the inductor. In some embodiments $C_a$ may be tunable. For the half bridge topology, $C_a$ may be tuned by varying either one or both capacitors $C_{switc}$, as only the parallel sum of these capacitors matters for the amplifier operation. For the full bridge topology, $C_a$ may be tuned by varying either one, two, three or all capacitors $C_{switc}$, as only their combination (series sum of the two parallel sums associated with the two halves of the bridge) matters for the amplifier operation.

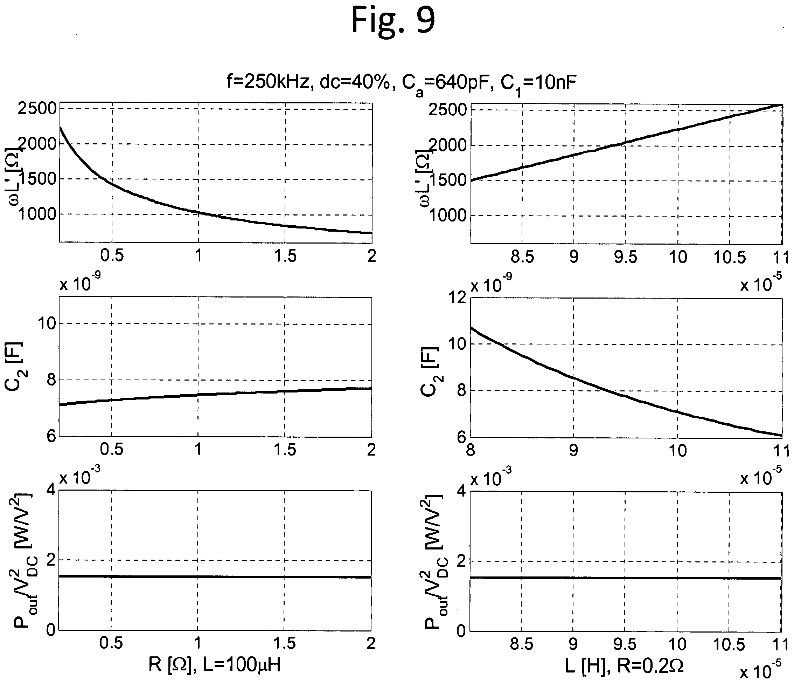

In some embodiments of tunable impedance matching, two of the components of the IMN may be tunable. In some embodiments, $L'$ and $C_2$ may be tuned. Then, Fig. 9 shows the values of the two tunable components needed to achieve impedance matching as functions of the varying R and L of the inductive element, and the associated variation of the output power (at given DC bus voltage) of the amplifier, for $f = 250kHz$, $dc = 40\%$, $C_a = 640pF$ and $C_1 = 10nF$. Since the IMN always adjusts to the fixed characteristic impedance of the amplifier, the output power is always constant as the inductive element is varying.

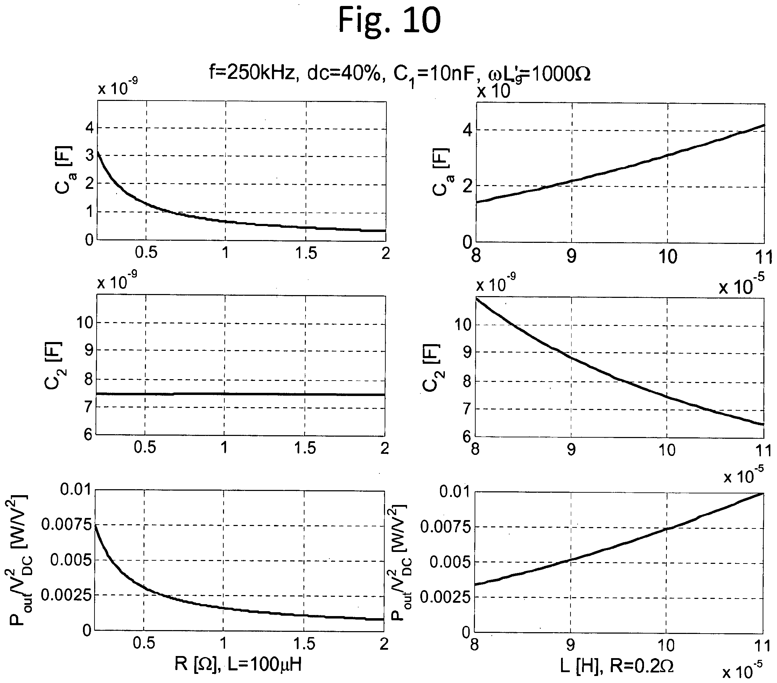

In some embodiments of tunable impedance matching, elements in the switching amplifier may also be tunable. In some embodiments the capacitance $C_a$ along with the IMN capacitor $C_2$ may be tuned. Then, Fig. 10 shows the values of the two tunable components needed to achieve impedance matching as functions of the varying $R$ and $L$ of the inductive element, and the associated variation of the output power (at given DC bus voltage) of the amplifier for $f = 250kHz$, $dc = 40\%$, $C_1 = 10nF$ and $\omega L' = 1000\Omega$. It can be inferred from Fig. 10 that $C_2$ needs to be tuned mainly in response to variations in $L$ and that the output power decreases as $R$ increases.

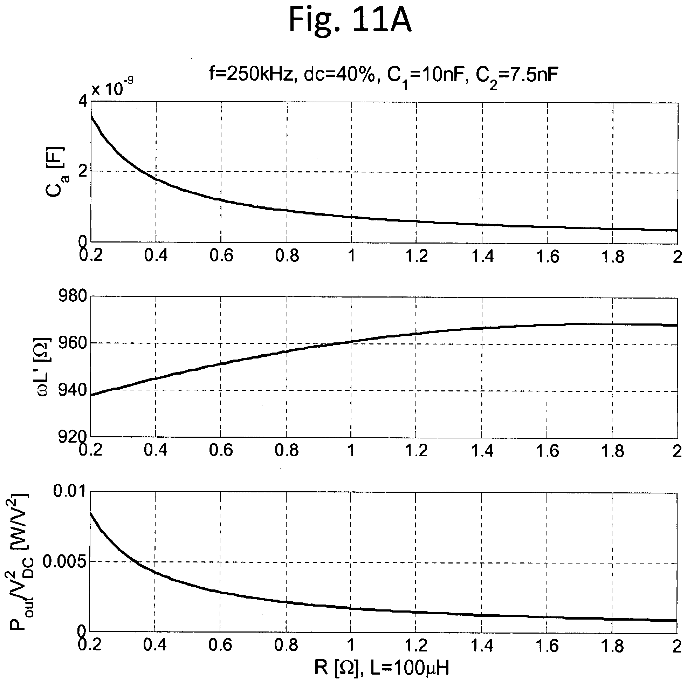

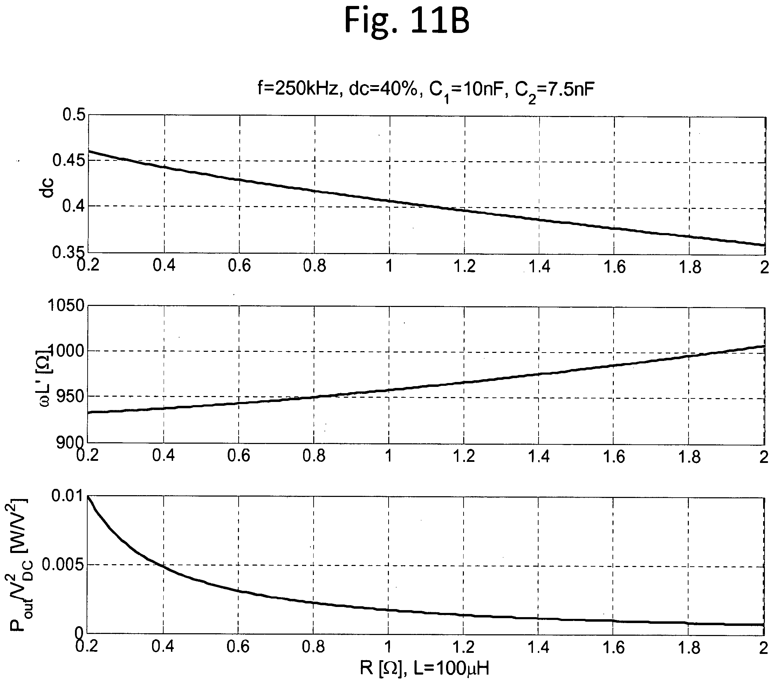

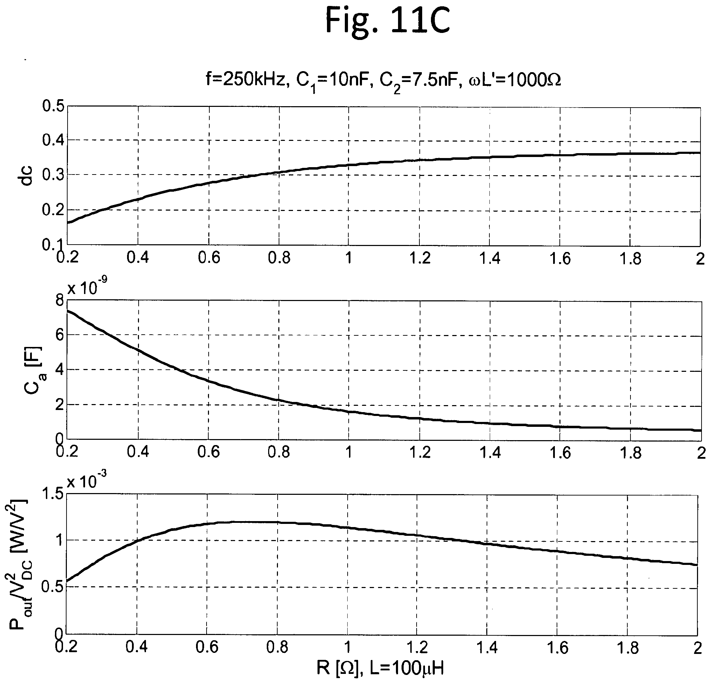

In some embodiments of tunable impedance matching, the duty cycle $dc$ along with the IMN capacitor $C_2$ may be tuned. Then, Fig. 11 shows the values of the two tunable parameters needed to achieve impedance matching as functions of the varying $R$ and $L$ of the inductive element, and the associated variation of the output power (at given DC bus voltage) of the amplifier for $f = 250kHz$, $C_a = 640pF$, $C_1 = 10nF$ and $\omega L' = 1000\Omega$. It can be inferred from Fig. 11 that $C_2$ needs to be tuned mainly in response to variations in $L$ and that the output power decreases as R increases.

In some embodiments of tunable impedance matching, the capacitance $C_a$ along with the IMN inductor $L'$ may be tuned. Then, Fig. 11A shows the values of the two tunable components needed to achieve impedance matching as functions of the varying $R$ of the inductive element, and the associated variation of the output power (at given DC bus voltage) of the amplifier for $f = 250kHz$, $dc = 40\%$, $C_1 = 10nF$ and $C_2 = 7.5nF$. It can be inferred from Fig. 11A that the output power decreases as $R$ increases.

In some embodiments of tunable impedance matching, the duty cycle $dc$ along with the IMN inductor $L'$ may be tuned. Then, Fig. 11B shows the values of the two tunable parameters needed to achieve impedance matching as functions of the varying $R$ of the inductive element, and the associated variation of the output power (at given DC bus voltage) of the amplifier for $f = 250kHz$, $C_a = 640pF$, $C_1 = 10nF$ and $C_2 = 7.5nF$ as functions of the varying $R$ of the inductive element. It can be inferred from Fig. 11B that the output power decreases as $R$ increases.

In some embodiments of tunable impedance matching, only elements in the switching amplifier may be tunable with no tunable elements in the IMN. In some embodiments the duty cycle $dc$ along with the capacitance $C_a$ may be tuned. Then, Fig. 11C, shows the values of the two tunable parameters needed to achieve impedance matching as functions of the varying $R$ of the inductive element, and the associated variation of the output power (at given DC bus voltage) of the amplifier for $f = 250kHz$, $C_1 = 10nF$, $C_2 = 7.5nF$ and $\omega L' = 1000\Omega$. It can be inferred from Fig. 11C that the output power is a non-monotonic function of $R$. These embodiments may be able to achieve dynamic impedance matching when variations in $L$ (and thus the resonant frequency) are modest.

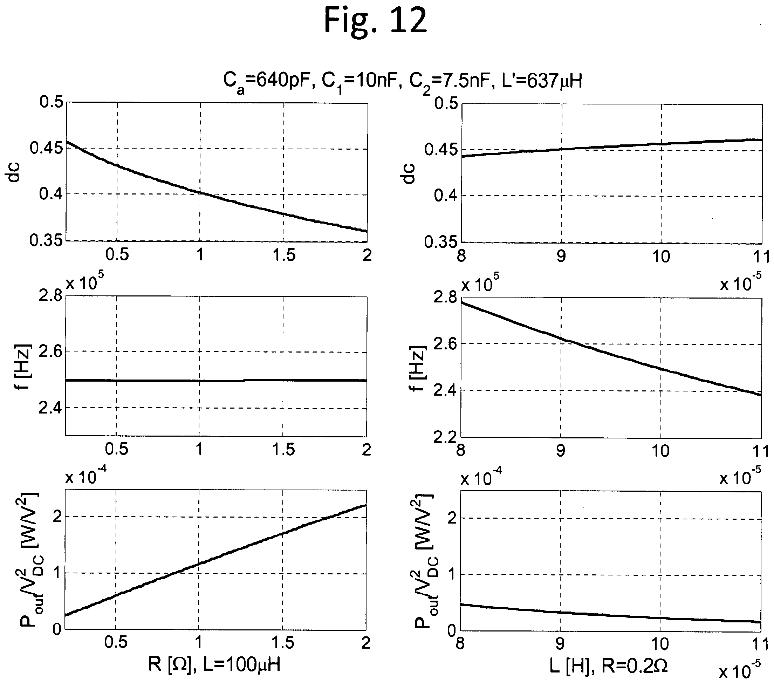

In some embodiments, dynamic impedance matching with fixed elements inside the IMN, also when $L$ is varying greatly as explained earlier, may be achieved by varying the driving frequency of the external frequency $f$ (e.g. the switching frequency of a switching amplifier) so that it follows the varying resonant frequency of the resonator. Using the switching frequency $f$ and the switch duty cycle $dc$ as the two variable parameters, full impedance matching can be achieved as $R$ and $L$ are varying without the need of any variable components. Then, Fig. 12 shows the values of the two tunable parameters needed to achieve impedance matching as functions of the varying $R$ and $L$ of the inductive element, and the associated variation of the output power (at given DC bus voltage) of the amplifier for $C_a = 640pF$, $C_1 = 10nF$, $C_2 = 7.5nF$ and $L' = 637\mu H$. It can be inferred from Fig. 12 that the frequency $f$ needs to be tuned mainly in response to variations in $L$, as explained earlier.

Tunable Impedance Matching for systems of wireless power transmission

In applications of wireless power transfer the low-loss inductive element may be the coil of a source resonator coupled to one or more device resonators or other resonators, such as repeater resonators, for example. The impedance of the inductive element R + $j\omega L$ may include the reflected impedances of the other resonators on the coil of the source resonator. Variations of $R$ and $L$ of the inductive element may occur due to external perturbations in the vicinity of the source resonator and/or the other resonators or thermal drift of components. Variations of $R$ and $L$ of the inductive element may also occur during normal use of the wireless power transmission system due to relative motion of the devices and other resonators with respect to the source. The relative motion of these devices and other resonators with respect to the source, or relative motion or position of other sources, may lead to varying coupling (and thus varying reflected impedances) of the devices to the source. Furthermore, variations of R and $L$ of the inductive element may also occur during normal use of the wireless power transmission system due to changes within the other coupled resonators, such as changes in the power draw of their loads. All the methods and embodiments disclosed so far apply also to this case in order to achieve dynamic impedance matching of this inductive element to the external circuit driving it.

To demonstrate the presently disclosed dynamic impedance matching methods for a wireless power transmission system, consider a source resonator including a low-loss source coil, which is inductively coupled to the device coil of a device resonator driving a resistive load.

In some embodiments, dynamic impedance matching may be achieved at the source circuit. In some embodiments, dynamic impedance matching may also be achieved at the device circuit. When full impedance matching is obtained (both at the source and the device), the effective resistance of the source inductive element (namely the resistance of the source coil $R_s$ plus the reflected impedance from the device) is $R = R_s\sqrt{1 + U_{sd}^2}$. (Similarly the effective resistance of the device inductive element is $R_d\sqrt{1 + U_{sd}^2}$, where $R_d$ is the resistance of the device coil.) Dynamic variation of the mutual inductance between the coils due to motion results in a dynamic variation of $U_{sd} = \omega M_{sd}/\sqrt{R_s R_d}$. Therefore, when both source and device are dynamically tuned, the variation of mutual inductance is seen from the source circuit side as a variation in the source inductive element resistance $R$. Note that in this type of variation, the resonant frequencies of the resonators may not change substantially, since $L$ may not be changing. Therefore, all the methods and examples presented for dynamic impedance matching may be used for the source circuit of the wireless power transmission system.

Note that, since the resistance $R$ represents both the source coil and the reflected impedances of the device coils to the source coil, in Figures 9-12, as $R$ increases due to the increasing $U$, the associated wireless power transmission efficiency increases. In some embodiments, an approximately constant power may be required at the load driven by the device circuitry. To achieve a constant level of power transmitted to the device, the required output power of the source circuit may need to decrease as $U$ increases. If dynamic impedance matching is achieved via tuning some of the amplifier parameters, the output power of the amplifier may vary accordingly. In some embodiments, the automatic variation of the output power is preferred to be monotonically decreasing with R, so that it matches the constant device power requirement. In embodiments where the output power level is accomplished by adjusting the DC driving voltage of the power generator, using an impedance matching set of tunable parameters which leads to monotonically decreasing output power vs. $R$ will imply that constant power can be kept at the power load in the device with only a moderate adjustment of the DC driving voltage. In embodiments, where the "knob" to adjust the output power level is the duty cycle $dc$ or the phase of a switching amplifier or a component inside an Impedance Matching Network, using an impedance matching set of tunable parameters which leads to monotonically decreasing output power vs. $R$ will imply that constant power can be kept at the power load in the device with only a moderate adjustment of this power "knob".

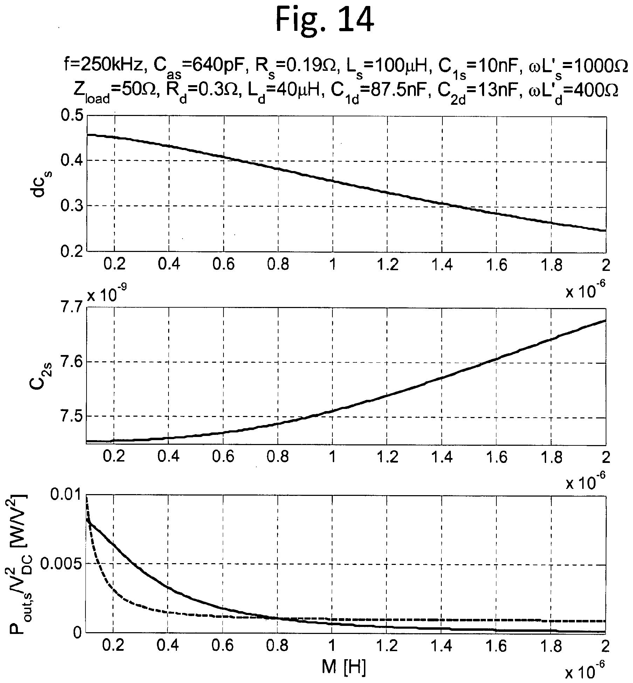

In the examples of Figures 9-12, if $R_s$ = 0.19Ω, then the range $R$ = 0.2 - 2Ω corresponds approximately to $U_{sd}$ = 0.3 - 10.5. For these values, in Fig. 14, we show with dashed lines the output power (normalized to DC voltage squared) required to keep a constant power level at the load, when both source and device are dynamically impedance matched. The similar trend between the solid and dashed lines explains why a set of tunable parameters with such a variation of output power may be preferable.

In some embodiments, dynamic impedance matching may be achieved at the source circuit, but impedance matching may not be achieved or may only partially be achieved at the device circuit. As the mutual inductance between the source and device coils varies, the varying reflected impedance of the device to the source may result in a variation of both the effective resistance R and the effective inductance $L$ of the source inductive element. The methods presented so far for dynamic impedance matching are applicable and can be used for the tunable source circuit of the wireless power transmission system.

As an example, consider the circuit of Fig. 14, where $f$ = 250kHz, $C_a$ = 640pF, $R_s$ = 0.19Ω, $L_s$ = 100μH, $C_{1s}$ = 10nF, $\omega L_s' = 1000\Omega$, $R_d$ = 0.3Ω, $L_d$ = 40μH, $C_{1d}$ = 87.5nF, $C_{2d}$ = 13nF, $\omega L_d' = 400\Omega$ and $Z_l$ = 50Ω, where s and d denote the source and device resonators respectively and the system is matched at $U_{sd}$ = 3. Tuning the duty cycle $dc$ of the switching amplifier and the capacitor $C_{2s}$ may be used to dynamically impedance match the source, as the non-tunable device is moving relatively to the source changing the mutual inductance $M$ between the source and the device. In Fig. 14, we show the required values of the tunable parameters along with the output power per DC voltage of the amplifier. The dashed line again indicates the output power of the amplifier that would be needed so that the power at the load is a constant value.

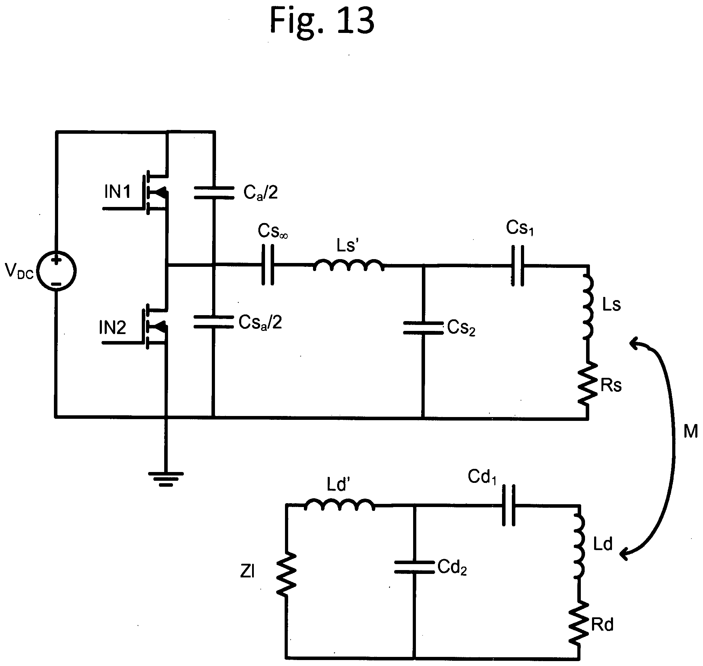

In some embodiments, tuning the driving frequency $f$ of the source driving circuit may still be used to achieve dynamic impedance matching at the source for a system of wireless power transmission between the source and one or more devices. As explained earlier, this method enables full dynamic impedance matching of the source, even when there are variations in the source inductance $L_s$ and thus the source resonant frequency. For efficient power transmission from the source to the devices, the device resonant frequencies must be tuned to follow the variations of the matched driving and source-resonant frequencies. Tuning a device capacitance (for example, in the embodiment of Fig. 13 $C_{1d}$ or $C_{2d}$) may be necessary, when there are variations in the resonant frequency of either the source or the device resonators. In fact, in a wireless power transfer system with multiple sources and devices, tuning the driving frequency alleviates the need to tune only one source-object resonant frequency, however, all the rest of the objects may need a mechanism (such as a tunable capacitance) to tune their resonant frequencies to match the driving frequency.

## **Resonator Thermal Management**

In wireless energy transfer systems, some portion of the energy lost during the wireless transfer process is dissipated as heat. Energy may be dissipated in the resonator components themselves. For example, even high-Q conductors and components have some loss or resistance, and these conductors and components may heat up when electric currents and/or electromagnetic fields flow through them. Energy may be dissipated in materials and objects around a resonator. For example, eddy currents dissipated in imperfect conductors or dielectrics surrounding or near-by the resonator may heat up those objects. In addition to affecting the material properties of those objects, this heat may be transferred through conductive, radiative, or convective processes to the resonator components. Any of these heating effects may affect the resonator Q, impedance, frequency, etc., and therefore the performance of the wireless energy transfer system.

In a resonator comprising a block or core of magnetic material, heat may be generated in the magnetic material due to hysteresis losses and to resistive losses resulting from induced eddy currents. Both effects depend on the magnetic flux density in the material, and both can create significant amounts of heat, especially in regions where the flux density or eddy currents may be concentrated or localized. In addition to the flux density, the frequency of the oscillating magnetic field, the magnetic material composition and losses, and the ambient or operating temperature of the magnetic material may all impact how hysteresis and resistive losses heat the material.

In embodiments, the properties of the magnetic material such as the type of material, the dimensions of the block, and the like, and the magnetic field parameters may be chosen for specific operating power levels and environments to minimize heating of the magnetic material. In some embodiments, changes, cracks, or imperfections in a block of magnetic material may increase the losses and heating of the magnetic material in wireless power transmission applications.

For magnetic blocks with imperfections, or that are comprised of smaller size tiles or pieces of magnetic material arranged into a larger unit, the losses in the block may be uneven and may be concentrated in regions where there are inhomogeneities or relatively narrow gaps between adjacent tiles or pieces of magnetic material. For example, if an irregular gap exists in a magnetic block of material, then the effective reluctance of various magnetic flux paths through the material may be substantially irregular and the magnetic field may be more concentrated in portions of the block where the magnetic reluctance is lowest. In some cases, the effective reluctance may be lowest where the gap between tiles or pieces is narrowest or where the density of imperfections is lowest. Because the magnetic material guides the magnetic field, the magnetic flux density may not be substantially uniform across the block, but may be concentrated in regions offering relatively lower reluctance. Irregular concentrations of the magnetic field within a block of magnetic material may not be desirable because they may result in uneven losses and heat dissipation in the material.

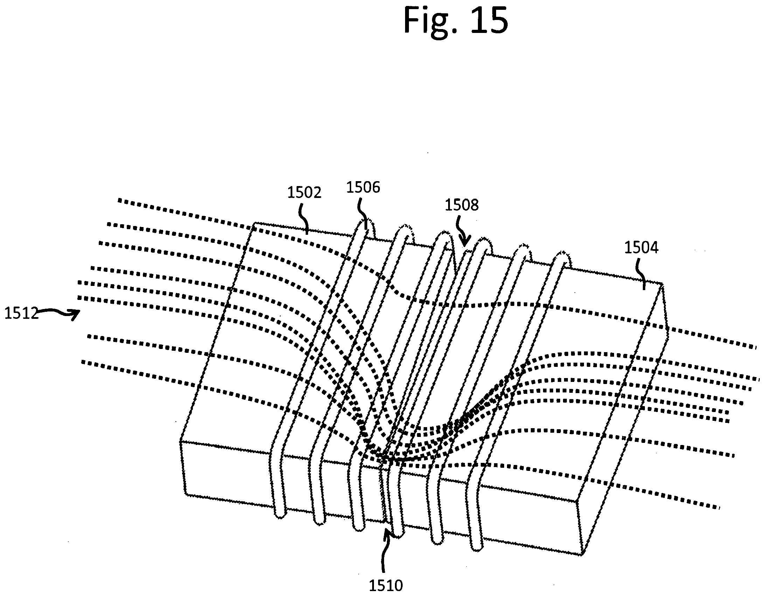

For example, consider a magnetic resonator comprising a conductor **1506** wrapped around a block of magnetic material composed of two individual tiles **1502,1504** of magnetic material joined such that they form a seam **1508** that is perpendicular to the axis of the conductor **1506** loops as depicted in Fig. 15. An irregular gap in the seam **1508** between the tiles of magnetic material **1502,1504** may force the magnetic field **1512** (represented schematically by the dashed magnetic field lines) in the resonator to concentrate in a sub region **1510** of the cross section of the magnetic material. Since the magnetic field will follow the path of least reluctance, a path including an air gap between two pieces of magnetic material may create an effectively higher reluctance path than one that traverses the width of the magnetic material at a point where the pieces of magnetic materials touch or have a smaller air gap. The magnetic flux density may therefore preferentially flow through a relatively small cross area of the magnetic material resulting in a high concentration of magnetic flux in that small area **1510**.

In many magnetic materials of interest, more inhomogeneous flux density distributions lead to higher overall losses. Moreover, the more inhomogeneous flux distribution may result in material saturation and cause localized heating of the area in which the magnetic flux is concentrated. The localized heating may alter the properties of the magnetic material, in some cases exacerbating the losses. For example, in the relevant regimes of operation of some materials, hysteresis and resistive losses increase with temperature. If heating the material increases material losses, resulting in more heating, the temperature of the material may continue to increase and even runaway if no corrective action is taken. In some instances, the temperature may reach 100C or more and may degrade the properties of the magnetic material and the performance of wireless power transfer. In some instances, the magnetic materials may be damaged, or the surrounding electronic components, packaging and/or enclosures may be damaged by the excessive heat.

In embodiments, variations or irregularities between tiles or pieces of the block of magnetic material may be minimized by machining, polishing, grinding, and the like, the edges of the tiles or pieces to ensure a tight fit between tiles of magnetic materials providing a substantially more uniform reluctance through the whole cross section of the block of magnetic material. In embodiments, a block of magnetic material may require a means for providing a compression force between the tiles to ensure the tiles are pressed tight together without gaps. In embodiments, an adhesive may be used between the tiles to ensure they remain in tight contact.

In embodiments the irregular spacing of adjacent tiles of magnetic material may be reduced by adding a deliberate gap between adjacent tiles of magnetic material. In embodiments a deliberate gap may be used as a spacer to ensure even or regular separations between magnetic material tiles or pieces. Deliberate gaps of flexible materials may also reduce irregularities in the spacings due to tile movement or vibrations. In embodiments, the edges of adjacent tiles of magnetic material may be taped, dipped, coated, and the like with an electrical insulator, to prevent eddy currents from flowing through reduced cross-sectional areas of the block, thus lowering the eddy current losses in the material. In embodiments a separator may be integrated into the resonator packaging. The spacer may provide a spacing of 1mm or less.

In embodiments, the mechanical properties of the spacer between tiles may be chosen so as to improve the tolerance of the overall structure to mechanical effects such as changes in the dimensions and/or shape of the tiles due to intrinsic effects (e.g" magnetostriction, thermal expansion, and the like) as well as external shocks and vibrations. For example, the spacer may have a desired amount of mechanical give to accommodate the expansion and/or contraction of individual tiles, and may help reduce the stress on the tiles when they are subjected to mechanical vibrations, thus helping to reduce the appearance of cracks and other defects in the magnetic material.

In embodiments, it may be preferable to arrange the individual tiles that comprise the block of magnetic material to minimize the number of seams or gaps between tiles that are perpendicular to the dipole moment of the resonator. In embodiments it may be preferable to arrange and orient the tiles of magnetic material to minimize the gaps between tiles that are perpendicular to the axis formed by the loops of a conductor comprising the resonator.

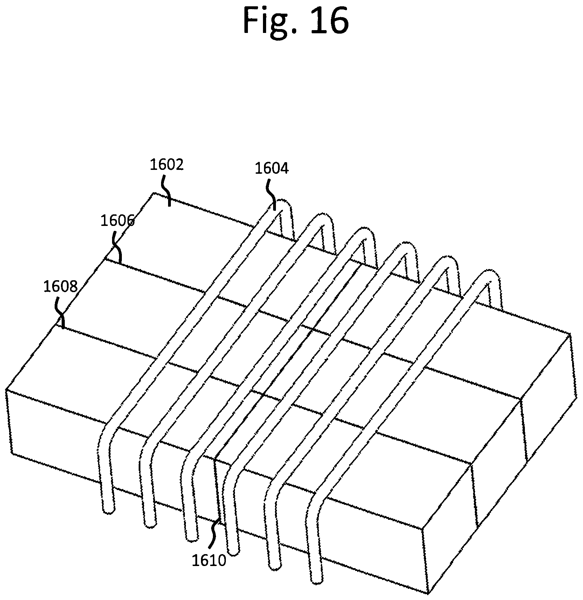

For example, consider the resonator structure depicted in Fig. 16. The resonator comprises a conductor **1604** wrapped around a block of magnetic material comprising six separate individual tiles **1602** arranged in a three by two array. The arrangement of tiles results in two tile seams **1606, 1608** when traversing the block of magnetic material in one direction, and only one tile seam **1610** when traversing the block of magnetic material in the orthogonal direction. In embodiments, it may be preferable to wrap the conductor wire **1604** around the block of magnetic material such that the dipole moment of the resonator is perpendicular to the fewest number of tile seams. The inventors have observed that there is relatively less heating induced around seams and gaps **1606, 1608** that are parallel to the dipole moment of the resonator. Seams and gaps that run perpendicular to the dipole moment of the resonator may also be referred to as critical seams or critical seam areas. It may still be desirable, however, to electrically insulate gaps that run parallel to the dipole moment of the resonator (such as **1606** and **1608)** so as to reduce eddy current losses. Uneven contact between tiles separated by such parallel gaps may cause eddy currents to flow through narrow contact points, leading to large losses at such points.

In embodiments, irregularities in spacing may be tolerated with adequate cooling of the critical seam areas to prevent the localized degradation of material properties when the magnetic material heats up. Maintaining the temperature of the magnetic material below a critical temperature may prevent a runaway effect caused by a sufficiently high temperature. With proper cooling of the critical seam area, the wireless energy transfer performance may be satisfactory despite the additional loss and heating effects due to irregular spacing, cracks, or gaps between tiles.

Effective heatsinking of the resonator structure to prevent excessive localized heating of the magnetic material poses several challenges. Metallic materials that are typically used for heatsinks and thermal conduction can interact with the magnetic fields used for wireless energy transfer by the resonators and affect the performance of the system. Their location, size, orientation, and use should be designed so as to not excessively lower the perturbed Q of the resonators in the presence of these heatsinking materials. In addition, owing to the relatively poor thermal conductivity of magnetic materials such as ferrites, a relatively large contact area between the heatsink and the magnetic material may be required to provide adequate cooling which may require placement of substantial amount of lossy materials close to the magnetic resonator.

In embodiments, adequate cooling of the resonator may be achieved with minimal effect on the wireless energy transfer performance with strategic placement of thermally conductive materials. In embodiments, strips of thermally conductive material may be placed in between loops of conductor wire and in thermal contact with the block of magnetic material.

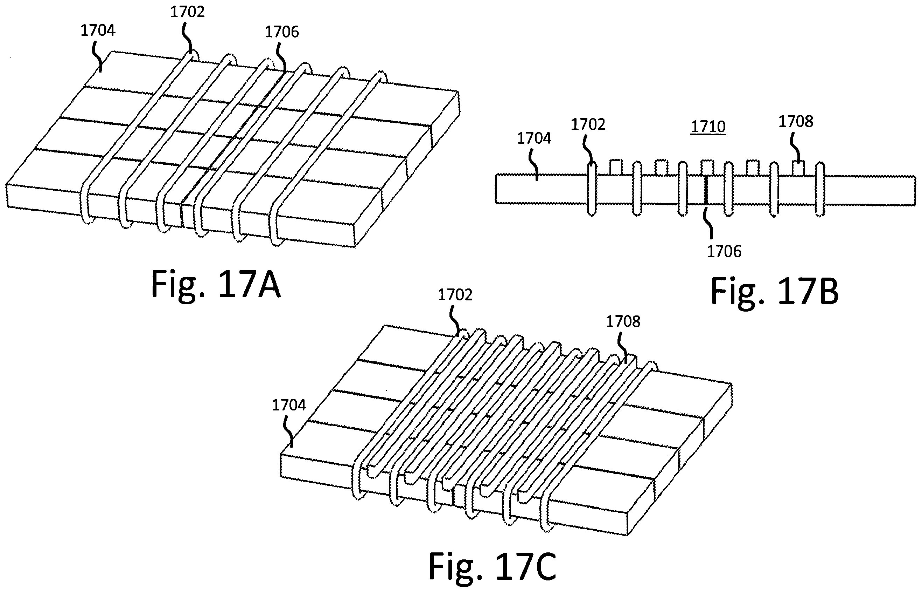

One exemplary embodiment of a resonator with strips of thermally conductive material is depicted in Fig. 17. Fig. 17A shows the resonator structure without the conducting strips and with the block of magnetic material comprising smaller tiles of magnetic material forming gaps or seams. Strips of thermally conductive **1708** material may be placed in between the loops of the conductor **1702** and in thermal contact with the block of magnetic material **1704** as depicted in Figs. 17B and 17C. To minimize the effects of the strips on the parameters of the resonator, in some embodiments it may be preferable to arrange the strips parallel to the loops of conductor or perpendicular to the dipole moment of the resonator. The strips of conductor may be placed to cover as much or as many of the seams or gaps between the tiles as possible especially the seams between tiles that are perpendicular to the dipole moment of the resonator.

In embodiments the thermally conductive material may comprise copper, aluminum, brass, thermal epoxy, paste, pads, and the like, and may be any material that has a thermal conductivity that is at least that of the magnetic material in the resonator (~5W/(K-m) for some commercial ferrite materials). In embodiments where the thermally conductive material is also electrically conducting, the material may require a layer or coating of an electrical insulator to prevent shorting and direct electrical contact with the magnetic material or the loops of conductor of the resonator.

In embodiments the strips of thermally conductive material may be used to conduct heat from the resonator structure to a structure or medium that can safely dissipate the thermal energy. In embodiments the thermally conductive strips may be connected to a heat sink such as a large plate located above the strips of conductor that can dissipate the thermal energy using passive or forced convection, radiation, or conduction to the environment. In embodiments the system may include any number of active cooling systems that may be external or internal to the resonator structure that can dissipate the thermal energy from the thermally conducting strips and may include liquid cooling systems, forced air systems, and the like. For example, the thermally conducting strips may be hollow or comprise channels for coolant that may be pumped or forced through to cool the magnetic material. In embodiments, a field deflector made of a good electrical conductor (such as copper, silver, aluminum, and the like) may double as part of the heatsinking apparatus. The addition of thermally and electrically conducting strips to the space between the magnetic material and the field deflector may have a marginal effect on the perturbed *Q,* as the electromagnetic fields in that space are typically suppressed by the presence of the field deflector. Such conducting strips may be thermally connected to both the magnetic material and the field deflector to make the temperature distribution among different strips more homogeneous.

In embodiments the thermally conducting strips are spaced to allow at least one loop of conductor to wrap around the magnetic material. In embodiments the strips of thermally conductive material may be positioned only at the gaps or seams of the magnetic material. In other embodiments, the strips may be positioned to contact the magnetic material at substantially throughout its complete length. In other embodiments, the strips may be distributed to match the flux density within the magnetic material. Areas of the magnetic material which under normal operation of the resonator may have higher magnetic flux densities may have a higher density of contact with the thermally conductive strips. In embodiments depicted in Fig 17A) for example, the highest magnetic flux density in the magnetic material may be observed toward the center of the block of magnetic material and the lower density may be toward the ends of the block in the direction of the dipole moment of the resonator.

To show how the use of thermally conducting strips helps to reduce the overall temperature in the magnetic material as well as the temperature at potential hot spots, the inventors have performed a finite element simulation of a resonator structure similar to that depicted in Fig. 17C. The structure was simulated operating at a frequency of 235 kHz and comprising a block of EPCOS N95 magnetic material measuring 30 cm x 30 cm x 5 mm excited by 10 turns of litz wire (symmetrically placed at 25 mm, 40 mm, 55 mm, 90 mm and 105 mm from the plane of symmetry of the structure) carrying 40 A of peak current each, and thermally connected to a 50 cm x 50 cm x 4 mm field deflector by means of three 3 x % x 1' hollow square tubes (1/8" wall thickness) of aluminum (alloy 6063) whose central axes are placed at -75mm, 0 mm, and +75 from the symmetry plane of the structure. The perturbed Q due to the field deflector and hollow tubes was found to be 1400 (compared to 1710 for the same structure without the hollow tubes). The power dissipated in the shield and tubes was calculated to be 35.6 W, while that dissipated in the magnetic material was 58.3 W. Assuming the structure is cooled by air convection and radiation and an ambient temperature of 24 °C, the maximum temperature in the structure was 85 °C (at points in the magnetic material approximately halfway between the hollow tubes) while the temperature in parts of the magnetic material in contact with the hollow tubes was approximately 68 °C. By comparison, the same resonator without the thermally conducting hollow tubes dissipated 62.0 W in the magnetic material for the same excitation current of 40 W peak and the maximum temperature in the magnetic material was found to be 111 °C.

The advantage of the conducting strips is more apparent still if we introduce a defect in a portion of the magnetic material that is in good thermal contact with the tubes. An air gap 10 cm long and 0.5 mm placed at the center of the magnetic material and oriented perpendicular to the dipole moment increases the power dissipated in the magnetic material to 69.9 W (the additional 11.6W relative to the previously discussed no-defect example being highly concentrated in the vicinity of the gap), but the conducting tube ensures that the maximum temperature in the magnetic material has only a relative modest increase of 11 °C to 96 °C. In contrast, the same defect without the conducting tubes leads to a maximum temperature of 161 °C near the defect. Cooling solutions other than convection and radiation, such as thermally connecting the conducting tubes body with large thermal mass or actively cooling them, may lead to even lower operational temperatures for this resonator at the same current level.

In embodiments thermally conductive strips of material may be positioned at areas that may have the highest probability of developing cracks that may cause irregular gaps in the magnetic material. Such areas may be areas of high stress or strain on the material, or areas with poor support or backing from the packaging of the resonator. Strategically positioned thermally conductive strips may ensure that as cracks or irregular gaps develop in the magnetic material, the temperature of the magnetic material will be maintained below its critical temperature. The critical temperature may be defined as the Curie temperature of the magnetic material, or any temperature at which the characteristics of the resonator have been degraded beyond the desired performance parameters.

In embodiments the heastsinking structure may provide mechanical support to the magnetic material. In embodiments the heatsinking structure may be designed to have a desired amount of mechanical give (e.g., by using epoxy, thermal pads, and the like having suitable mechanical properties to thermally connect different elements of the structure) so as to provide the resonator with a greater amount of tolerance to changes in the intrinsic dimensions of its elements (due to thermal expansion, magnetostriction, and the like) as well as external shocks and vibrations, and prevent the formation of cracks and other defects.

In embodiments where the resonator comprises orthogonal windings wrapped around the magnetic material, the strips of conducting material may be tailored to make thermal contact with the magnetic material within areas delimited by two orthogonal sets of adjacent loops. In embodiments a strip may contain appropriate indentations to fit around the conductor of at least one orthogonal winding while making thermal contact with the magnetic material at least one point. In embodiments the magnetic material may be in thermal contact with a number of thermally conducting blocks placed between adjacent loops. The thermally conducting blocks may be in turn thermally connected to one another by means of a good thermal conductor and/or heatsinked.

Throughout this description although the term thermally conductive strips of material was used as an exemplary specimen of a shape of a material it should be understood by those skilled in the art that any shapes and contours may be substituted without departing from the spirit of the inventions. Squared, ovals, strips, dots, elongated shapes, and the like would all be within the spirit of the present invention.

## Communication in a Wireless Energy Transfer System

A wireless energy transfer system may require a verification step to ensure that energy is being transferred between designated resonators. For example, in wireless energy transfer systems, source resonators, device resonators, and repeater resonators, do not require physical contact with each other in order to exchange energy, and these resonators may be separated from each other by distances of centimeters or meters, depending on the size and number of resonators in the system. In some configurations, multiple resonators may be in a position to generate or receive power, but only two or some of those resonators are designated resonators.

Communication of information between resonators in a wireless energy transfer system may be utilized to designate resonators. Communication of information between resonators may be implemented using in-band or out-of-band communications or communications channels. If at least some part of a magnetic resonator used to exchange power is also used to exchange information, and the carrier frequency of the information exchange is close to the resonant frequency used in the power exchange, we refer to that communication as in-band. Any other type of communication between magnetic resonators is referred to as out-of band. An out-of-band communication channel may use an antenna and a signaling protocol that is separated from the energy transfer resonator and magnetic fields. An out-of-band communication channel may use or be based on Bluetooth, WiFi, Zigbee, NFC technology and the like.

Communication between resonators may be used to coordinate the wireless energy transfer or to adjust the parameters of a wireless energy transfer system, to identify and authenticate available power sources and devices, to optimize efficiency, power delivery, and the like, to track and bill energy preferences, usage, and the like, and to monitor system performance, battery condition, vehicle health, extraneous objects, also referred to as foreign objects, and the like. Methods for designating and verifying resonators for energy transfer may be different when in-band and out-of-band communication channels are used because the distance over which communication signals may be exchanged using out-of-band techniques may greatly exceed the distance over which the power signals may be exchanged. Also, the bandwidth of out-of-band communication signals may be larger than in-band communication signals. This difference in communication range and capability may affect the coordination of the wireless energy transfer system. For example, the number of resonators that may be addressed using out-of-band communication may be very large and communicating resonators may be farther apart than the distance over which they may efficiently exchange energy.

In some embodiments all of the signaling and communication may be performed using an in-band communication channel and the signals may be modulated on the fields used for energy transfer. In other embodiments, in-band communication may use substantially the same frequency spectrum as is used for energy transfer, but communication may occur while useful amounts of energy are not being transmitted. Using only the in-band communication channel may be preferable if separate or multiple verification steps are problematic, because the range of the communication may be limited to the same range as the power exchange or because the information arrives as a modulation on the power signal itself. In some embodiments however, a separate out-of-band communication channel may be more desirable. For example, an out-of-band communication channel may be less expensive to implement and may support higher data rates. An out-of-band communication channel may support longer distance communication, allowing resonator discovery and power system mapping. An out-of-band communication channel may operate regardless of whether or not power transfer is taking place and may occur without disruption of the power transfer.

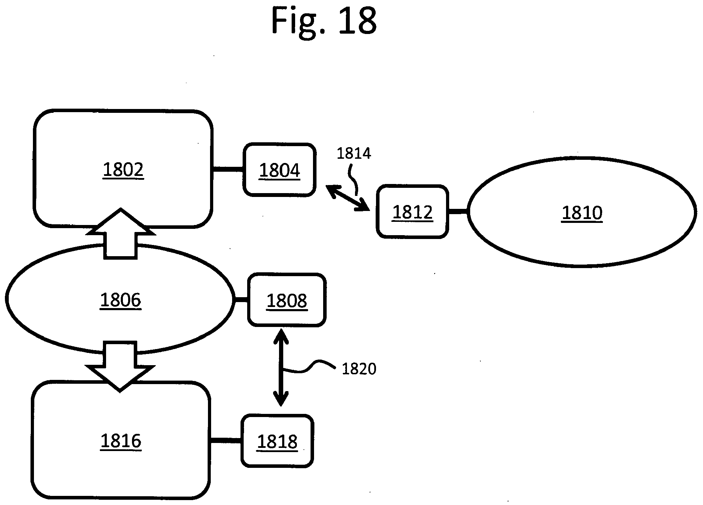

An exemplary embodiment of a wireless energy system is shown in Fig. 18. This exemplary embodiment comprises two device resonators **1802,1816** each with an out-of-band communication module **1804,1818** respectively and two source resonators **1806,1810** each with their own out-of-band communication modules **1808,1812** respectively. The system may use the out-of-band communication channel to adjust and coordinate the energy transfer. The communication channel may be used to discover or find resonators in the proximity, to initiate power transfer, and to communicate adjustment of operating parameters such as power output, impedance, frequency, and the like of the individual resonators.

In some situations a device resonator may incorrectly communicate with one source but receive energy from another source resonator. For example, imagine that device **1802** sends an out-of-band communication signal requesting power from a source. Source **1810** may respond and begin to supply power to device **1802**. Imagine that device **1816** also sends an out-of-band communication signal requesting power from a source and that source **1806** responds and begins to supply power to device **1816**. Because of the proximity of device **1802** to source **1806,** it is possible that device **1802** receives some or most of its power from source **1806**. If the power level received by device **1802** becomes too high, device **1802** may send an out-of-band communication signal to source **1810** to reduce the power it is transmitting to device **1802**. However, device **1802** may still be receiving too much power, because it is receiving power from source **1806** but is not communicating control signals to that source **1806.**

Therefore, the separation of the energy transfer channel and the communication channel may create performance, control, safety, security, reliability, and the like issues in wireless energy transfer systems. In embodiments, it may be necessary for resonators in a wireless energy transfer system to identify/designate and verify any and all resonators with which it is exchanging power. As those skilled in the art will recognize, the example shown in Fig. 18 is just one example and there exist many configurations and arrangements of wireless power transmission systems that may benefit from explicit or implicit energy transfer verification steps.

In embodiments, the potential performance, control, safety, security, reliability and the like, issues may be avoided by providing at least one verification step that insures that the energy transfer channel and the communication channel used by a pair of resonators are associated with the same pair of resonators.

In embodiments the verification step may comprise some additional information exchange or signaling through the wireless energy transfer channel. A verification step comprising communication or information exchange using the energy transfer channel, or fields of the energy transfer channel may be used to verify that the out-of-band communication channel is exchanging information between the same two resonators that are or will be exchanging energy.

In embodiments with an out-of-band communication channel the verification step may be implicit or explicit. In some embodiments verification may be implicit. In embodiments an energy transfer channel may be implicitly verified by monitoring and comparing the behavior of the energy transfer channel to expected behavior or parameters in response to the out-of-band information exchange. For example, after establishing out-of-band communications, a device may request that a wireless source increase the amount of power it is transmitting. At the same time, parameters of the wireless energy transfer channel and resonators may be monitored. An observed increase of delivered power at the device may be used to infer that the out-of-band communication channel and the energy transfer channel are correctly linked to the designated resonators.

In embodiments an implicit verification step may involve monitoring any number of the parameters of the wireless energy transfer or parameters of the resonators and components used in the wireless energy transfer. In embodiments the currents, voltages, impedances, frequency, efficiency, temperatures, of the resonators and their drive circuits and the like may be monitored and compared to expected values, trends, changes and the like as a result of an out-of-band communication exchange.

In embodiments a resonator may store tables of measured parameters and expected values, trends, and/or changes to these parameters as a consequence of a communication exchange. A resonator may store a history of communications and observed parameter changes that may be used to verify the energy transfer channel. In some cases a single unexpected parameter change due to a communication exchange may be not be conclusive enough to determine the out-of-band channel is incorrectly paired. In some embodiments the history of parameter changes may be scanned or monitored over several or many communication exchanges to perform verification.

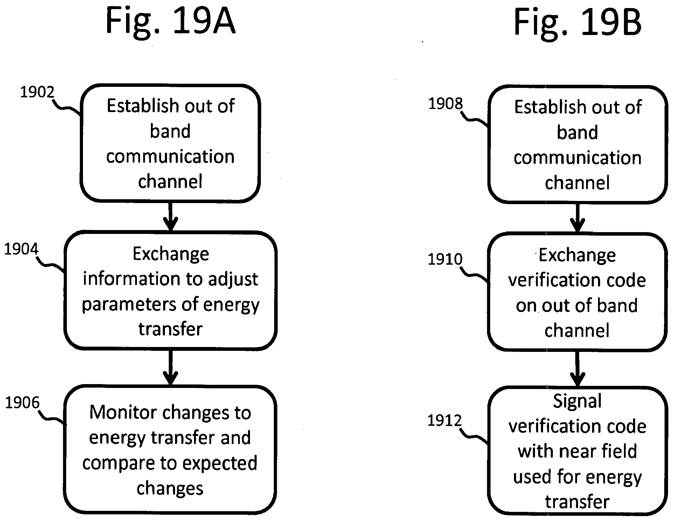

An example algorithm showing the series of steps which may be used to implicitly verify an energy transfer channel in a wireless energy transfer system using out-of-band communication is shown in Fig. 19A. In the first step **1902** an out-of-band communication channel between a source and a device is established. In the next step **1904** the source and device may exchange information regarding adjusting the parameters of the wireless energy transfer or parameters of the components used for wireless energy transfer. The information exchange on the out-of-band communication channel may be a normal exchange used in normal operation of the system to control and adjust the energy transfer. In some systems the out-of band communication channel may be encrypted preventing eavesdropping, impersonation, and the like. In the next step **1906** the source and the device or just a source or just a device may monitor and keep track of any changes to the parameters of the wireless energy transfer or any changes in parameters in the components used in the energy transfer. The tracked changes may be compared against expected changes to the parameters as a consequence of any out-of-band communication exchanges. Validation may be considered failed when one or many observed changes in parameters do not correspond to expected changes in parameters.

In some embodiments of wireless energy transfer systems verification may be explicit. In embodiments a source or a device may alter, dither, modulate, and the like the parameters of the wireless energy transfer or the parameters of the resonators used in the wireless energy transfer to communicate or provide a verifiable signal to a source or device through the energy transfer channel. The explicit verification may involve changing, altering, modulating, and the like some parameters of the wireless energy transfer or the parameters of the resonators and components used in the energy transfer for the explicit purpose of verification and may not be associated with optimizing, tuning, or adjusting the energy transfer.

The changing, altering, modulating, and the like some parameters of the wireless energy transfer or the parameters of the resonators and components used in the energy transfer for the purpose of signaling or communicating with another wireless energy resonator or component may also be referred to as in-band communication. In embodiments, the in-band communication channel may be implemented as part of the wireless energy transfer resonators and components. Information may be transmitted from one resonator to another by changing the parameters of the resonators. Parameters such as inductance, impedance, resistance, and the like may be dithered or changed by one resonator. These changes may affect the impedance, resistance, or inductance of other resonators around the signaling resonator. The changes may manifest themselves as corresponding dithers of voltage, current, and the like on the resonators which may be detected and decoded into messages. In embodiments, in-band communication may comprise altering, changing, modulating, and the like the power level, amplitude, phase, orientation, frequency, and the like of the magnetic fields used for energy transfer.

In one embodiment the explicit in-band verification may be performed after an out-of-band communication channel has been established. Using the out-of-band communication channel a source and a device may exchange information as to the power transfer capabilities and in-band signaling capabilities. Wireless energy transfer between a source and a device may then be initiated. The source or device may request or challenge the other source or device to signal using the in-band communication channel to verify the connection between the out-of-band and communication channel and the energy transfer channel. The channel is verified when the agreed signaling established in the out-of-band communication channel is observed at the in-band communication channel.

In embodiments verification may be performed only during specific or predetermined times of an energy exchange protocol such as during energy transfer startup. In other embodiments explicit verification steps may be performed periodically during the normal operation of the wireless energy transfer system. The verification steps may be triggered when the efficiency or characteristics of the wireless power transfer change which may signal that the physical orientations have changed. In embodiments the communication controller may maintain a history of the energy transfer characteristics and initiate a verification of the transfer that includes signaling using the resonators when a change in the characteristics is observed. A change in the energy transfer characteristics may be observed as a change in the efficiency of the energy transfer, the impedance, voltage, current, and the like of the resonators, or components of the resonators and power and control circuitry.

Those skilled in the art will appreciate a signaling and communication channel capable of transmitting messages may be secured with any number of encryption, authentication, and security algorithms. In embodiments the out-of-band communication may be encrypted and the secured communication channel may be used to transmit random sequences for verification using the in-band channel. In embodiments the in-band communication channel may be encrypted, randomized, or secured by any known security and cryptography protocols and algorithms. The security and cryptography algorithms may be used to authenticate and verify compatibility between resonators and may use a public key infrastructure (PKI) and secondary communication channels for authorization and authentication.

In embodiments of energy transfer systems between a source and a device a device may verify the energy transfer channel to ensure it is receiving energy from the desired or assumed source. A source may verify the energy transfer channel to ensure energy is being transferred to the desired or assumed source. In some embodiments the verification may be bidirectional and a source and device may both verify their energy transfer channels in one step or protocol operation. In embodiments, there may be more than two resonators and there may be repeater resonators. In embodiments of multiple resonators, communication and control may be centralized in one or a few resonators or communication and control may be distributed across many, most, or all the resonators in a network. In embodiments, communication and/or control may be effected by one or more semiconductor chips or microcontrollers that are coupled to other wireless energy transfer components.

An example algorithm showing the series of steps which may be used to explicitly verify an energy transfer channel in a wireless energy transfer system using out-of band communication is shown in Fig. 19B. In the first step **1908** an out-of-band communication channel between a source and a device is established. In the next step **1910** the source and device may coordinate or agree on a signaling protocol, method, scheme, and the like that may be transmitted through the wireless energy transfer channel. To prevent eavesdropping and provide security the out-of-band communication channel may be encrypted and the source and device may follow any number of known cryptographic authentication protocols. In a system enabled with cryptographic protocols the verification code may comprise a challenge-response type exchange which may provide an additional level of security and authentication capability. A device, for example, may challenge the source to encrypt a random verification code which it sends to the source via the out-of-band communication channel using a shared secret encryption key or a private key. The verification code transmitted in the out-of-band communication channel may then be signaled **1912** through the in-band communication channel. In the case where the source and device are enabled with cryptographic protocols the verification code signaled in the in-band communication channel may be encrypted or modified by the sender with a reversible cryptographic function allowing the receiver to further authenticate the sender and verify that the in-band communication channels are linked with the same source or device associated with the out-of-band communication channel.

In situations when the verification fails a wireless energy transfer system may try to repeat the validation procedure. In some embodiments the system may try to re-validate the wireless energy transfer channel by exchanging another verification sequence for resignaling using the in-band communication channel. In some embodiments the system may change or alter the sequence or type of information that is used to verify the in-band communication channel after attempts to verify the in-band communication channel have failed. The system may change the type of signaling, protocol, length, complexity and the like of the in-band communication verification code.

In some embodiments, upon failure of verification of the in-band communication channel and hence the energy transfer channel, the system may adjust the power level, the strength of modulation, frequency of modulation and the like of the signaling method in the in-band communication channel. For example, upon failure of verification of a source by a device, the system may attempt to perform the verification at a higher energy transfer level. The system may increase the power output of the source generating stronger magnetic fields. In another example, upon failure of verification of a source by a device, the source that communicated the verification code to the device by changing the impedance of its source resonator may increase or even double the amount of change in the impedance of the source resonator for the signaling.

In embodiments, upon failure of verification of the energy transfer channel, the system may try to probe, find, or discover other possible sources or devices using the out-of-band communication channel. In embodiments the out-of-band communication channel may be used to find other possible candidates for wireless energy transfer. In some embodiments the system may change or adjust the output power or the range of the out-of-band communication channel to help minimize false pairings.

The out-of-band communication channel may be power modulated to have several modes, long range mode to detect sources and a short range or low power mode to ensure the communication is with another device or source that is within a specified distance. In embodiments the out-of-band communication channel may be matched to the range of the wireless channel for each application. After failure of verification of the energy transfer channel the output power of the out-of-band communication channel may be slowly increased to find other possible sources or devices for wireless energy transfer. As discussed above, an out-of band communication channel may exhibit interferences and obstructions that may be different from the interferences and obstructions of the energy transfer channel and sources and devices that may require higher power levels for out-of-band communication may be in close enough proximity to allow wireless energy transfer.

In some embodiments the out-of-band communication channel may be directed, arranged, focused, and the like, using shielding or positioning to be only effective in a confined area (i.e., under a vehicle), to insure it is only capable of establishing communication with another source or device that is in close enough proximity, position, and orientation for energy transfer.

In embodiments the system may use one or more supplemental sources of information to establish an out-of-band communication channel or to verify an in-band energy transfer channel. For example, during initial establishment of an out-of-band communication channel the locations of the sources or devices may be compared to known or mapped locations or a database of locations of wireless sources or devices to determine the most probable pair for successful energy transfer. Out-of-band communication channel discovery may be supplemented with GPS data from one or more GPS receivers, data from positioning sensors, inertial guidance systems and the like.

It is to be understood that although example embodiments with verification were described in systems consisting of a source and device verification may be performed in systems with any number of sources, devices, or repeaters. A single source may provide verification to multiple devices. In some embodiments multiple sources may provide power to one or more devices concurrently each may be varied. In embodiments verification may be performed with a repeater. In some embodiments verification may be performed through a repeater. A device receiving power from a source via a repeater resonator may verify the source of power from the repeater. A device receiving power from a source via a repeater resonator may verify the source of energy through the repeater, i.e., the in-band communication may pass through the repeater to the source for verification. It should be clear to those skilled in the art that all of these and other configurations are within the scope of the invention.

## Low Resistance Electrical Conductors

As described above, resonator structures used for wireless energy transfer may include conducting wires that conduct high frequency oscillating currents. In some structures the effective resistance of the conductors may affect the quality factor of the resonator structure and a conductor with a lower loss or lower resistance may be preferable. The inventors have discovered new structures for reducing the effective resistance of conducting wires at high frequencies compared to solid wire conductors or even Litz wire conductors of the same equivalent wire gauge (diameter).

In embodiments, structures comprising concentric cylindrical conducting shells can be designed that have much lower electrical resistance for frequencies in the MHz range than similarly sized solid wire conductors or commercially available Litz wires. At such frequencies, wire resistances are dominated by skin-depth effects (also referred to as proximity effects), which prevent electrical current from being uniformly distributed over the wire cross-section. At lower frequencies, skin-depth effects may be mitigated by breaking the wire into a braid of many thin insulated wire strands (e.g. Litz wire), where the diameter of the insulated strands are related to the conductor skin depth at the operating frequency of interest. In the MHz frequency range, the skin depth for typical conductors such as copper are on the order of 10 $\mu$m, making traditional Litz wire implementations impractical.

The inventors have discovered that breaking the wire into multiple properly designed concentric insulated conducting shells can mitigate the skin depth effects for frequencies above 1 MHz. In embodiments, wires comprising fewer than 10 coaxial shells can lower AC resistance by more than a factor of 3 compared to solid wire. In embodiments, wires or conductors comprising thin concentric shells can be fabricated by a variety of processes such as electroplating, electrodeposition, vapor deposition, sputtering, and processes that have previously been applied to the fabrication of optical fibers.

In embodiments, conducting structures comprising nested cylindrical conductors may be analyzed using the quasistatic Maxwell equations. Of particular importance in the design of these conducting structures is taking account of the proximity losses induced by each conducting shell in the others via the magnetic fields. Modeling tools may be used to optimize the number of conducting shells, the size and shape of the conducting shells, the type and thickness of insulating materials for a given conductor diameter, operating frequency and environment, cost, and the like.

One embodiment of the new conductor structure comprises a number, N, of concentric conducting shells. Such a structure can be designed to have much lower AC resistance at frequencies in the 10 MHz range than similar gauge solid or stranded wires or commercially available Litz wires.

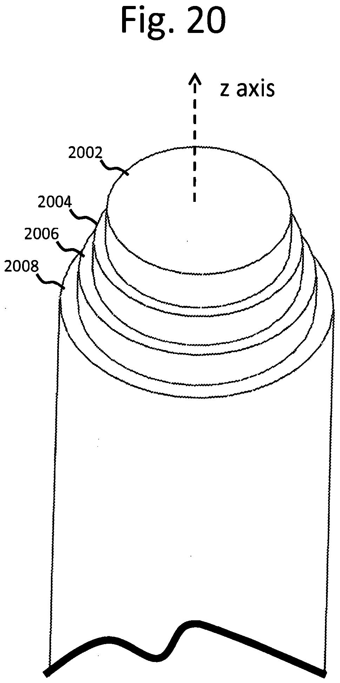

An embodiment of a wire or conductor comprising conducting shells may comprise at least two concentric conducting shells separated by an electrical insulator. An exemplary embodiment of an electrical conductor with four concentric shells is shown in Figure 20. Note that the conductor may have an unlimited length along the z axis. That is, the length along the z axis is the length of the wire or the conductor. Also, the wire or conductor may have any number of bends, curves, twists, and the like (not shown) as would other conductors of equivalent gauge or thickness. Also note that in embodiments where the cross-section of the shell is annular or substantially annular, the shell will consequently be cylindrical or substantially cylindrical. There is no limitation to the shape of the cross sections and thus the shape of the resulting three-dimensional structure. For example, the cross-sectional shape may be rectangular in embodiments.

An embodiment shown in Figure 20 comprises four concentric shells **2008, 2006, 2004, 2002** of an electrical conductor that extend through the complete length of the conducting wire along the z axis. The conductor shells may be referred to by their location with respect to the center or innermost conductor shell. For convention, the innermost shell may be referred to as the first shell, and each successive shell as the second shell, third shell, etc. The successive shells may also referred to as nested concentric shells. For example, in the embodiment shown in Fig. 20 conductor shell **2002** may be referred to as the first shell or the innermost shell and the conductor **2004** as the second shell, conductor **2006** as the third shell, and conductor **2008** as the fourth shell or the outermost shell. Each shell, except the innermost and the outermost shell, is in direct proximity to two neighboring shells, an inner neighbor and an outer neighbor shell. The innermost shell only has an outer neighbor, and the outermost shell only has an inner neighbor. For example, the third conductor **2006** has two shell neighbors, the inner neighbor being the second shell **2004** and the outer neighbor being the fourth shell **2008.** In embodiments, the inner shell may be a solid core(in embodiments, cylindrical with an inner diameter zero). Alternatively, it may have a finite inner diameter and surround a core made of insulating material and the like.

In embodiments each successive shell covers its inner neighbor shell long the z axis of the conductor. Each shell wraps around its inner neighbor shell except the faces of each shell that are exposed at the ends of the conductor. For example, in the embodiment shown in Fig. 20, shell **2002** is wrapped around by its outer neighbor shell **2004** and shell **2004** is wrapped by **2006** and etc.

In embodiments each successive shell may comprise one or more strips of conductor shaped so as to conform to the cylindrical geometry of the structure. In embodiments the strips in each shell may be mutually insulated and periodically connected to strips in adjacent shells so that the input impedances of the shells and/or strips naturally enforce the current distribution that minimizes the resistance of the structure. In embodiments the strips in each shell may be wound at a particular pitch. The pitch in different shells may be varied so as to assist in the impedance matching of the entire structure.

Fig. 20 shows an end section of the conductor with the conducting layers staggered to provide a clear illustration of the layers. The staggering of layers in the drawing should not be considered as a preferred termination of the conductor. The conductor comprising multiple shells may be terminated with all shells ending in the same plane or at different staggered planes as depicted in Fig. 20.

In embodiments, the innermost conductor shell **2002** may be solid as shown in Fig. 20. In embodiments the innermost conductor shell may be hollow defining a hole or cavity along its length along the z axis of the conductor.

In embodiments neighboring shells may be separated from each other by layers of an electrical insulator such that neighboring layers are not in electrical contact with one another. The thickness and material of the insulating layer may depend on the voltages, currents, and relative voltage potential between each neighboring shell. In general the insulator should be selected such that its breakdown voltage exceeds the voltage potential between neighboring conducting shells. In embodiments the outside of the outermost shell **2010** may be covered by additional electrical insulators or protective casing for electrical safety, durability, water resistance, and the like. In embodiments different shells and insulator layers may have different thicknesses depending on the application, frequency, power levels and the like.

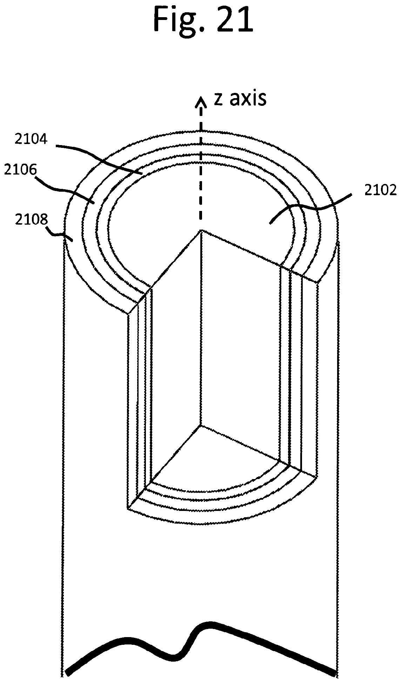

Another view of a cross section of an embodiment of the conductor comprising four shells is shown in Fig. 21. The figure shows a cross-section, normal to the z-axis, of the conductor comprising the conductor shells **2102, 2104, 2106, 2108.** Note that in this figure, and in Fig. 20, the insulating layers are not shown explicitly, but are understood to be located between the various shells. In embodiments, the thickness of the insulating layers may be extremely thin, especially in comparison to the thickness of the conducting shells.

The thickness, relative thickness, size, composition, shape, number, fraction of total current carried and the like, of concentric conducing shells may be selected or optimized for specific criteria such as the voltage and/or current levels carried by the wire, the operating frequency of the resonator, size, weight and flexibility requirements of the resonator, required Q-values, system efficiencies, costs and the like. The appropriate size, number, spacing, and the like of the conductors may be determined analytically, through simulation, by trial and error, and the like.

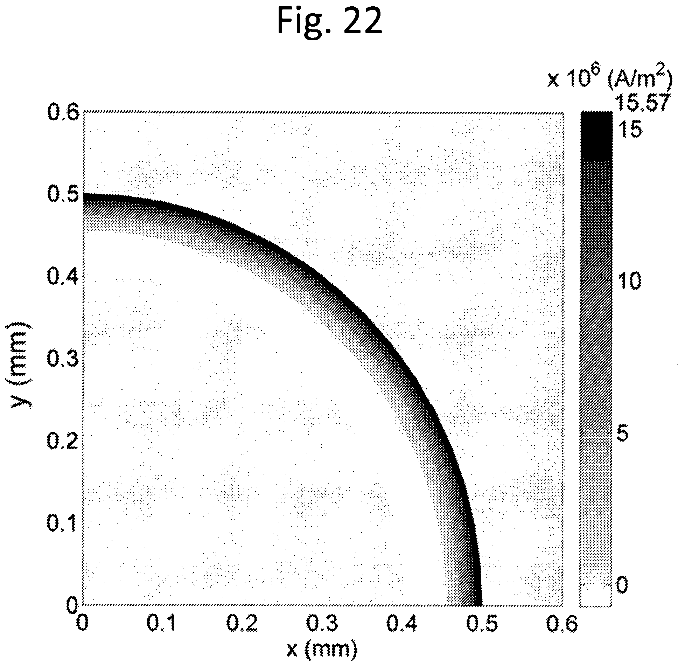

The benefits of the concentric shell design may be seen by comparing the current distributions in conductors of similar diameters but with different conductor arrangements. By way of example, calculations of the current distributions in two concentric shell conductor structures and one solid conductor are shown in Figs. 22-24. The figures show one quarter of the cross section of the conductor with the conductor being symmetric around x=0, y=0 coordinate. The figures show the current density at 10 MHz for a copper conductor with an outside diameter (OD) of 1 mm and carrying a peak current of 1 A. Note that the darker shadings indicate higher current densities, as shown in the legend on the right hand side of the figure.

Fig. 22 shows the current distribution for a wire comprising a single, 1 mm diameter, solid core of copper. Note that the current is concentrated on the outer perimeter of the solid conductor, limiting the area over which the current is distributed, and yielding an effective resistance of 265.9 m$\Omega$/m. This behavior is indicative of the known proximity effect.

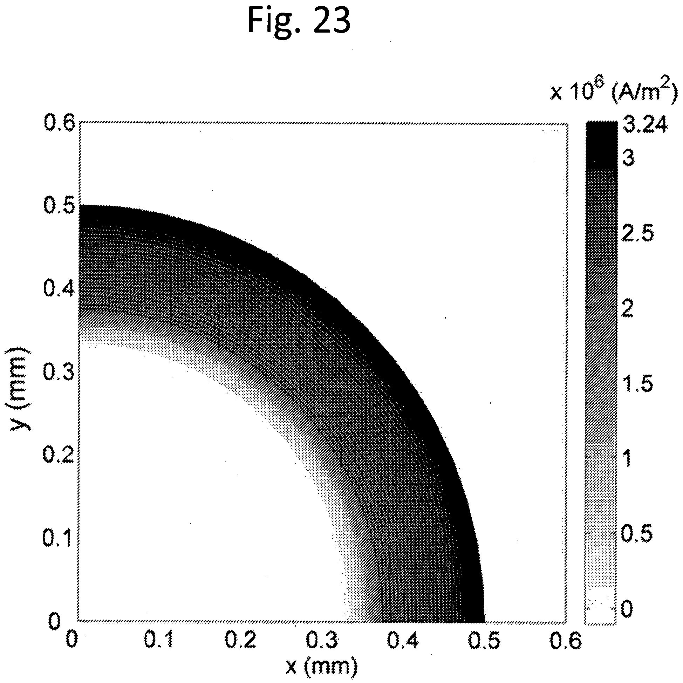

Fig. 23 shows the current distribution for an embodiment where the 1 mm diameter wire comprises 24 mutually insulated 5.19 $\mu$m concentric conductive shells, around a solid innermost copper shell, totaling 25 conductive shell elements. Note that the optimal current density (i.e., the current distribution among the shells that minimizes the AC resistance, which may be found for any given structure using mathematical techniques familiar to those skilled in the art) in this structure is more uniformly distributed, increasing the cross section over which the current flows, and reducing the effective resistance of the wire to 55.2 m$\Omega$/m. Note that this wire comprising concentric conducting shells has an AC resistance that is approximately five times lower than the similarly sized solid conducting wire.

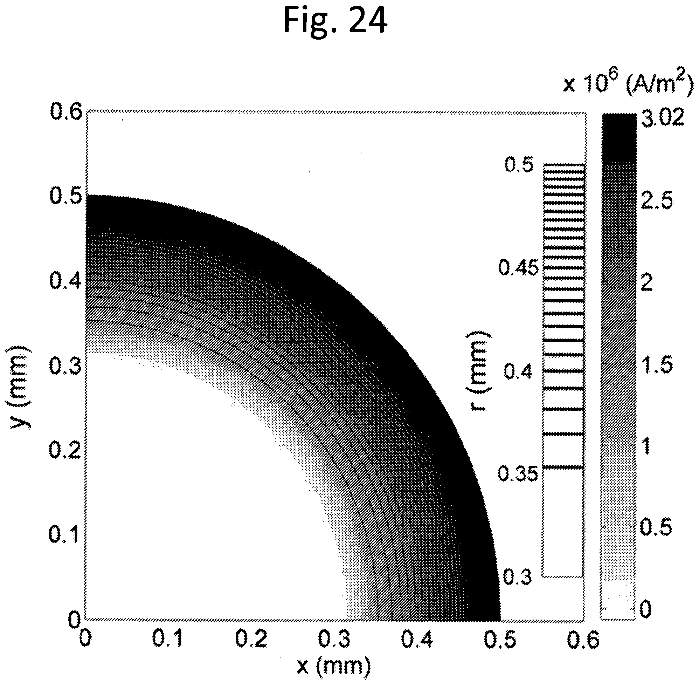

Fig. 24 shows the current distribution for an embodiment where the 1 mm diameter wire comprises 25 conductive shells (including an innermost solid core) whose thicknesses are varied from shell to shell so as to minimize the overall resistance. Each shell is of a different thickness with thinner and thinner shells towards the outside of the wire. In this embodiment, the thickness of the shells ranged from 16.3 $\mu$m to 3.6 $\mu$m (except for the solid innermost shell). The inset in Fig. 24 shows the radial locations of the interfaces between the shells. The effective resistance of the wire comprising the varying thickness shells as shown in Fig. 24 is 51.6 m$\Omega$/m. Note that the resistance of the conducting structures shown in Figs. 22-24 was calculated analytically using methods described in A. Kurs, M. Kesler, and S.G. Johnson, Optimized design of a low-resistance electrical conductor for the multimegahertz range, Appl. Phys. Lett. 98, 172504 (2011), as well as United States Provisional Application Serial No. 61/411,490, filed November 9, 2010 the contents of each which are incorporated herein by reference in their entirety as if fully set forth herein. For simplicity, the insulating gap between the shells was taken to be negligibly small for each structure.

Note that while the embodiments modeled in Figs. 23-24 comprised solid innermost conductor shells, most of the current flowing in that shell is confined to the outer layer of this innermost shell. In other embodiments, this solid innermost shell may be replaced by a hollow or insulator filled shell, a few skin-depths thick, without significantly increasing the AC resistance of the structure.

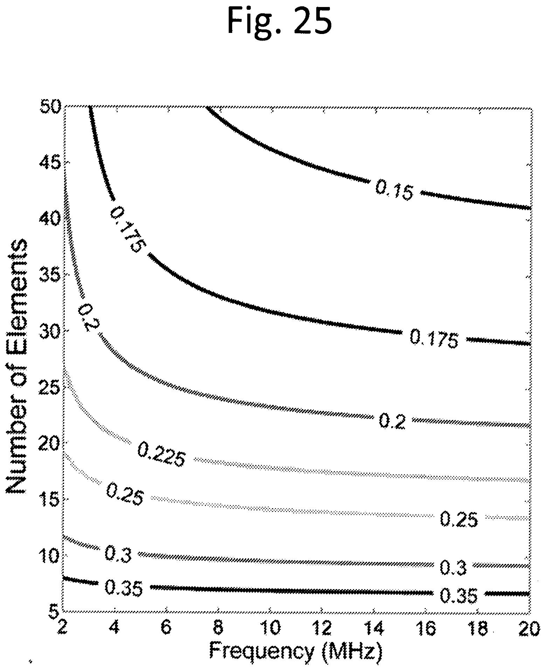

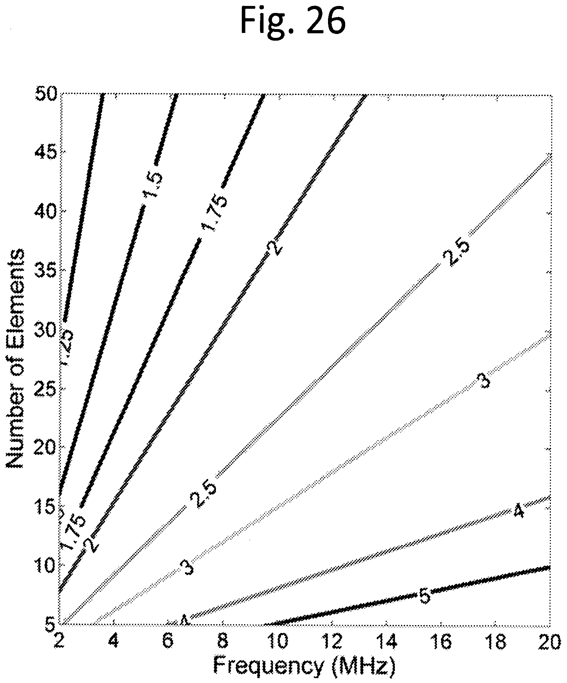

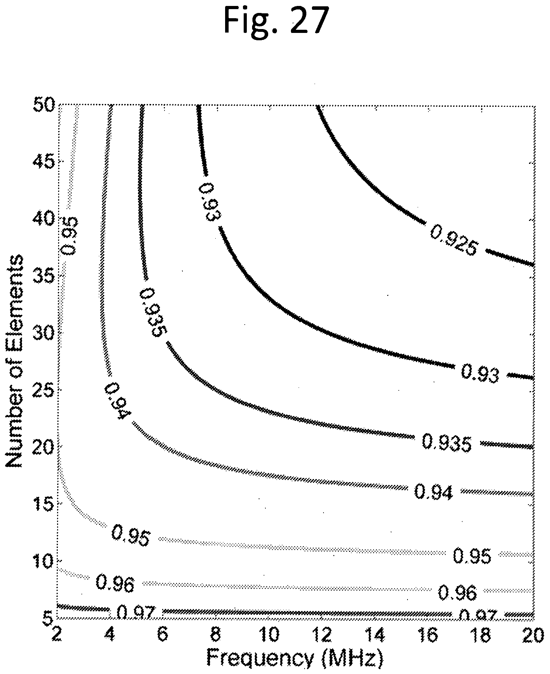

Figs. 25-27 show plots that compare the ratio of the lowest AC resistance (as a function of the number of shells, N, and the operating frequency, $f$) achievable for a 1 mm OD wire comprising concentric conducting shells and a 1 mm OD solid core wire, of the same conducting material.

Fig. 25 shows that an optimized cylindrical shell conductor can significantly outperform a solid conductor of the same OD. One can also see from Fig. 25 that much of the relative improvement of an optimized concentric shell conductor over a solid conductor occurs for structures with only a small number of elements or shells. For example, a wire comprising 10 concentric conducting shells has an AC resistance that is three times lower than a similarly sized solid wire over the entire 2-20 MHz range. Equivalently, since the resistance of a solid conductor in the regime $\kappa D \gg 1$ ($\kappa$ being the inverse of the skin depth $\delta$ and $D$ the diameter of the conductor) scales as $1/D$, the conductor comprising ten shells would have the same resistance per unit length as a solid conductor with a diameter that is 3.33 times greater (and roughly 10 times the cross area) than the wire comprising shells.

Increasing the number of shells to 20 and 30 further reduces the AC resistance to four times lower, and five times lower than the AC resistance for a similarly sized solid wire.

It should be noted that with the presented structures comprising multiple conductor shells it may be necessary to impedance match each shell to ensure an optimal current distribution. However due to the relatively small number of shell conductors for most applications (<40) a brute force approach of individually matching the impedance of each shell (e.g., with a lumped-element matching network) to achieve the optimal current distribution could be implemented (similar impedance matching considerations arise in multi-layer high-$T_c$ superconducting power cables (see H. Noji, Supercond. Sci. Technol. 10, 552 (1997). and S. Mukoyama, K. Miyoshi, H. Tsubouti, T. Yoshida, M. Mimura, N. Uno, M. Ikeda, H. Ishii, S. Honjo, and Y. Iwata, IEEE Trans. Appl. Supercond. 9, 1269 (1999). the contents of which are incorporated in their entirety as if fully set forth herein ), albeit at much lower frequencies).

In embodiments, concentric conducting shells of a wire may preferably be cylindrical or have circular cross-sections, however other shapes are contemplated and may provide for substantial improvement over solid conductors. Concentric conducting shells having an elliptical, rectangular, triangular, or other irregular shapes are within the scope of this invention. The practicality and usefulness of each cross-section shape may depend on the application, manufacturing costs, and the like.

In this section of the disclosure we may have referred to the structures comprising multiple shells of conductors as a wire. It is to be understood that the term wire should not be limited to mean any specific or final form factor of the structures. In embodiments the structures may comprise free standing conductors that may be used to replace traditional wires. In embodiments the structures comprising multiple shells may be fabricated or etched onto a multilayer printed circuit board or substrate. The structures may be etched, deposited on wafers, boards, and the like. In embodiments thin concentric shells can be fabricated by a variety of processes (such as electroplating, electro-deposition, vapor deposition, or processes utilized in optical fiber fabrication).

The conductor structures may be utilized in many resonator or coil structures used for wireless energy transfer. The multi-shell structures may be used as part of a resonator such as those shown in Fig. 2A-2E. The low loss conductors may be wrapped around a core of magnetic material to form low loss planar resonators. The low loss conductors may be etched or printed on a printed circuit board to form a printed coil and the like.

**Wireless Energy Distribution System**

Wireless energy may be distributed over an area using repeater resonators. In embodiments a whole area such as a floor, ceiling, wall, table top, surface, shelf, body, area, and the like may be wirelessly energized by positioning or tiling a series of repeater resonators and source resonators over the area. In some embodiments, a group of objects comprising resonators may share power amongst themselves, and power may be wireless transmitted to and/or through various objects in the group. In an exemplary embodiment, a number of vehicles may be parked in an area and only some of the vehicles may be positioned to receive wireless power directly from a source resonator. In such embodiments, certain vehicles may retransmit and/or repeat some of the wireless power to vehicles that are not parked in positions to receive wireless power directly from a source. In embodiments, power supplied by a vehicle charging source may use repeaters to transmit power into the vehicles to power devices such as cell phones, computers, displays, navigation devices, communication devices, and the like. In some embodiments, a vehicle parked over a wireless power source may vary the ratio of the amount of power it receives and the amount of power it retransmits or repeats to other nearby vehicles. In embodiments, wireless power may be transmitted from one source to device after device and so on, in a daisy chained fashion. In embodiments, certain devices may be able to self determine how much power that receive and how much they pass on. In embodiments, power distribution amongst various devices and/or repeaters may be controlled by a master node or a centralized controller.

Some repeater resonators may be positioned in proximity to one or more source resonators. The energy from the source may be transferred from the sources to the repeaters, and from those repeaters to other repeaters, and to other repeaters, and so on. Therefore energy may be wirelessly delivered to a relatively large area with the use of small sized sources being the only components that require physical or wired access to an external energy source.

In embodiments the energy distribution over an area using a plurality of repeater resonators and at least one source has many potential advantages including in ease of installation, configurability, control, efficiency, adaptability, cost, and the like. For example, using a plurality of repeater resonators allows easier installation since an area may be covered by the repeater resonators in small increments, without requiring connections or wiring between the repeaters or the source and repeaters. Likewise, a plurality of smaller repeater coils allows a greater flexibility of placement allowing the arrangement and coverage of an area with an irregular shape. Furthermore, the repeater resonators may be easily moved or repositioned to change the magnetic field distribution within an area. In some embodiments the repeaters and the sources may be tunable or adjustable allowing the repeater resonators to be tuned or detuned from the source resonators and allowing a dynamic reconfiguration of energy transfer or magnetic field distribution within the area covered by the repeaters without physically moving components of the system.

For example, in one embodiment, repeater resonators and wireless energy sources may be incorporated or integrated into flooring. In embodiments, resonator may be integrated into flooring or flooring products such as carpet tiles to provide wireless power to an area, room, specific location, multiple locations and the like. Repeater resonators, source resonators, or device resonators may be integrated into the flooring and distribute wireless power from one or more sources to one more devices on the floor via a series of repeater resonators that transfer the energy from the source over an area of the floor.

It is to be understood that the techniques, system design, and methods may be applied to many flooring types, shapes, and materials including carpet, ceramic tiles, wood boards, wood panels and the like. For each type of material those skilled in the art will recognize that different techniques may be used to integrate or attach the resonators to the flooring material. For example, for carpet tiles the resonators may be sown in or glued on the underside while for ceramic tiles integration of tiles may require a slurry type material, epoxy, plaster, and the like. In some embodiments the resonators may not be integrated into the flooring material but placed under the flooring or on the flooring. The resonators may, for example, come prepackaged in padding material that is placed under the flooring. In some embodiments a series or an array or pattern of resonators, which may include source, device, and repeater resonators, may be integrated in to a large piece of material or flooring which may be cut or trimmed to size. The larger material may be trimmed in between the individual resonators without disrupting or damaging the operation of the cut piece.

Returning now to the example of the wireless floor embodiment comprising individual carpet tiles, the individual flooring tiles may be wireless power enabled by integrating or inserting a magnetic resonator to the tile or under the tile. In embodiments resonator may comprise a loop or loops of a good conductor such as Litz wire and coupled to a capacitive element providing a specific resonant frequency which may be in the range of 10 KHz to 100MHz. In embodiments the resonator may be a high-Q resonator with a quality factor greater than 100. Those skilled in the art will appreciate that the various designs, shaped, and methods for resonators such as planar resonators, capacitively loaded loop resonators, printed conductor loops, and the like described herein may be integrated or combined within a flooring tile or other flooring material.

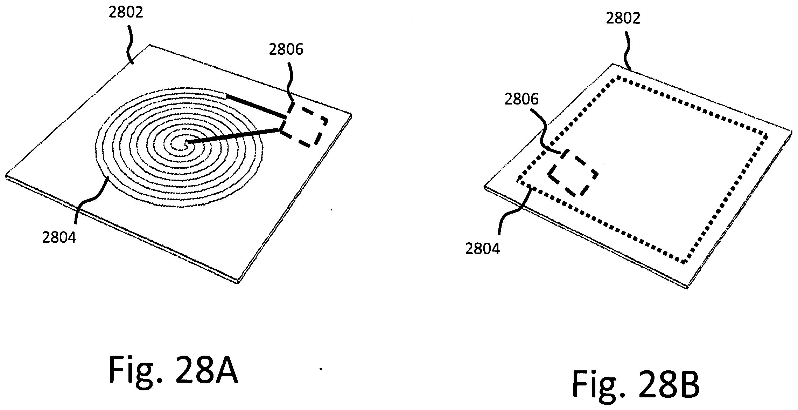

Example embodiments of a wireless power enabled floor tile are depicted in Fig. 28A and Fig. 28B. A floor tile **2802** may include loops of an electrical conductor **2804** that are wound within the perimeter of the tile. In embodiments the conductor **2804** of the resonator may be coupled to additional electric or electronic components **2806** such as capacitors, power and control circuitry, communication circuitry, and the like. In other embodiments the tile may include more than one resonator and more than one loop of conductors that may be arranged in an array or a deliberate pattern as described herein such as for example a series of multisized coils, a configurable size coil and the like.

In embodiments the coils and resonators integrated into the tiles may include magnetic material. Magnetic material may be used to construct planar resonator structures such those depicted in Fig. 2C or Fig. 2E. In embodiments the magnetic material may also be used for shielding of the coil of the resonator from lossy objects that may be under or around the flooring. In some embodiments the structures may further include a layer or sheet of a good electrical conductor under the magnetic material to increase the shielding capability of the magnetic material as described herein.

Tiles with a resonator may have various functionalities and capabilities depending on the control circuitry, communication circuitry, sensing circuitry, and the like that is coupled to the coil or resonator structure. In embodiments of a wireless power enabled flooring the system may include multiple types of wireless enabled tiles with different capabilities. One type of floor tile may comprise only a magnetic resonator and function as a fixed tuned repeater resonator that wirelessly transfers power from one resonator to another resonator without any direct or wired power source or wired power drain.

Another type of floor tile may comprise a resonator coupled to control electronics that may dynamically change or adjust the resonant frequency of the resonator by, for example, adjusting the capacitance, inductance, and the like of the resonator. The tile may further include an in-band or out-of-band communication capability such that it can exchange information with other communication enabled tiles. The tile may be then able to adjust its operating parameters such as resonant frequency in response to the received signals from the communication channel.

Another type of floor tile may comprise a resonator coupled to integrated sensors that may include temperature sensors, pressure sensors, inductive sensors, magnetic sensors, and the like. Some or all the power captured by the resonator may be used to wirelessly power the sensors and the resonator may function as a device or partially as a repeater.

Yet another type of wireless power enabled floor tile may comprise a resonator with power and control circuitry that may include an amplifier and a wired power connection for driving the resonator and function like a wireless power source. The features, functions, capabilities of each of the tiles may be chosen to satisfy specific design constraints and may feature any number of different combinations of resonators, power and control circuitry, amplifiers, sensors, communication capabilities and the like.

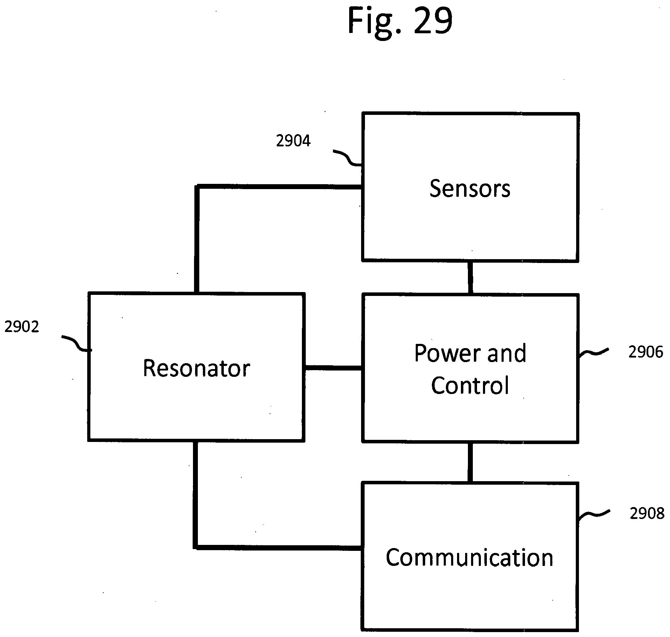

A block diagram of the components comprising a resonator tile are shown in Fig. 29. In a tile, a resonator **2902** may be optionally coupled to power and control circuitry **2906** to receive power and power devices or optional sensors **2904**. Additional optional communication circuitry **2908** may be connected to the power and control circuitry and control the parameters of the resonator based on received signals.

Tiles and resonators with different features and capabilities may be used to construct a wireless energy transfer systems with various features and capabilities. One embodiment of a system may include sources and only fixed tuned repeater resonator tiles. Another system may comprise a mixture of fixed and tunable resonator tiles with communication capability. To illustrate some of the differences in system capabilities that may be achieved with different types of floor tiles we will describe example embodiments of a wireless floor system.

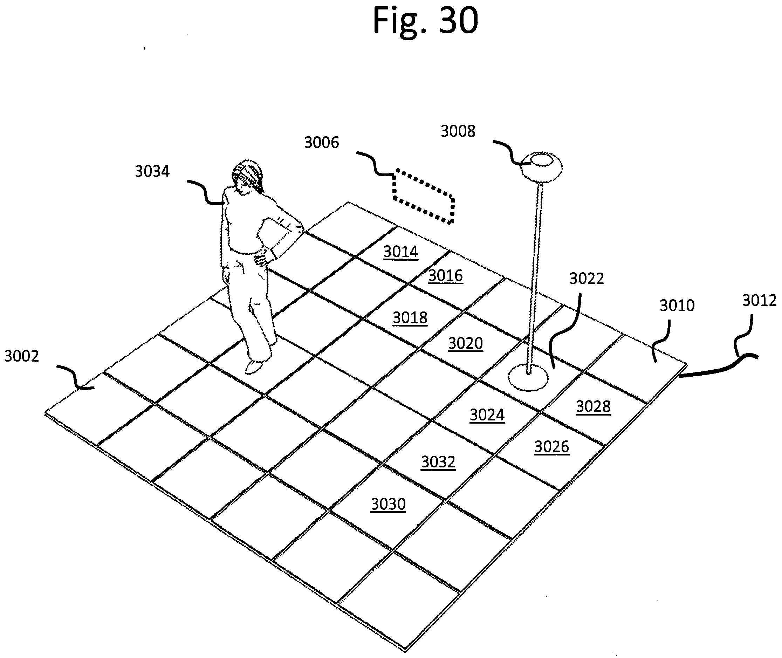

The first example embodiment of the wireless floor system may include a source and only fixed tuned repeater resonator tiles. In this first embodiment a plurality of fixed tuned resonator tiles may be arranged on a floor to transfer power from a source to an area or location over or next to the tiles and deliver wireless power to devices that may be placed on top of the tiles, below the tiles, or next to the tiles. The repeater resonators may be fixed tuned to a fixed frequency that may be close to the frequency of the source. An arrangement of the first example embodiment is shown in Fig. 30. The tiles **3002** are arranged in an array with at least one source resonator that may be integrated into a tile **3010** or attached to a wall **3006** and wired **3012** to a power source. Some repeater tiles may be positioned next to the source resonator and arranged to transfer the power from the source to a desired location via one or more additional repeater resonators.

Energy may be transferred to other tiles and resonators that are further away from the source resonators using tiles with repeater resonators which may be used to deliver power to devices, integrated or connected to its own device resonator and device power and control electronics that are placed on top or near the tiles. For example, power from the source resonator **3006** may be transferred wirelessly from the source **3006** to an interior area or interior tile **3022** via multiple repeater resonators **3014, 3016, 3018, 3020** that are between the interior tile **3022** and the source **3006**. The interior tile 3022 may than transfer the power to a device such as a resonator built into the base of a lamp **3008**. Tiles with repeater resonators may be positioned to extend the wireless energy transfer to a whole area of the floor allowing a device on top of the floor to be freely moved within the area. For example additional repeater resonator tiles **3024, 3026, 3028** may be positioned around the lamp **3008** to create a defined area of power (tiles **3014,3016,3018,3020,3022,3024,3026,3028**) over which the lamp may be placed to receive energy from the source via the repeater tiles. The defined area over which power is distributed may be changed by adding more repeater tiles in proximity to at least one other repeater or source tile. The tiles may be movable and configurable by the user to change the power distribution as needed or as the room configuration changes. Except a few tiles with source resonators which may need wired source or energy, each tile may be completely wireless and may be configured or moved by the user or consumer to adjust the wireless power flooring system.

A second embodiment of the wireless floor system may include a source and one or more tunable repeater resonator tiles. In embodiments the resonators in each or some of the tiles may include control circuitry allowing dynamic or periodic adjustment of the operating parameters of the resonator. In embodiments the control circuitry may change the resonant frequency of the resonator by adjusting a variable capacitor or a changing a bank of capacitors.

To obtain maximum efficiency of power transfer or to obtain a specific distribution of power transfer in the system of multiple wireless power enabled tiles it may be necessary to adjust the operating point of each resonator and each resonator may be tuned to a different operating point. For example, in some situations or applications the required power distribution in an array of tiles may be required to be non-uniform, with higher power required on one end of the array and lower power on the opposite end of the array. Such a distribution may be obtained, for example, by slightly detuning the frequency of the resonators from the resonant frequency of the system to distribute the wireless energy where it is needed.

For example, consider the array of tiles depicted in Fig.30 comprising 36 tunable repeater resonator tiles with a single source resonator **3006**. If only one device that requires power is placed on the floor, such as the lamp **3008**, it may be inefficient to distribute the energy across every tile when the energy is needed in only one section of the floor tile array. In embodiments the tuning of individual tiles may be used to change the energy transfer distribution in the array. In the example of the single lamp device **3008**, the repeater tiles that are not in direct path from the source resonator **3006** to the tile closes to the device **3022** may be completely or partially detuned from the frequency of the source. Detuning of the unused repeaters reduces the interaction of the resonators with the oscillating magnetic fields changing the distribution of the magnetic fields in the floor area. With tunable repeater tiles, a second device may be placed within the array of tiles or the lamp device **3008** is moved from its current location **3022** to another tile, say **3030,** the magnetic field distribution in the area of the tiles may be changed by retuning tiles that are in the path from the source **3006** to the new location **3030.**

In embodiments, to help coordinate the distribution of power and tuning of the resonators the resonator may include a communication capability. Each resonator may be capable of wirelessly communicating with one or more of its neighboring tiles or any one of the tiles to establish an appropriate magnetic field distribution for a specific device arrangement.

In embodiments the tuning or adjustment of the operating point of the individual resonators to generate a desired magnetic field distribution over the area covered by the tiles may be performed in a centralized manner from one source or one "command tile". In such a configuration the central tile may gather the power requirements and the state of each resonator and each tile via wireless communication or in band communication of each tile and calculate the most appropriate operating point of each resonator for the desired power distribution or operating point of the system. The information may be communicated to each individual tile wirelessly by an additional wireless communication channel or by modulating the magnetic field used for power transfer. The power may be distributed or metered out using protocols similar to those used in communication systems. For example, there may be devices that get guaranteed power, while others get best effort power. Power may be distributed according to a greedy algorithm, or using a token system. Many protocols that have been adapted for sharing information network resources may be adapted for sharing wireless power resources.

In other embodiments the tuning or adjustment of the operating point of the individual resonators may be performed in a decentralized manner. Each tile may adjust the operating point of its resonator on its own based on the power requirements or state of the resonators of tiles in its near proximity.

In both centralized and decentralized arrangements any number of network based centralized and distributed routing protocols may be used. For example, each tile may be considered as a node in network and shortest path, quickest path, redundant path, and the like, algorithms may be used to determine the most appropriate tuning of resonators to achieve power delivery to one or more devices.

In embodiments various centralized and decentralized routing algorithms may be used to tune and detune resonators of a system to route power via repeater resonators around lossy objects. If an object comprising lossy material is placed on some of the tiles it may the tiles, it may unnecessarily draw power from the tiles or may disrupt energy transmission if the tiles are in the path between a source and the destination tile. In embodiments the repeater tiles may be selectively tuned to bypass lossy objects that may be on the tiles. Routing protocols may be used to tune the repeater resonators such that power is routed around lossy objects.

In embodiments the tiles may include sensors. The tiles may include sensors that may be power wirelessly from the magnetic energy captured by the resonator built into the tile to detect objects, energy capture devices, people **3034,** and the like on the tiles. The tiles may include capacitive, inductive, temperature, strain, weight sensors, and the like. The information from the sensors may be used to calculate or determine the best or satisfactory magnetic field distribution to deliver power to devices and maybe used to detune appropriate resonators. In embodiments the tiles may comprise sensors to detect metal objects. In embodiments the presence of a lossy object may be detected by monitoring the parameters of the resonator. Lossy objects may affect the parameters of the resonator such as resonant frequency, inductance, and the like and may be used to detect the metal object.

In embodiments the wireless powered flooring system may have more than one source and source resonators that are part of the tiles, that are located on the wall or in furniture that couple to the resonators in the flooring. In embodiments with multiple sources and source resonators the location of the sources may be used to adjust or change the power distribution within in the flooring. For example, one side of a room may have devices which require more power and may require more sources closer to the devices. In embodiments the power distribution in the floor comprising multiple tiles may be adjusted by adjusting the output power (the magnitude of the magnetic field) of each source, the phase of each source (the relative phase of the oscillating magnetic field) of each source, and the like.

In embodiments the resonator tiles may be configured to transfer energy from more than one source via the repeater resonators to a device. Resonators may be tuned or detuned to route the energy from more than one source resonator to more than one device or tile.

In embodiments with multiple sources it may be desirable to ensure that the different sources and maybe different amplifiers driving the different sources are synchronized in frequency and/or phase. Sources that are operating at slightly different frequencies and/or phase may generate magnetic fields with dynamically changing amplitudes and spatial distributions (due to beating effects between the oscillating sources). In embodiments, Multiple source resonators may be synchronized with a wired or wireless synchronization signal that may be generated by a source or external control unit. In some embodiments one source resonator may be designed as a master source resonator that dictates the frequency and phase to other resonators. A master resonator may operate at its nominal frequency while other source resonators detect the frequency and phase of the magnetic fields generated by the master source and synchronize their signals with that of the master.

In embodiments the wireless power from the floor tiles may be transferred to table surfaces, shelves, furniture and the like by integrating additional repeater resonators into the furniture and tables that may extend the range of the wireless energy transfer in the vertical direction from the floor. For example, in some embodiments of a wireless power enabled floor, the power delivered by the tiles may not be enough to directly charge a phone or an electronic device that may be placed on top of a table surface that may be two or three feet above the wireless power enabled tiles. The coupling between the small resonator of the electronic device on the surface of the table and the resonator of the tile may be improved by placing a large repeater resonator near the surface of the table such as on the underside of the table. The relatively large repeater resonator of the table may have good coupling with the resonator of the tiles and, due to close proximity, good coupling between the resonator of the electronic device on the surface of the table resulting in improved coupling and improved wireless power transfer between the resonator of the tile and the resonator of the device on the table.

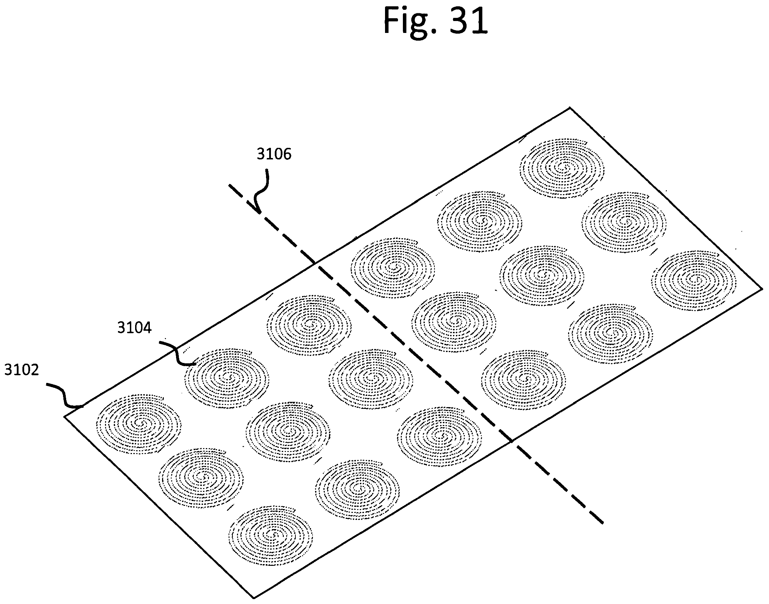

As those skilled in the art will recognize the features and capabilities of the different embodiments described may be rearranged or combined into other configurations. A system may include any number of resonator types, source, devices, and may be deployed on floors, ceilings, walls, desks, and the like. The system described in terms of floor tiles may be deployed onto, for example, a wall and distribute wireless power on a wall or ceiling into which enabled devices may be attached or positioned to receive power and enable various applications and configurations. The system techniques may be applied to multiple resonators distributed across table tops, surfaces, shelves, bodies, vehicles, machines, clothing, furniture, and the like. Although the example embodiments described tiles or separate repeater resonators that may be arranged into different configurations based on the teachings of this disclosure it should be clear to those skilled In the art that multiple repeater or source resonator may not be attached or positioned on separate physical tiles or sheets. Multiple repeater resonators, sources, devices, and their associated power and control circultry may be attached, printed, etched, to one tile, sheet, substrate, and the like. For example, as depicted in Fig. 31, an array of repeater resonators 3104 may be printed, attached, or embedded onto one single sheet 3102. The single sheet 3102 may be deployed similarly as the tiles described above. The sheet of resonators may be placed near, on, or below a source resonator to distribute the wireless energy through the sheet or parts of the sheet. The sheet of resonators may be used as a configurable sized repeater resonator in that the sheet may be cut or trimmed between the different resonators such as for example along line 3106 shown in Fig. 31.

In embodiments a sheet of repeater resonators may be used in a desktop environment. Sheet of repeater resonators may be cut to size to fit the top of a desk or part of the desk, to fit inside drawers, and the like. A source resonator may be positioned next to or on top of the sheet of repeater resonators and devices such as computers, computer peripherals, portable electronics, phones, and the like may be charged or powered via the repeaters.

In embodiments resonators embedded in floor tiles or carpets can be used to capture energy for radiant floor heating. The resonators of each tile may be directly connected to a highly resistive heating element via unrectified AC, and with a local thermal sensor to maintain certain floor temperature. Each tile may be able to dissipate a few watts of power in the thermal element to heat a room or to maintain the tiles at a specific temperature.

**Claims**

1. A system for wireless energy distribution over a defined area, the system comprising:

   a source resonator (3006) coupled to an energy source and generating an oscillating magnetic field with a driving frequency;
   a repeater resonator (2902, 3014, 3016, 3018, 3020) positioned in the defined area and in proximity to the source resonator, and the repeater resonator (2902, 3014, 3016, 3018, 3020) having a resonant frequency; and
   at least two other repeater resonators (2902, 3014, 3016, 3018, 3020) positioned in the defined area, each of the at least two other repeater resonators (2902, 3014, 3016, 3018, 3020) positioned in proximity to at least one other repeater resonator, and each of the at least two other repeater resonators (2902, 3014, 3016, 3018, 3020) having a resonant frequency;

   wherein the source resonator (3006) is configured to wirelessly transfer power through the repeater resonators (2902, 3014, 3016, 3018, 3020) in the defined area;
   wherein the system is configured to detune the resonant frequency of at least one of the repeater resonators (2902, 3014, 3016, 3018, 3020) from the driving frequency of the source resonator (3006) to adjust a power distribution in the area; and

wherein the detuning the at least one of the repeater resonators (2902, 3014, 3016, 3018, 3020) is performed according to a routing algorithm.

2. The system of claim 1 further comprising at least one additional source resonator that generates an oscillating magnetic field with the driving frequency.

3. The system of claim 2, wherein a relative phase of the oscillating fields generated by different source resonators of the system is adjustable.

4. The system of claim 1, wherein at least one of the repeater resonators (2902, 3014, 3016, 3018, 3020) comprises a capacitively loaded conducting loop.

5. The system of claim 1, wherein at least one of the repeater resonators (2902, 3014, 3016, 3018, 3020) comprises control circuitry and a variable capacitor, and the control circuitry is configured to adjust the variable capacitor to change the resonant frequency of the at least one of the repeater resonators (2902, 3014, 3016, 3018, 3020).

6. The system of claim 5, wherein the system is configured to detune the resonant frequency of the at least one of the repeater resonators (2902, 3014, 3016, 3018, 3020) by adjusting the variable capacitor to increase a power distribution in a region of the area.

7. The system of claim 5, further comprising a communication channel between the resonators (3006, 2902, 3014, 3016, 3018, 3020) of the system.

8. The system of claim 7, wherein the communication channel is used to coordinate detuning of the repeater resonators (2902, 3014, 3016, 3018, 3020) of the system by adjusting variable capacitors of the repeater resonators (2902, 3014, 3016, 3018, 3020) to adjust the power distribution.

9. The system of claim 7, wherein the communication channel is based on communication selected from the group consisting of WiFi, Bluetooth and near field communication.

10. The system of claim 8, wherein:

each control circuitry of the repeater resonators (2902, 3014, 3016, 3018, 3020) is configured to send status information to control circuitry of the source resonator (3006); and
the control circuitry of the source resonator (3006) is configured to calculate operating information for each of the repeater resonators (2902, 3014, 3016, 3018, 3020) and send the operating information used for adjusting the power distribution to the control circuitry of each of the repeater resonators (2902, 3014, 3016, 3018, 3020) through the communication channel.

11. The system of claim 8, wherein each control circuitry of the repeater resonators (2902, 3014, 3016, 3018, 3020) is configured to send its status information to control circuitry of other repeater resonators (2902, 3014, 3016, 3018, 3020) through the communication channel, and the status information is used to coordinate the detuning of the repeater resonators (2902, 3014, 3016, 3018, 3020) of the system.

12. The system of claim 1, wherein at least one of the repeater resonators (2902, 3014, 3016, 3018, 3020) has a quality factor Q > 100.

13. The system of claim 1, wherein at least one of the repeater resonators (2902, 3014, 3016, 3018, 3020) comprises a pressure sensor and wherein the at least one of the repeater resonators (2902, 3014, 3016, 3018, 3020) is configured to change an operating parameter of the at least one of the repeater resonators (2902, 3014, 3016, 3018, 3020) based on an output from the pressure sensor to change the power distribution.

14. The system of claim 1, wherein the defined area is a floor.

15. The system of claim 14, wherein the resonators (3006, 2902, 3014, 3016, 3018, 3020) are integrated into flooring material.

16. The system of claim 1 wherein the system is a wireless energy transfer flooring system.

**17.** The system of claim 16, further comprising a communication channel between the resonators (3006, 2902, 3014, 3016, 3018, 3020) of the system.

**18.** The system of claim 17, wherein the communication channel is used to coordinate detuning of the repeater resonators (2902, 3014, 3016, 3018, 3020) of the system by adjusting variable capacitors of the repeater resonators (2902, 3014, 3016, 3018, 3020) to adjust the power distribution.

**19.** The system of claim 16, wherein the resonators (3006, 2902, 3014, 3016, 3018, 3020) are integrated into flooring material.

**20.** The system of claim 16, wherein a relative phase of the oscillating fields generated by different source resonators of the system is adjustable.

**21.** The system of claim 16, wherein the system is configured to detune the resonant frequency of one or more of the repeater resonators (2902, 3014, 3016, 3018, 3020) by adjusting variable capacitors of the one or more of the repeater resonators (2902, 3014, 3016, 3018, 3020) to increase a power distribution in a region of the area.

**22.** The system of claim 16, wherein the detuning the resonant frequency of at least one of the repeater resonators (2902, 3014, 3016, 3018, 3020) is performed according to a routing algorithm.

**23.** The system of claim 16, wherein at least one of the repeater resonators (2902, 3014, 3016, 3018, 3020) comprises a pressure sensor and wherein the at least one of the repeater resonators (2902, 3014, 3016, 3018, 3020) is configured to change an operating parameter of the at least one of the repeater resonators (2902, 3014, 3016, 3018, 3020) based on an output from the pressure sensor to adjust the power distribution.

**24.** A method of distributing wireless energy from at least one source resonator (3006) to a specific location within an area having tunable repeater resonators (2902, 3014, 3016, 3018, 3020), the method comprising:

transferring power from a source resonator (3006) to a repeater resonator;
transferring power from the repeater resonator to one or more repeater resonators;
transferring power from the one or more repeater resonators to at least one device resonator (2904) through at least one other repeater resonator;
wherein transferring power to at least one device resonator (2904) includes:

determining the closest repeater resonator(s) (2902, 3014, 3016, 3018, 3020) to the specific location, tuning the resonant frequency of the repeater resonator(s) (2902, 3014, 3016, 3018, 3020) to provide for an energy transfer path from the source resonator (3006) to the closest repeater resonater(s) (2902, 3014, 3016, 3018, 3020), wherein the method further comprises:

detuning a resonant frequency of at least one of the repeater resonators (2902, 3014, 3016, 3018, 3020) to adjust a power distribution in an area,
wherein the source and repeater resonators (3006, 2902, 3014, 3016, 3018, 3020) are positioned in the area; and
wherein the detuning the at least one of the repeater resonators (2902, 3014, 3016, 3018, 3020) is performed according to a routing algorithm.

**25.** The method of claim 24, further comprising:

determining a region of the area; and
increasing a power distribution in the region by detuning the resonant frequency of at least one of the repeater resonators (2902, 3014, 3016, 3018, 3020) by adjusting a variable capacitor of the at least one of the repeater resonators (2902, 3014, 3016, 3018, 3020).

**26.** The method of claim 24, further comprising:

wirelessly receiving information from each of the repeater resonators (2902, 3014, 3016, 3018, 3020) through a communication channel;
calculating a power distribution based on the received information to generate output information; and

wirelessly communicating the output information to the repeater resonators (2902, 3014, 3016, 3018, 3020) through the communication channel,

wherein the detuning the resonant frequency of the at least one of the repeater resonators (2902, 3014, 3016, 3018, 3020) comprises adjusting a variable capacitor of the least one of the repeater resonators (2902, 3014, 3016, 3018, 3020) based on the output information.

27. The method of claim 24, further comprising changing an operating parameter of at least one of the repeater resonators (2902, 3014, 3016, 3018, 3020) based on an output from a pressure sensor of the at least one of the repeater resonators (2902, 3014, 3016, 3018, 3020) to adjust the power distribution.

**Patentansprüche**

1. System für drahtlose Energieverteilung über ein definiertes Gebiet, wobei das System Folgendes umfasst:

einen Quellresonator (3006), der an eine Energiequelle angekoppelt ist und ein oszillierendes Magnetfeld mit einer Treiberfrequenz erzeugt;
einen Repeaterresonator (2902, 3014, 3016, 3018, 3020), der in dem definierten Gebiet und nahe an dem Quellresonator positioniert ist, und wobei der Repeaterresonator (2902, 3014, 3016, 3018, 3020) eine Resonanzfrequenz aufweist; und
mindestens zwei andere Repeaterresonatoren (2902, 3014, 3016, 3018, 3020), die in dem definierten Gebiet positioniert sind, wobei jeder der mindestens zwei anderen Repeaterresonatoren (2902, 3014, 3016, 3018, 3020) nahe an mindestens einem anderen Repeaterresonator positioniert ist und jeder der mindestens zwei anderen Repeaterresonatoren (2902, 3014, 3016, 3018, 3020) eine Resonanzfrequenz aufweist;

wobei der Quellresonator (3006) ausgelegt ist zum drahtlosen Übertragen von Leistung mittels der Repeaterresonatoren (2902, 3014, 3016, 3018, 3020) in dem definierten Gebiet;
wobei das System ausgelegt ist zum Verstimmen der Resonanzfrequenz von mindestens einem der Repeaterresonatoren (2902, 3014, 3016, 3018, 3020) von der Treiberfrequenz des Quellresonators (3006), um eine Leistungsverteilung in dem Gebiet einzustellen; und
wobei das Verstimmen des mindestens einen der Repeaterresonatoren (2902, 3014, 3016, 3018, 3020) gemäß einem Routingalgorithmus durchgeführt wird.

2. System nach Anspruch 1, das ferner mindestens einen zusätzlichen Quellresonator umfasst, der ein oszillierendes Magnetfeld mit der Treiberfrequenz erzeugt.

3. System nach Anspruch 2, wobei eine relative Phase der oszillierenden Felder, die von verschiedenen Quellresonatoren des Systems erzeugt werden, einstellbar ist.

4. System nach Anspruch 1, wobei mindestens einer der Repeaterresonatoren (2902, 3014, 3016, 3018, 3020) eine kapazitiv geladene Leitungsschleife umfasst.

5. System nach Anspruch 1, wobei mindestens einer der Repeaterresonatoren (2902, 3014, 3016, 3018, 3020) Steuerschaltungen und einen variablen Kondensator umfasst und die Steuerschaltungen ausgelegt sind zum Einstellen des variablen Kondensators, um die Resonanzfrequenz des mindestens einen der Repeaterresonatoren (2902, 3014, 3016, 3018, 3020) zu ändern.

6. System nach Anspruch 5, wobei das System ausgelegt ist zum Verstimmen der Resonanzfrequenz des mindestens einen der Repeaterresonatoren (2902, 3014, 3016, 3018, 3020) durch Einstellen des variablen Kondensators, um eine Leistungsverteilung in einem Bereich des Gebiets zu erhöhen.

7. System nach Anspruch 5, das ferner einen Kommunikationskanal zwischen den Resonatoren (3006, 2902, 3014, 3016, 3018, 3020) des Systems umfasst.

8. System nach Anspruch 7, wobei der Kommunikationskanal verwendet wird, um das Verstimmen der Repeaterresonatoren (2902, 3014, 3016, 3018, 3020) des Systems durch Einstellen variabler Kondensatoren der Repeaterresonatoren (2902, 3014, 3016, 3018, 3020), um die Leistungsverteilung einzustellen, zu koordinieren.

9. System nach Anspruch 7, wobei der Kommunikationskanal auf Kommunikation basiert, die aus der aus den Folgenden bestehenden Gruppe ausgewählt wird: WiFi, Bluetooth und Nahfeldkommunikation.

10. System nach Anspruch 8, wobei:

jede Steuerschaltung der Repeaterresonatoren (2902, 3014, 3016, 3018, 3020) ausgelegt ist zum Senden von Statusinformationen an Steuerschaltungen des Quellresonators (3006); und
die Steuerschaltungen des Quellresonators (3006) ausgelegt sind zum Berechnen von Betriebsinformationen für jeden der Repeaterresonatoren (2902, 3014, 3016, 3018, 3020) und zum Senden der Betriebsinformationen, die zum Einstellen der Leistungsverteilung verwendet werden, an die Steuerschaltungen von jedem der Repeaterresonatoren (2902, 3014, 3016, 3018, 3020) über den Kommunikationskanal.

11. System nach Anspruch 8, wobei jede Steuerschaltung der Repeaterresonatoren (2902, 3014, 3016, 3018, 3020) ausgelegt ist zum Senden ihrer Statusinformationen über den Kommunikationskanal an andere Repeaterresonatoren (2902, 3014, 3016, 3018, 3020) und die Statusinformationen verwendet werden, um das Verstimmen der Repeaterresonatoren (2902, 3014, 3016, 3018, 3020) des Systems zu koordinieren.

12. System nach Anspruch 1, wobei mindestens einer der Repeaterresonatoren (2902, 3014, 3016, 3018, 3020) einen Gütefaktor von $Q > 100$ aufweist.

13. System nach Anspruch 1, wobei mindestens einer der Repeaterresonatoren (2902, 3014, 3016, 3018, 3020) einen Drucksensor umfasst und wobei der mindestens eine der Repeaterresonatoren (2902, 3014, 3016, 3018, 3020) ausgelegt ist zum Ändern eines Betriebsparameters des mindestens einen der Repeaterresonatoren (2902, 3014, 3016, 3018, 3020), basierend auf einer Ausgabe des Drucksensors, um die Leistungsverteilung zu ändern.

14. System nach Anspruch 1, wobei das definierte Gebiet ein Fußboden ist.

15. System nach Anspruch 14, wobei die Resonatoren (3006, 2902, 3014, 3016, 3018, 3020) in einem Fußbodenmaterial integriert sind.

16. System nach Anspruch 1, wobei das System ein drahtloses Energieübertragungs-Fußbodensystem ist.

17. System nach Anspruch 16, das ferner einen Kommunikationskanal zwischen den Resonatoren (3006, 2902, 3014, 3016, 3018, 3020) des Systems umfasst.

18. System nach Anspruch 17, wobei der Kommunikationskanal verwendet wird zum Koordinieren des Verstimmens der Repeaterresonatoren (2902, 3014, 3016, 3018, 3020) des Systems durch Einstellen variabler Kondensatoren der Repeaterresonatoren (2902, 3014, 3016, 3018, 3020), um die Leistungsverteilung einzustellen.

19. System nach Anspruch 16, wobei die Resonatoren (3006, 2902, 3014, 3016, 3018, 3020) in das Fußbodenmaterial integriert sind.

20. System nach Anspruch 16, wobei eine relative Phase der oszillierenden Felder, die von verschiedenen Quellresonatoren des Systems erzeugt werden, einstellbar ist.

21. System nach Anspruch 16, wobei das System ausgelegt ist zum Verstimmen der Resonanzfrequenz von einem oder mehreren der Repeaterresonatoren (2902, 3014, 3016, 3018, 3020) durch Einstellen variabler Kondensatoren des einen oder der mehreren Repeaterresonatoren (2902,3014,3016,3018,3020), um eine Leistungsverteilung in einem Bereich des Gebiets zu erhöhen.

22. System nach Anspruch 16, wobei das Verstimmen der Resonanzfrequenz von mindestens einem der Repeaterresonatoren (2902, 3014, 3016, 3018, 3020) gemäß einem Routingalgorithmus durchgeführt wird.

23. System nach Anspruch 16, wobei mindestens einer der Repeaterresonatoren (2902, 3014, 3016, 3018, 3020) einen Drucksensor umfasst und wobei der mindestens eine der Repeaterresonatoren (2902, 3014, 3016, 3018, 3020) ausgelegt ist zum Ändern eines Betriebsparameters des mindestens einen der Repeaterresonatoren (2902, 3014, 3016, 3018, 3020), basierend auf einer Ausgabe des Drucksensors, um die Leistungsverteilung einzustellen.

**24.** Verfahren zum Verteilen drahtloser Energie von mindestens einem Quellresonator (3006) zu einem bestimmten Ort innerhalb eines Gebiets, das abstimmbare Repeaterresonatoren (2902, 3014, 3016, 3018, 3020) aufweist und wobei das Verfahren folgende Schritte umfasst:

Übertragen von Leistung von einem Quellresonator (3006) an einen Repeaterresonator;
Übertragen von Leistung von dem Repeaterresonator an einen oder mehrere Repeaterresonatoren;
Übertragen von Leistung von dem einen oder den mehreren Repeaterresonatoren an mindestens einen Geräteresonator (2904) über mindestens einen anderen Repeaterresonator;
wobei das Übertragen von Leistung an mindestens einen Geräteresonator (2904) Folgendes beinhaltet:

Bestimmen des(der) dem bestimmten Ort nächstgelegenen Repeaterresonators(en) (2902,3014,3016,3018,3020), Abstimmen der Resonanzfrequenz des(der) Repeaterresonators(en) (2902,3014,3016,3018,3020), um einen Energieübertragungsweg von dem Quellresonator (3006) an den(die) nächstgelegenen Repeaterresonator(en) (2902, 3014, 3016, 3018, 3020) zu schaffen, wobei das Verfahren ferner Folgendes umfasst:

Verstimmen einer Resonanzfrequenz von mindestens einem der Repeaterresonatoren (2902,3014,3016,3018,3020), um eine Leistungsverteilung in einem Gebiet einzustellen;
wobei die Quell- und Repeaterresonatoren (3006, 2902, 3014, 3016, 3018, 3020) in dem Gebiet positioniert sind; und
wobei das Verstimmen des mindestens einen der Repeaterresonatoren (2902, 3014, 3016, 3018, 3020) gemäß einem Routingalgorithmus durchgeführt wird.

**25.** Verfahren nach Anspruch 24, das ferner umfasst:

Bestimmen eines Bereichs des Gebiets; und
Erhöhen einer Leistungsverteilung in dem Bereich durch Verstimmen der Resonanzfrequenz von mindestens einem der Repeaterresonatoren (2902, 3014, 3016, 3018, 3020) durch Einstellen eines variablen Kondensators des mindestens einen der Repeaterresonatoren (2902, 3014, 3016, 3018, 3020).

**26.** Verfahren nach Anspruch 24, das ferner umfasst:

drahtloses Empfangen von Informationen von jedem der Repeaterresonatoren (2902, 3014, 3016, 3018, 3020) über einen Kommunikationskanal;
Berechnen einer Leistungsverteilung, basierend auf den empfangenen Informationen, um Ausgabeinformationen zu erzeugen; und
drahtloses Kommunizieren der Ausgabeinformationen an die Repeaterresonatoren (2902, 3014, 3016, 3018, 3020) über den Kommunikationskanal,

wobei das Verstimmen der Resonanzfrequenz des mindestens einen der Repeaterresonatoren (2902, 3014, 3016, 3018, 3020) das Einstellen eines variablen Kondensators des mindestens einen der Repeaterresonatoren (2902, 3014, 3016, 3018, 3020), basierend auf den Ausgabeinformationen, umfasst.

**27.** Verfahren nach Anspruch 24, das ferner das Ändern eines Betriebsparameters von mindestens einem der Repeaterresonatoren (2902, 3014, 3016, 3018, 3020), basierend auf einer Ausgabe von einem Drucksensor des mindestens einen der Repeaterresonatoren (2902, 3014, 3016, 3018, 3020), um die Leistungsverteilung einzustellen, umfasst.

**Revendications**

**1.** Système pour une distribution d'énergie sans fil sur une zone définie, le système comprenant :

un résonateur source (3006) couplé à une source d'énergie et générant un champ magnétique oscillant avec une fréquence pilote ;
un résonateur répéteur (2902, 3014, 3016, 3018, 3020) positionné dans la zone définie et à proximité du résonateur source et le résonateur répéteur (2902, 3014, 3016, 3018, 3020) ayant une fréquence de résonance ; et

au moins deux autres résonateurs répéteurs (2902, 3014, 3016, 3018, 3020) positionnés dans la zone définie, chacun des au moins deux autres résonateurs répéteurs (2902, 3014, 3016, 3018, 3020) étant positionné à proximité d'au moins un autre résonateur répéteur et chacun des au moins deux autres résonateurs répéteurs (2902, 3014, 3016, 3018, 3020) ayant une fréquence de résonance ;

dans lequel le résonateur source (3006) est configuré pour transférer sans fil de l'énergie au moyen des résonateurs répéteurs (2902, 3014, 3016, 3018, 3020) dans la zone définie ;

dans lequel le système est configuré pour dérégler la fréquence de résonance d'au moins l'un des résonateurs répéteurs (2902, 3014, 3016, 3018, 3020) par rapport à la fréquence pilote du résonateur source (3006) de sorte à régler une distribution d'énergie dans la zone ; et

dans lequel le déréglage de l'au moins un des résonateurs répéteurs (2902, 3014, 3016, 3018, 3020) est effectué en fonction d'un algorithme de routage.

2. Système selon la revendication 1, comprenant en outre au moins un résonateur source supplémentaire qui génère un champ magnétique oscillant avec la fréquence pilote.

3. Système selon la revendication 2, dans lequel une phase relative des champs oscillants générés par différents résonateurs sources du système est ajustable.

4. Système selon la revendication 1, dans lequel au moins l'un des résonateurs répéteurs (2902, 3014, 3016, 3018, 3020) comprend une boucle conductrice à charge capacitive.

5. Système selon la revendication 1, dans lequel au moins l'un des résonateurs répéteurs (2902, 3014, 3016, 3018, 3020) comprend un ensemble de circuits de commande et un condensateur variable et l'ensemble de circuits de commande est configuré pour régler le condensateur variable de sorte à changer la fréquence de résonance de l'au moins un des résonateurs répéteurs (2902, 3014, 3016, 3018, 3020).

6. Système selon la revendication 5, dans lequel le système est configuré pour dérégler la fréquence de résonance de l'au moins un des résonateurs répéteurs (2902, 3014, 3016, 3018, 3020) en réglant le condensateur variable de sorte à augmenter une distribution d'énergie dans une région de la zone.

7. Système selon la revendication 5, comprenant en outre un canal de communication entre les résonateurs (3006, 2902, 3014, 3016, 3018, 3020) du système.

8. Système selon la revendication 7, dans lequel le canal de communication est utilisé pour coordonner le déréglage des résonateurs répéteurs (2902, 3014, 3016, 3018, 3020) du système par réglage des condensateurs variables des résonateurs répéteurs (2902, 3014, 3016, 3018, 3020) de sorte à régler la distribution d'énergie.

9. Système selon la revendication 7, dans lequel le canal de communication est basé sur une communication sélectionnée dans le groupe constitué par le WiFi, le Bluetooth et une communication en champ proche.

10. Système selon la revendication 8, dans lequel :

chaque ensemble de circuits de commande des résonateurs répéteurs (2902, 3014, 3016, 3018, 3020) est configuré pour envoyer des informations d'état à un ensemble de circuits de commande du résonateur source (3006) ; et

l'ensemble de circuits de commande du résonateur source (3006) est configuré pour calculer des informations de fonctionnement pour chacun des résonateurs répéteurs (2902, 3014, 3016, 3018, 3020) et envoyer les informations de fonctionnement utilisées pour régler la distribution d'énergie à l'ensemble de circuits de commande de chacun des résonateurs répéteurs (2902, 3014, 3016, 3018, 3020) au moyen du canal de communication.

11. Système selon la revendication 8, dans lequel chaque ensemble de circuits de commande des résonateurs répéteurs (2902, 3014, 3016, 3018, 3020) est configuré pour envoyer ses informations d'état à un ensemble de circuits de commande d'autres résonateurs répéteurs (2902, 3014, 3016, 3018, 3020) au moyen du canal de communication et les informations d'état sont utilisées pour coordonner le déréglage des résonateurs répéteurs (2902, 3014, 3016, 3018, 3020) du système.

**12.** Système selon la revendication 1, dans lequel au moins l'un des résonateurs répéteurs (2902, 3014, 3016, 3018, 3020) présente un facteur de qualité Q > 100.

**13.** Système selon la revendication 1, dans lequel au moins l'un des résonateurs répéteurs (2902, 3014, 3016, 3018, 3020) comprend un capteur de pression et dans lequel le ou les résonateurs répéteurs (2902, 3014, 3016, 3018, 3020) sont configurés pour changer un paramètre de fonctionnement de l'au moins un des résonateurs répéteurs (2902, 3014, 3016, 3018, 3020) sur la base d'une sortie du capteur de pression de sorte à changer la distribution d'énergie.

**14.** Système selon la revendication 1, dans lequel la zone définie est un plancher.

**15.** Système selon la revendication 14, dans lequel les résonateurs (3006, 2902, 3014, 3016, 3018, 3020) sont intégrés dans un matériau de revêtement de sol.

**16.** Système selon la revendication 1, dans lequel le système est un système de revêtement de sol à transfert d'énergie sans fil.

**17.** Système selon la revendication 16, comprenant en outre un canal de communication entre les résonateurs (3006, 2902, 3014, 3016, 3018, 3020) du système.

**18.** Système selon la revendication 17, dans lequel le canal de communication est utilisé pour coordonner le déréglage des résonateurs répéteurs (2902, 3014, 3016, 3018, 3020) du système par réglage de condensateurs variables des résonateurs répéteurs (2902, 3014, 3016, 3018, 3020) de sorte à régler la distribution d'énergie.

**19.** Système selon la revendication 16, dans lequel les résonateurs (3006, 2902, 3014, 3016, 3018, 3020) sont intégrés dans un matériau de revêtement de sol.

**20.** Système selon la revendication 16, dans lequel une phase relative des champs oscillants générés par différents résonateurs sources du système est ajustable.

**21.** Système selon la revendication 16, dans lequel le système est configuré pour dérégler la fréquence de résonance du ou des résonateurs répéteurs (2902, 3014, 3016, 3018, 3020) en réglant des condensateurs variables du ou des résonateurs répéteurs (2902, 3014, 3016, 3018, 3020) de sorte à augmenter une distribution d'énergie dans une région de la zone.

**22.** Système selon la revendication 16, dans lequel le déréglage de la fréquence de résonance de l'au moins un des résonateurs répéteurs (2902, 3014, 3016, 3018, 3020) est effectué en fonction d'un algorithme de routage.

**23.** Système selon la revendication 16, dans lequel au moins l'un des résonateurs répéteurs (2902, 3014, 3016, 3018, 3020) comprend un capteur de pression et dans lequel le ou les résonateurs répéteurs (2902, 3014, 3016, 3018, 3020) sont configurés pour changer un paramètre de fonctionnement de l'au moins un des résonateurs répéteurs (2902, 3014, 3016, 3018, 3020) sur la base d'une sortie du capteur de pression de sorte à régler la distribution d'énergie.

**24.** Procédé de distribution d'énergie sans fil depuis au moins un résonateur source (3006) jusqu'à un emplacement spécifique dans une zone ayant des résonateurs répéteurs accordables (2902, 3014, 3016, 3018, 3020), le procédé consistant à :

transférer de l'énergie depuis un résonateur source (3006) à un résonateur répéteur ;
transférer de l'énergie depuis le résonateur répéteur à un ou plusieurs résonateurs répéteurs ;
transférer de l'énergie depuis l'un ou plusieurs résonateurs répéteurs à au moins un résonateur de dispositif (2904) au moyen d'au moins un autre résonateur répéteur ;
dans lequel le transfert d'énergie à au moins un résonateur de dispositif (2904) consiste à :

déterminer le ou les résonateurs répéteurs (2902, 3014, 3016, 3018, 3020) les plus proches de l'emplacement spécifique, régler la fréquence de résonance du ou des résonateurs répéteurs (2902, 3014, 3016, 3018, 3020) de sorte à fournir un trajet de transfert d'énergie depuis le résonateur source (3006) jusqu'au ou jusqu'aux résonateurs répéteurs (2902, 3014, 3016, 3018, 3020) les plus proches, dans lequel le procédé consiste en outre à :

dérégler une fréquence de résonance d'au moins l'un des résonateurs répéteurs (2902, 3014, 3016, 3018, 3020) de sorte à régler une distribution d'énergie dans la zone ;
dans lequel les résonateurs source et répéteur (3006, 2902, 3014, 3016, 3018, 3020) sont positionnés dans la zone ; et
dans lequel le déréglage de l'au moins un des résonateurs répéteurs (2902, 3014, 3016, 3018, 3020) est effectué en fonction d'un algorithme de routage.

**25.** Procédé selon la revendication 24, consistant en outre à :

déterminer une région de la zone ; et
augmenter une distribution d'énergie dans la région par déréglage de la fréquence de résonance d'au moins l'un des résonateurs répéteurs (2902, 3014, 3016, 3018, 3020) en réglant un condensateur variable de l'au moins un des résonateurs répéteurs (2902, 3014,3016,3018,3020).

**26.** Procédé selon la revendication 24, consistant en outre à :

recevoir sans fil des informations provenant de chacun des résonateurs répéteurs (2902, 3014, 3016, 3018, 3020) au moyen d'un canal de communication ;
calculer une distribution d'énergie en se basant sur les informations reçues afin de générer des informations de sortie ; et
communiquer sans fil les informations de sortie aux résonateurs répéteurs (2902, 3014, 3016, 3018, 3020) au moyen du canal de communication,

dans lequel le déréglage de la fréquence de résonance de l'au moins un des résonateurs répéteurs (2902, 3014, 3016, 3018, 3020) consiste à régler un condensateur variable de l'au moins un des résonateurs répéteurs (2902, 3014, 3016, 3018, 3020) en se basant sur les informations de sortie.

**27.** Procédé selon la revendication 24, consistant en outre à changer un paramètre de fonctionnement d'au moins l'un des résonateurs répéteurs (2902, 3014, 3016, 3018, 3020) en se basant sur une sortie d'un capteur de pression de l'au moins un des résonateurs répéteurs (2902, 3014, 3016, 3018, 3020) de sorte à régler la distribution d'énergie.

Fig. 1

Fig. 2A

Fig. 2B

Fig. 2C

Fig. 2D

Fig. 2E

Fig. 2F

C    L    R

EP 2 617 120 B1

# Fig. 3

EP 2 617 120 B1

Fig. 4

Fig. 5A

Fig. 5B

**Fig. 6A**

```
┌─────────────┐        ┌─────────────┐
│    Power    │────────│    Power    │
│  Generator  │        │    Load     │──── 604
└─────────────┘        └─────────────┘
     602
```

**Fig. 6B**

```
┌─────────────┐    ┌─────────────┐    ┌─────────────┐
│    Power    │────│   Tunable   │────│    Power    │
│  Generator  │    │  Impedance  │    │    Load     │──── 604
└─────────────┘    │  Matching   │    └─────────────┘
     602           │   Network   │
                   └─────────────┘
                         606
```

**Fig. 6C**

```
┌─────────────┐    ┌─────────────┐    ┌─────────────┐
│   Tunable   │────│   Tunable   │────│    Power    │
│    Power    │    │  Impedance  │    │    Load     │──── 604
│  Generator  │    │  Matching   │    └─────────────┘
└─────────────┘    │   Network   │
     608           └─────────────┘
                         606
```

EP 2 617 120 B1

# Fig. 7

Fig. 8

## Fig. 9

$f=250kHz$, $dc=40\%$, $C_a=640pF$, $C_1=10nF$

EP 2 617 120 B1

Fig. 10

# Fig. 11A

f=250kHz, dc=40%, $C_1$=10nF, $C_2$=7.5nF

# Fig. 11B

f=250kHz, dc=40%, $C_1$=10nF, $C_2$=7.5nF

Fig. 11C

f=250kHz, $C_1$=10nF, $C_2$=7.5nF, $\omega$L'=1000$\Omega$

dc

0.5
0.4
0.3
0.2
0.1

$C_a$ [F]

$\times 10^{-9}$
8
6
4
2
0

$P_{out}/V_{DC}^2$ [W/V²]

$\times 10^{-3}$
1.5
1
0.5
0

R [$\Omega$], L=100$\mu$H

0.2  0.4  0.6  0.8  1  1.2  1.4  1.6  1.8  2

# Fig. 12

$C_a$=640pF, $C_1$=10nF, $C_2$=7.5nF, L'=637µH

R [Ω], L=100µH

L [H], R=0.2Ω

EP 2 617 120 B1

Fig. 13

EP 2 617 120 B1

Fig. 14

f=250kHz, $C_{as}$ =640pF, $R_s$ =0.19Ω, $L_s$ =100µH, $C_{1s}$ =10nF, $\omega L'_s$ =1000Ω, $Z_{load}$ =50Ω, $R_d$ =0.3Ω, $L_d$ =40µH, $C_{1d}$ =87.5nF, $C_{2d}$ =13nF, $\omega L'_d$ =400Ω

Fig. 15

Fig. 16

Fig. 17A

Fig. 17B

Fig. 17C

Fig. 18

1810

1812

1814

1804

1808

1820

1818

1802

1806

1816

## Fig. 19A

1902 — Establish out of band communication channel

↓

1904 — Exchange information to adjust parameters of energy transfer

↓

1906 — Monitor changes to energy transfer and compare to expected changes

## Fig. 19B

1908 — Establish out of band communication channel

↓

1910 — Exchange verification code on out of band channel

↓

1912 — Signal verification code with near field used for energy transfer

EP 2 617 120 B1

Fig. 20

# Fig. 21

# Fig. 22

EP 2 617 120 B1

## Fig. 23

EP 2 617 120 B1

# Fig. 24

EP 2 617 120 B1

Fig. 25

Fig. 26

Fig. 27

Fig. 28B

Fig. 28A

# Fig. 29

EP 2 617 120 B1

Fig. 30

# Fig. 31

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20100164296 A
- US 78961110 A
- US 20100237709 A
- US 72205010 A
- US 20100181843 A
- US 61411490 B

**Non-patent literature cited in the description**

- **A. KURS ; M. KESLER ; S.G. JOHNSON.** Optimized design of a low-resistance electrical conductor for the multimegahertz range. *Appl. Phys. Lett.,* 2011, vol. 98, 172504
- **H. NOJI.** *Supercond. Sci. Technol.,* 1997, vol. 10, 552
- **S. MUKOYAMA ; K. MIYOSHI ; H. TSUBOUTI ; T. YOSHIDA ; M. MIMURA ; N. UNO ; M. IKEDA ; H. ISHII ; S. HONJO ; Y. IWATA.** *IEEE Trans. Appl. Supercond.,* 1999, vol. 9, 1269